# EUROPEAN PATENT APPLICATION

(11) **EP 4 750 285 A1**
(43) Date of publication of application: **27.05.2026**
(21) Application number: 25216621.0
(22) Date of filing: 18.11.2025
(51) Int. Cl.: H10K 50/11, H10K 85/30

(54) **ORGANOMETALLIC COMPOUND, LIGHT-EMITTING DEVICE INCLUDING THE ORGANOMETALLIC COMPOUND, AND ELECTRONIC APPARATUS INCLUDING THE LIGHT-EMITTING DEVICE**

(30) Priority: 21.11.2024 KR 20240167756
(71) Applicant: Samsung Display Co., Ltd., Yongin-si, Gyeonggi-do 17113 (KR)
(72) Inventor: CHUNG, Yeon Sook, 16678 Suwon-si (KR); KIM, Hwang Suk, 16678 Suwon-si (KR); MIN, Minsik, 16678 Suwon-si (KR); BAE, Hyejin, 16678 Suwon-si (KR); CHOI, Hyesung, 16678 Suwon-si (KR); HEO, Joon, 16678 Suwon-si (KR); KANG, Hosuk, 16678 Suwon-si (KR); KIM, Jong Soo, 16678 Suwon-si (KR); SON, Youngmok, 16678 Suwon-si (KR); WON, Joonghee, 16678 Suwon-si (KR); LEE, Yeonkyung, 16678 Suwon-si (KR); JU, Kyeongsik, 16678 Suwon-si (KR)
(74) Representative: Elkington and Fife LLP

(57) **Abstract**

Provided are an organometallic compound represented by Formula 1, a light-emitting device including the organometallic compound, and an electronic apparatus including the light-emitting device: 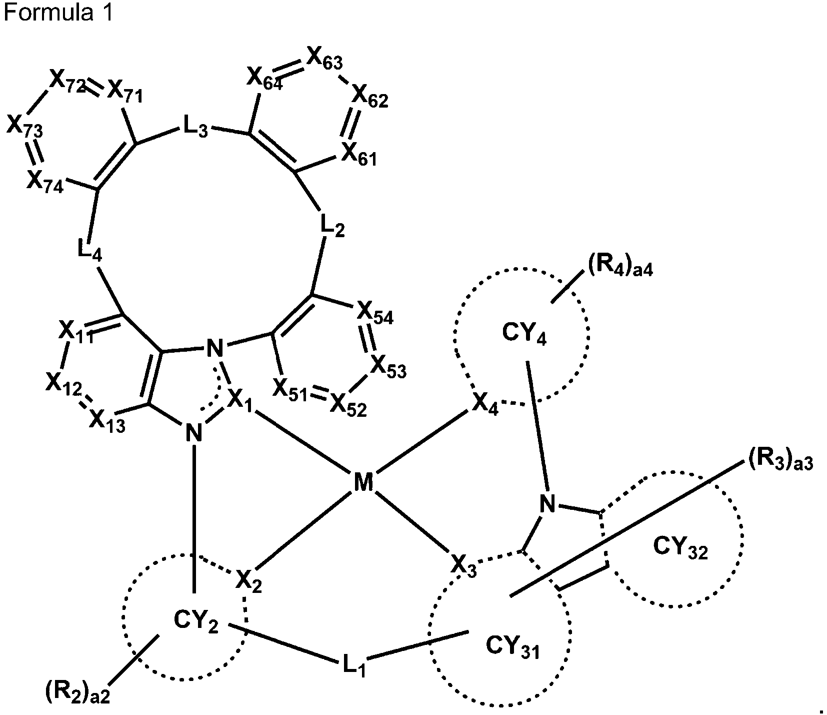 wherein a detailed description of Formula 1 is as provided herein.

## Description

### FIELD OF THE INVENTION

The subject matter relates to an organometallic compound, a light-emitting device including the organometallic compound, and an electronic apparatus including the light-emitting device.

### BACKGROUND OF THE INVENTION

From among light-emitting devices, organic light-emitting devices (OLEDs) are self-emissive devices, which have improved characteristics in terms of viewing angles, response time, luminance, driving voltage, and response speed. In addition, OLEDs can produce full-color images.

In an example, an organic light-emitting device includes an anode, a cathode, and an interlayer arranged between the anode and the cathode, and including an emission layer. A hole transport region may be arranged between the anode and the emission layer, and an electron transport region may be arranged between the emission layer and the cathode. Holes provided from the anode move towards the emission layer through the hole transport region, and electrons provided from the cathode move towards the emission layer through the electron transport region. The holes and the electrons recombine in the emission layer to produce excitons. The excitons transition from an excited state to a ground state, thereby generating light.

### SUMMARY OF THE INVENTION

Provided are an organometallic compound, a light-emitting device including the organometallic compound, and an electronic apparatus including the light-emitting device.

Additional aspects will be set forth in part in the detailed description that follows and, in part, will be apparent from the detailed description, or may be learned by practice of the presented exemplary embodiments described herein.

According to an aspect, provided is an organometallic compound represented by Formula 1: 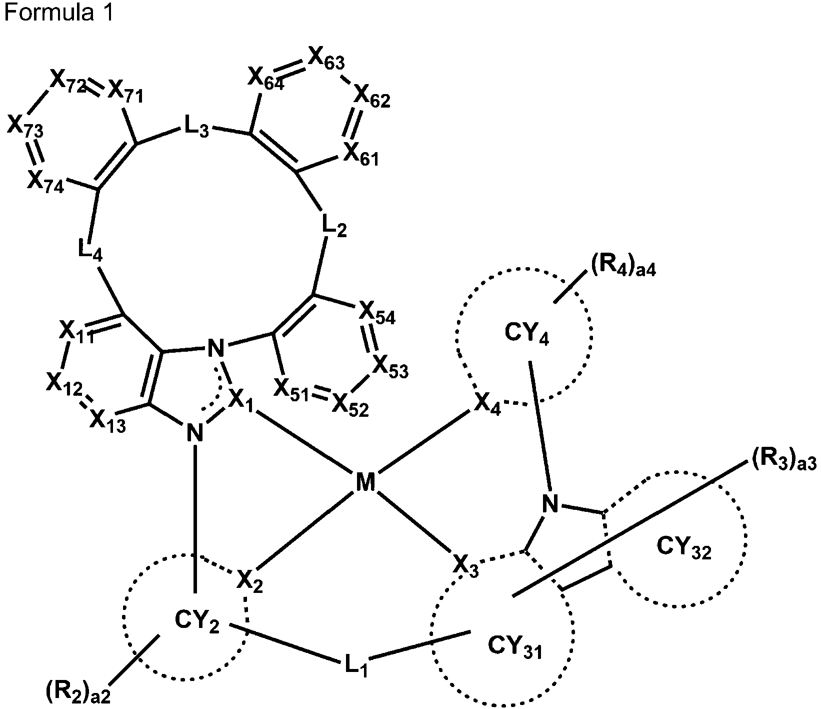 wherein, in Formula 1,
M is Pt or Pd,
X₁ is C,
X₂ to X₄ are each independently C or N,
ring CY₂, ring CY₃₁, ring CY₃₂, and ring CY₄ are each independently a C₅-C₃₀ carbocyclic group or a C₁-C₃₀ heterocyclic group,
X₁₁ is N or C(R₁₁), X₁₂ is N or C(R₁₂), and X₁₃ is N or C(R₁₃),
X₅₁ is N or C(R₅₁), X₅₂ is N or C(R₅₂), X₅₃ is N or C(R₅₃), and X₅₄ is N or C(R₅₄),
X₆₁ is N or C(R₆₁), X₆₂ is N or C(R₆₂), X₆₃ is N or C(R₆₃), and X₆₄ is N or C(R₆₄),
X₇₁ is N or C(R₇₁), X₇₂ is N or C(R₇₂), X₇₃ is N or C(R₇₃), and X₇₄ is N or C(R₇₄),
L₁ is O, S, Se, N(R₁₀₁), C(R₁₀₁)(R₁₀₂), or Si(R₁₀₁)(R₁₀₂),
L₂, L₃, and L₄ are each independently a single bond, O, S, Se, N(R'), C(R')(R"), or Si(R')(R"),
at least one of L₂, L₃, and L₄ is O, S, Se, N(R'), C(R')(R"), or Si(R')(R"),
   i) when L₂ is N(R'), R' is not linked to either of X₅₄ and X₆₁, ii) when L₃ is N(R'), R' is not linked to either of X₆₄ and X₇₁, and iii) when L₄ is N(R'), R' is not linked to either of X₇₄ and X₁₁,
R₂, R₃, R₄, R₁₁ to R₁₃, R₅₁ to R₅₄, R₆₁ to R₆₄, R₇₁ to R₇₄, R₁₀₁, R₁₀₂, R', and R" are each independently hydrogen, deuterium, -F, -Cl, -Br, -I, -SF₅, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, a substituted or unsubstituted C₁-C₆₀ alkyl group, a substituted or unsubstituted C₂-C₆₀ alkenyl group, a substituted or unsubstituted C₂-C₆₀ alkynyl group, a substituted or unsubstituted C₁-C₆₀ alkoxy group, a substituted or unsubstituted C₁-C₆₀ alkylthio group, a substituted or unsubstituted C₃-C₁₀ cycloalkyl group, a substituted or unsubstituted C₁-C₁₀ heterocycloalkyl group, a substituted or unsubstituted C₃-C₁₀ cycloalkenyl group, a substituted or unsubstituted C₁-C₁₀ heterocycloalkenyl group, a substituted or unsubstituted C₆-C₆₀ aryl group, a substituted or unsubstituted C₇-C₆₀ alkyl aryl group, a substituted or unsubstituted C₇-C₆₀ aryl alkyl group, a substituted or unsubstituted C₆-C₆₀ aryloxy group, a substituted or unsubstituted C₆-C₆₀ arylthio group, a substituted or unsubstituted C₁-C₆₀ heteroaryl group, a substituted or unsubstituted C₂-C₆₀ alkyl heteroaryl group, a substituted or unsubstituted C₂-C₆₀ heteroaryl alkyl group, a substituted or unsubstituted C₁-C₆₀ heteroaryloxy group, a substituted or unsubstituted C₁-C₆₀ heteroarylthio group, a substituted or unsubstituted monovalent non-aromatic condensed polycyclic group, a substituted or unsubstituted monovalent non-aromatic condensed heteropolycyclic group, -Si(Q₁)(Q₂)(Q₃), -Ge(Q₁)(Q₂)(Q₃), -N(Q₄)(Q₅), - B(Q₆)(Q₇), -P(Q₈)(Q₉), or -P(=O)(Q₈)(Q₉),
a2 to a4 are each independently an integer from 0 to 20,
two or more of R₁₁ to R₁₃ are optionally linked to each other to form a C₅-C₃₀ carbocyclic group unsubstituted or substituted with at least one R₁₀ₐ or a C₁-C₃₀ heterocyclic group unsubstituted or substituted with at least one R₁₀ₐ,
two or more of a plurality of R₂ are optionally linked to each other to form a C₅-C₃₀ carbocyclic group unsubstituted or substituted with at least one R₁₀ₐ or a C₁-C₃₀ heterocyclic group unsubstituted or substituted with at least one R₁₀ₐ,
two or more of a plurality of R₃ are optionally linked to each other to form a C₅-C₃₀ carbocyclic group unsubstituted or substituted with at least one R₁₀ₐ or a C₁-C₃₀ heterocyclic group unsubstituted or substituted with at least one R₁₀ₐ,
two or more of a plurality of R₄ are optionally linked to each other to form a C₅-C₃₀ carbocyclic group unsubstituted or substituted with at least one R₁₀ₐ or a C₁-C₃₀ heterocyclic group unsubstituted or substituted with at least one R₁₀ₐ,
two or more of R₅₁ to R₅₄ are optionally linked to each other to form a C₅-C₃₀ carbocyclic group unsubstituted or substituted with at least one R₁₀ₐ or a C₁-C₃₀ heterocyclic group unsubstituted or substituted with at least one R₁₀ₐ,
two or more of R₆₁ to R₆₄ are optionally linked to each other to form a C₅-C₃₀ carbocyclic group unsubstituted or substituted with at least one R₁₀ₐ or a C₁-C₃₀ heterocyclic group unsubstituted or substituted with at least one R₁₀ₐ,
two or more of R₇₁ to R₇₄ are optionally linked to each other to form a C₅-C₃₀ carbocyclic group unsubstituted or substituted with at least one R₁₀ₐ or a C₁-C₃₀ heterocyclic group unsubstituted or substituted with at least one R₁₀ₐ,
R₁₀₁ and R₁₀₂ are optionally linked to each other to form a C₅-C₃₀ carbocyclic group unsubstituted or substituted with at least one R₁₀₂ or a C₁-C₃₀ heterocyclic group unsubstituted or substituted with at least one R₁₀ₐ,
R' and R" are optionally linked to each other to form a C₅-C₃₀ carbocyclic group unsubstituted or substituted with at least one R₁₀ₐ or a C₁-C₃₀ heterocyclic group unsubstituted or substituted with at least one R₁₀ₐ,
R₁₀ₐ is as described in connection with R₁₁,
at least one substituent of the substituted C₁-C₆₀ alkyl group, the substituted C₂-C₆₀ alkenyl group, the substituted C₂-C₆₀ alkynyl group, the substituted C₁-C₆₀ alkoxy group, the substituted C₁-C₆₀ alkylthio group, the substituted C₃-C₁₀ cycloalkyl group, the substituted C₁-C₁₀ heterocycloalkyl group, the substituted C₃-C₁₀ cycloalkenyl group, the substituted C₁-C₁₀ heterocycloalkenyl group, the substituted C₆-C₆₀ aryl group, the substituted C₇-C₆₆ alkyl aryl group, the substituted C₇-C₆₀ aryl alkyl group, the substituted C₆-C₆₀ aryloxy group, the substituted C₆-C₆₀ arylthio group, the substituted C₁-C₆₀ heteroaryl group, the substituted C₂-C₆₀ alkyl heteroaryl group, the substituted C₂-C₆₀ heteroaryl alkyl group, the substituted C₁-C₆₀ heteroaryloxy group, the substituted C₁-C₆₀ heteroarylthio group, the substituted monovalent non-aromatic condensed polycyclic group, and the substituted monovalent non-aromatic condensed heteropolycyclic group is:
   deuterium, -F, -Cl, -Br, -I, -SF₅, -CD₃, -CD₂H, -CDH₂, -CF₃, -CF₂H, - CFH₂, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, a C₁-C₆₀ alkyl group, a C₂-C₆₀ alkenyl group, a C₂-C₆₀ alkynyl group, a C₁-C₆₀ alkoxy group, or a C₁-C₆₀ alkylthio group;
   a C₁-C₆₀ alkyl group, a C₂-C₆₀ alkenyl group, a C₂-C₆₀ alkynyl group, a C₁-C₆₀ alkoxy group, or a C₁-C₆₀ alkylthio group, each substituted with deuterium, -F, -Cl, -Br, -I, -SF₅, -CD₃, -CD₂H, -CDH₂, -CF₃, -CF₂H, -CFH₂, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, a C₃-C₁₀ cycloalkyl group, a C₁-C₁₀ heterocycloalkyl group, a C₃-C₁₀ cycloalkenyl group, a C₁-C₁₀ heterocycloalkenyl group, a C₆-C₆₀ aryl group, a C₇-C₆₀ alkyl aryl group, a C₆-C₆₀ aryloxy group, a C₆-C₆₀ arylthio group, a C₁-C₆₀ heteroaryl group, a C₂-C₆₀ alkyl heteroaryl group, a C₁-C₆₀ heteroaryloxy group, a C₁-C₆₀ heteroarylthio group, a monovalent non-aromatic condensed polycyclic group, a monovalent non-aromatic condensed heteropolycyclic group, -Si(Q₁₁)(Q₁₂)(Q₁₃), -Ge(Q₁₁)(Q₁₂)(Q₁₃), -N(Q₁₄)(Q₁₅), -B(Q₁₆)(Q₁₇), - P(Q₁₈)(Q₁₉), -P(=O)(Q₁₈)(Q₁₉), or a combination thereof;
   a C₃-C₁₀ cycloalkyl group, a C₁-C₁₀ heterocycloalkyl group, a C₃-C₁₀ cycloalkenyl group, a C₁-C₁₀ heterocycloalkenyl group, a C₆-C₆₀ aryl group, a C₇-C₆₀ alkyl aryl group, a C₆-C₆₀ aryloxy group, a C₆-C₆₀ arylthio group, a C₁-C₆₀ heteroaryl group, a C₂-C₆₀ alkyl heteroaryl group, a C₁-C₆₀ heteroaryloxy group, a C₁-C₆₀ heteroarylthio group, a monovalent non-aromatic condensed polycyclic group, or a monovalent non-aromatic condensed heteropolycyclic group, each unsubstituted or substituted with deuterium, -F, -Cl, -Br, -I, -SF₅, - CD₃, -CD₂H, -CDH₂, -CF₃, -CF₂H, -CFH₂, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, a C₁-C₆₀ alkyl group, a C₂-C₆₀ alkenyl group, a C₂-C₆₀ alkynyl group, a C₁-C₆₀ alkoxy group, a C₁-C₆₀ alkylthio group, a C₃-C₁₀ cycloalkyl group, a C₁-C₁₀ heterocycloalkyl group, a C₃-C₁₀ cycloalkenyl group, a C₁-C₁₀ heterocycloalkenyl group, a C₆-C₆₀ aryl group, a C₇-C₆₀ alkyl aryl group, a C₇-C₆₀ aryl alkyl group, a C₆-C₆₀ aryloxy group, a C₆-C₆₀ arylthio group, a C₁-C₆₀ heteroaryl group, a C₂-C₆₀ alkyl heteroaryl group, a C₂-C₆₀ heteroaryl alkyl group, a C₁-C₆₀ heteroaryloxy group, a C₁-C₆₀ heteroarylthio group, a monovalent non-aromatic condensed polycyclic group, a monovalent non-aromatic condensed heteropolycyclic group, -Si(Q₂₁)(Q₂₂)(Q₂₃), -Ge(Q₂₁)(Q₂₂)(Q₂₃), -N(Q₂₄)(Q₂₅), -B(Q₂₆)(Q₂₇), - P(Q₂₈)(Q₂₉), -P(=O)(Q₂₈)(Q₂₉), or a combination thereof;
   -Si(Q₃₁)(Q₃₂)(Q₃₃), -Ge(Q₃₁)(Q₃₂)(Q₃₃), -N(Q₃₄)(Q₃₅), -B(Q₃₆)(Q₃₇), - P(Q₃₈)(Q₃₉), or -P(=O)(Q₃₈)(Q₃₉); or
   a combination thereof, and
   Q₁ to Q₉, Q₁₁ to Q₁₉, Q₂₁ to Q₂₉, and Q₃₁ to Q₃₉ are each independently:
      hydrogen, deuterium, or -F; or
      a C₁-C₆₀ alkyl group, a C₂-C₆₀ alkenyl group, a C₂-C₆₀ alkynyl group, a C₁-C₆₀ alkoxy group, a C₁-C₆₀ alkylthio group, a C₃-C₁₀ cycloalkyl group, a C₁-C₁₀ heterocycloalkyl group, a C₃-C₁₀ cycloalkenyl group, a C₁-C₁₀ heterocycloalkenyl group, a C₆-C₆₀ aryl group, a C₇-C₆₀ alkyl aryl group, a C₇-C₆₀ aryl alkyl group, a C₆-C₆₀ aryloxy group, a C₆-C₆₀ arylthio group, a C₁-C₆₀ heteroaryl group, a C₂-C₆₀ alkyl heteroaryl group, a C₂-C₆₀ heteroaryl alkyl group, a C₁-C₆₀ heteroaryloxy group, a C₁-C₆₀ heteroarylthio group, a monovalent non-aromatic condensed polycyclic group, or a monovalent non-aromatic condensed heteropolycyclic group, each unsubstituted or substituted with deuterium, -F, a cyano group, a C₁-C₆₀ alkyl group, a C₆-C₆₀ aryl group, or a combination thereof.

According to another aspect, a light-emitting device includes a first electrode, a second electrode, and an interlayer arranged between the first electrode and the second electrode, wherein the interlayer includes an emission layer, and wherein the interlayer further includes at least one organometallic compound represented by Formula 1.

According to another aspect, an electronic apparatus includes the light-emitting device.

### BRIEF DESCRIPTION OF THE DRAWINGS

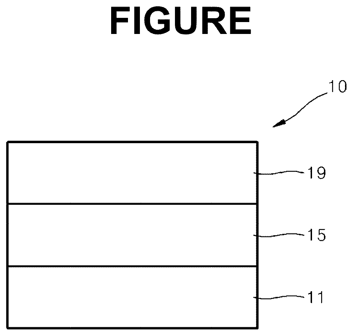

The above and other aspects, features, and advantages of certain exemplary embodiments will be more apparent from the following detailed description taken in conjunction with the FIGURE, which is a schematic cross-sectional view of an organic light-emitting device according to one or more embodiments.

### DETAILED DESCRIPTION OF THE EMBODIMENTS

Reference will now be made in further detail to exemplary embodiments, examples of which are illustrated in the accompanying drawing, wherein like reference numerals refer to like elements throughout the specification. In this regard, the present exemplary embodiments may have different forms and should not be construed as being limited to the detailed descriptions set forth herein. Accordingly, the exemplary embodiments are merely described in further detail below, and by referring to the figure, to explain certain aspects and features. As used herein, the term "and/or" includes any and all combinations of one or more of the associated listed items. Expressions such as "at least one of," when preceding a list of elements, modify the entire list of elements and do not modify the individual elements of the list.

The terminology used herein is for the purpose of describing one or more exemplary embodiments only and is not intended to be limiting. As used herein, the singular forms "a," "an," and "the" are intended to include the plural forms as well, unless the context clearly indicates otherwise. The term "or" means "and/or." It will be further understood that the terms "comprises" and/or "comprising," or "includes" and/or "including" when used in this specification, specify the presence of stated features, regions, integers, steps, operations, elements, and/or components, but do not preclude the presence or addition of one or more other features, regions, integers, steps, operations, elements, components, and/or groups thereof.

It will be understood that, although the terms first, second, third etc. may be used herein to describe various elements, components, regions, layers, and/or sections, these elements, components, regions, layers, and/or sections should not be limited by these terms. These terms are only used to distinguish one element, component, region, layer, or section from another element, component, region, layer, or section. Thus, a first element, component, region, layer, or section discussed below could be termed a second element, component, region, layer, or section without departing from the teachings of the present embodiments.

Exemplary embodiments are described herein with reference to cross section illustrations that are schematic illustrations of idealized embodiments. As such, variations from the shapes of the illustrations as a result, for example, of manufacturing techniques and/or tolerances, are to be expected. Thus, embodiments described herein should not be construed as limited to the particular shapes of regions as illustrated herein but are to include deviations in shapes that result, for example, from manufacturing. For example, a region illustrated or described as flat may, typically, have rough and/or nonlinear features. Moreover, sharp angles that are illustrated may be rounded. Thus, the regions illustrated in the figures are schematic in nature and their shapes are not intended to illustrate the precise shape of a region and are not intended to limit the scope of the present claims.

It will be understood that when an element is referred to as being "on" another element, it can be directly in contact with the other element or intervening elements may be present therebetween. In contrast, when an element is referred to as being "directly on" another element, there are no intervening elements present.

Unless otherwise defined, all terms (including technical and scientific terms) used herein have the same meaning as commonly understood by one of ordinary skill in the art to which this general inventive concept belongs. It will be further understood that terms, such as those defined in commonly used dictionaries, should be interpreted as having a meaning that is consistent with their meaning in the context of the relevant art and the present disclosure, and will not be interpreted in an idealized or overly formal sense unless expressly so defined herein.

"About" or "approximately" as used herein is inclusive of the stated value and means within an acceptable range of deviation for the particular value as determined by one of ordinary skill in the art, considering the measurement in question and the error associated with measurement of the particular quantity *(i.e.,* the limitations of the measurement system). For example, "about" can mean within one or more standard deviations, or within ± 30%, 20%, 10%, 5% of the stated value.

An aspect provides an organometallic compound represented by Formula 1:

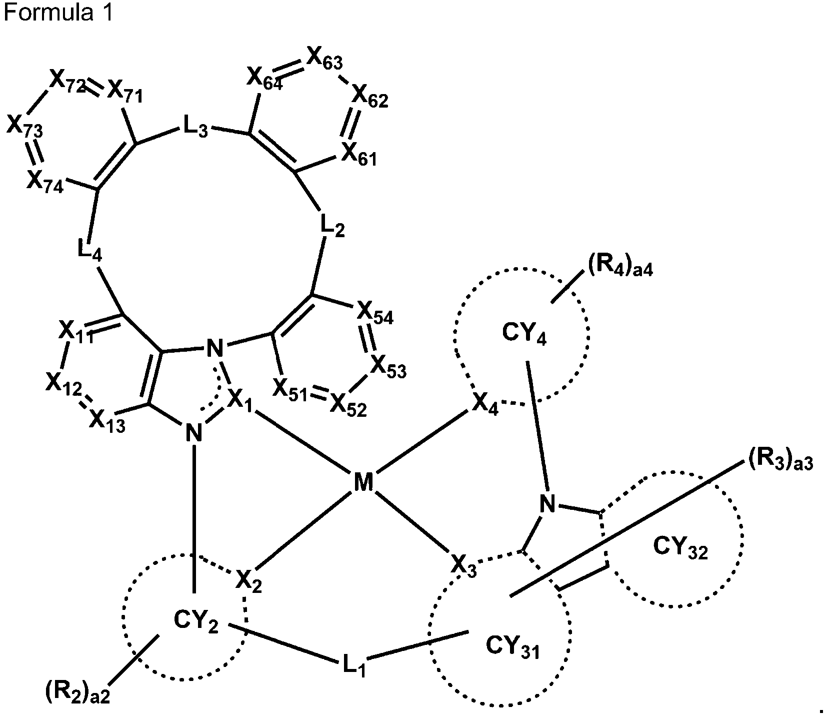

In Formula 1, M is Pt or Pd.

In one or more embodiments, M may be Pt.

In Formula 1, X₁ is C, and X₂ to X₄ are each independently be C or N.

In one or more embodiments, X₂ and X₃ may each be C, and X₄ may be N.

In one or more embodiments, a bond between X₁ and M and a bond between X₄ and M may each be a coordinate bond, and a bond between X₂ and M and a bond between X₃ and M may each be a covalent bond. That is, the organometallic compound may be electrically neutral.

Formula 1, in which X₁ is indicated as a carbene and X₄ is N, may be expressed as Formula 1', in which the charges of two nitrogen atoms are indicated as follows (i.e., Formula 1, in which X₄ is N, may be identical to Formula 1'), and it may be easily understood that descriptions of Formula 1, in which X₄ is N, may be applied to Formula 1':

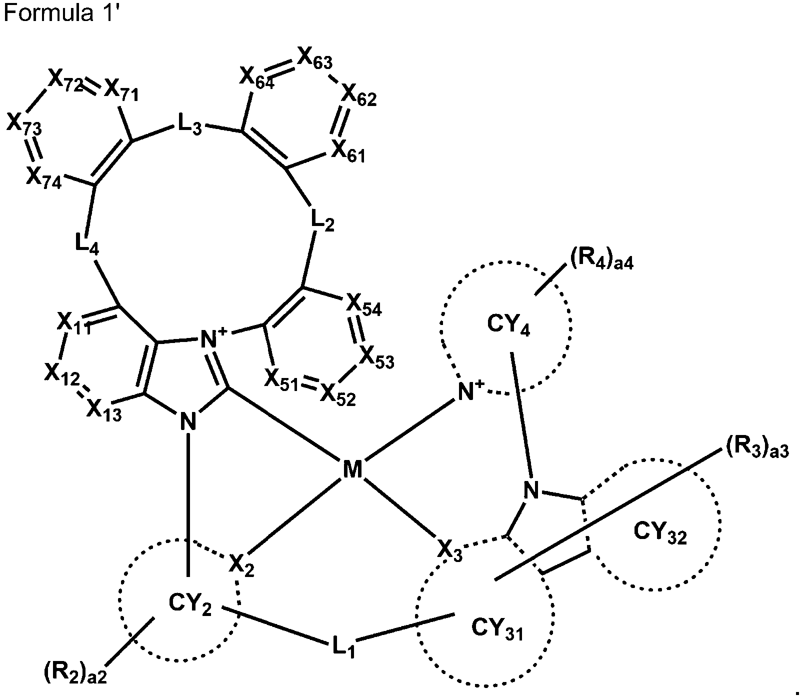

Ring CY₂, ring CY₃₁, ring CY₃₂, and ring CY₄ in Formula 1 are each independently a C₅-C₃₀ carbocyclic group or a C₁-C₃₀ heterocyclic group.

In one or more embodiments, ring CY₂, ring CY₃₁, ring CY₃₂, and ring CY₄ may each independently be a benzene group, a naphthalene group, a phenanthrene group, a pyridine group, a pyrimidine group, a pyridazine group, a pyrazine group, a triazine group, a quinoline group, an isoquinoline group, a benzoquinoline group, or a benzoisoquinoline group.

In one or more embodiments, ring CY₂, ring CY₃₁, and ring CY₃₂ may each independently be a benzene group, a naphthalene group, a phenanthrene group, a pyridine group, a pyrimidine group, a pyridazine group, a pyrazine group, a triazine group, a quinoline group, an isoquinoline group, a benzoquinoline group, or a benzoisoquinoline group, and ring CY₄ may be a pyridine group, a pyrimidine group, a pyridazine group, a pyrazine group, a triazine group, a quinoline group, an isoquinoline group, a benzoquinoline group, or a benzoisoquinoline group.

In Formula 1, X₁₁ is N or C(R₁₁), X₁₂ is N or C(R₁₂), X₁₃ is N or C(R₁₃), X₅₁ is N or C(R₅₁), X₅₂ is N or C(R₅₂), X₅₃ is N or C(R₅₃), X₅₄ is N or C(R₅₄), X₆₁ is N or C(R₆₁), X₆₂ is N or C(R₆₂), X₆₃ is N or C(R₆₃), X₆₄ is N or C(R₆₄), X₇₁ is N or C(R₇₁), X₇₂ is N or C(R₇₂), X₇₃ is N or C(R₇₃), and X₇₄ is N or C(R₇₄). R₁₁ to R₁₃, R₅₁ to R₅₄, R₆₁ to R₆₄, and R₇₁ to R₇₄ may each be as described herein.

In one or more embodiments, in Formula 1, X₁₁ may be C(R₁₁), X₁₂ may be C(R₁₂), X₁₃ may be C(R₁₃), X₅₁ may be C(R₅₁), X₅₂ may be C(R₅₂), X₅₃ may be C(R₅₃), X₅₄ may be C(R₅₄), X₆₁ may be C(R₆₁), X₆₂ may be C(R₆₂), X₆₃ may be C(R₆₃), X₆₄ may be C(R₆₄), X₇₁ may be C(R₇₁), X₇₂ may be C(R₇₂), X₇₃ may be C(R₇₃), and X₇₄ may be C(R₇₄).

In Formula 1, L₁ is O, S, Se, N(R₁₀₁), C(R₁₀₁)(R₁₀₂), or Si(R₁₀₁)(R₁₀₂).

In one or more embodiments, L₁ in Formula 1 may be O or S. R₁₀₁ and R₁₀₂ may each be as described herein.

In Formula 1, L₂, L₃, and L₄ are each independently a single bond, O, S, Se, N(R'), C(R')(R"), or Si(R')(R"), wherein at least one of L₂, L₃, and L₄ (or, "L₂, L₃, L₄, or any combination thereof") is O, S, Se, N(R'), C(R')(R"), or Si(R')(R").

In one or more embodiments, L₂, L₃, L₄, or any combination thereof in Formula 1 may be N(R').

In one or more embodiments, L₂, L₃, L₄, or any combination thereof in Formula 1 may be O, S, or Se.

In one or more embodiments, L₂, L₃, L₄, or any combination thereof in Formula 1 may be C(R')(R") or Si(R')(R").

In one or more embodiments, two of L₂, L₃, or L₄ in Formula 1 may each be a single bond, and the remaining one of L₂, L₃, or L₄ may not be a single bond.

In one or more embodiments, in Formula 1,
i) L₂ and L₃ are each a single bond, and L₄ is O, S, Se, N(R'), C(R')(R"), or Si(R')(R"),
ii) L₂ and L₄ are each a single bond, and L₃ is O, S, Se, N(R'), C(R')(R"), or Si(R')(R"), or
iii) L₃ and L₄ are each a single bond, and L₂ is O, S, Se, N(R'), C(R')(R"), or Si(R')(R").

In Formula 1, i) when L₂ is N(R'), R' is not linked to either of X₅₄ and X₆₁, ii) when L₃ is N(R'), R' is not linked to either of X₆₄ and X₇₁, and iii) when L₄ is N(R'), R' is not linked to either of X₇₄ and X₁₁. That is, for example, Compounds C3 and C4 described below may not be included in Formula 1 described herein.

For example, in Formula 1, i) when L₂ is N(R'), R' is not linked to X₅₄ and X₆₁, ii) when L₃ is N(R'), R' is not linked to X₆₄ and X₇₁, and iii) when L₄ is N(R'), R' is not linked to X₇₄ and X₁₁.

In Formula 1, R₂, R₃, R₄, R₁₁ to R₁₃, R₅₁ to R₅₄, R₆₁ to R₆₄, R₇₁ to R₇₄, R₁₀₁, R₁₀₂, R', and R" are each independently hydrogen, deuterium, -F, -Cl, -Br, -I, -SF₅, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, a substituted or unsubstituted C₁-C₆₀ alkyl group (e.g., a substituted or unsubstituted C₁-C₂₀ alkyl group), a substituted or unsubstituted C₂-C₆₀ alkenyl group (e.g., a substituted or unsubstituted C₂-C₂₀ alkenyl group), a substituted or unsubstituted C₂-C₆₀ alkynyl group, a substituted or unsubstituted C₁-C₆₀ alkoxy group (e.g., a substituted or unsubstituted C₁-C₂₀ alkoxy group), a substituted or unsubstituted C₁-C₆₀ alkylthio group, a substituted or unsubstituted C₃-C₁₀ cycloalkyl group, a substituted or unsubstituted C₁-C₁₀ heterocycloalkyl group, a substituted or unsubstituted C₃-C₁₀ cycloalkenyl group, a substituted or unsubstituted C₁-C₁₀ heterocycloalkenyl group, a substituted or unsubstituted C₆-C₆₀ aryl group (e.g., a substituted or unsubstituted C₆-C₂₀ aryl group), a substituted or unsubstituted C₇-C₆₀ alkyl aryl group, a substituted or unsubstituted C₇-C₆₀ aryl alkyl group, a substituted or unsubstituted C₆-C₆₀ aryloxy group, a substituted or unsubstituted C₆-C₆₀ arylthio group, a substituted or unsubstituted C₁-C₆₀ heteroaryl group (e.g., a substituted or unsubstituted C₁-C₂₀ heteroaryl group), a substituted or unsubstituted C₂-C₆₀ alkyl heteroaryl group, a substituted or unsubstituted C₂-C₆₀ heteroaryl alkyl group, a substituted or unsubstituted C₁-C₆₀ heteroaryloxy group, a substituted or unsubstituted C₁-C₆₀ heteroarylthio group, a substituted or unsubstituted monovalent non-aromatic condensed polycyclic group, a substituted or unsubstituted monovalent non-aromatic condensed heteropolycyclic group, -Si(Q₁)(Q₂)(Q₃), -Ge(Q₁)(Q₂)(Q₃), -N(Q₄)(Q₅), - B(Q₆)(Q₇), -P(Q₈)(Q₉), or -P(=O)(Q₈)(Q₉). Q₁ to Q₉ are each as described herein.

In one or more embodiments, R₂, R₃, R₄, R₁₁ to R₁₃, R₅₁ to R₅₄, R₆₁ to R₆₄, R₇₁ to R₇₄, R₁₀₁, R₁₀₂, R', and R" may each independently be:
hydrogen, deuterium, -F, or a cyano group;
a C₁-C₂₀ alkyl group or a C₁-C₂₀ alkoxy group, each unsubstituted or substituted with deuterium, -F, a cyano group, or a combination thereof;
a C₃-C₁₀ cycloalkyl group, a phenyl group, a naphthyl group, a pyridinyl group, a furanyl group, a thiophenyl group, a benzofuranyl group, a benzothiophenyl group, a carbazolyl group, a dibenzofuranyl group, or a dibenzothiophenyl group, each unsubstituted or substituted with deuterium, - F, a cyano group, a C₁-C₂₀ alkyl group, a C₁-C₂₀ alkoxy group, a deuterated C₁-C₂₀ alkyl group, a fluorinated C₁-C₂₀ alkyl group, a C₃-C₁₀ cycloalkyl group, a deuterated C₃-C₁₀ cycloalkyl group, a fluorinated C₃-C₁₀ cycloalkyl group, a (C₁-C₂₀ alkyl)C₃-C₁₀ cycloalkyl group, a phenyl group, a deuterated phenyl group, a fluorinated phenyl group, a (C₁-C₂₀ alkyl)phenyl group, a naphthyl group, a pyridinyl group, a furanyl group, a thiophenyl group, a benzofuranyl group, a benzothiophenyl group, a carbazolyl group, a dibenzofuranyl group, a dibenzothiophenyl group, -Si(Q₃₃)(Q₃₄)(Q₃₅), -Ge(Q₃₃)(Q₃₄)(Q₃₅), or a combination thereof; or
-Si(Q₃)(Q₄)(Q₅) or -Ge(Q₃)(Q₄)(Q₅).

In one or more embodiments, R₂, R₃, R₄, R₁₁ to R₁₃, R₅₁ to R₅₄, R₆₁ to R₆₄, R₇₁ to R₇₄, R₁₀₁, R₁₀₂, R', and R" may each independently be:
hydrogen or deuterium; or
a C₁-C₂₀ alkyl group, a phenyl group, or a carbazolyl group (e.g., an N-carbazolyl group), each unsubstituted or substituted with deuterium, a C₁-C₂₀ alkyl group, a phenyl group, a carbazolyl group (e.g., an N-carbazolyl group), or a combination thereof.

Non-limiting examples of the term "a C₁-C₂₀ alkyl group, a phenyl group, or a carbazolyl group, each substituted with deuterium, a C₁-C₂₀ alkyl group, a phenyl group, a carbazolyl group, or a combination thereof" as used herein may include:
a C₁-C₂₀ alkyl group substituted with at least one deuterium,
a C₁-C₂₀ alkyl group substituted with at least one phenyl group,
a C₁-C₂₀ alkyl group substituted with at least one deuterium and at least one phenyl group,
a C₁-C₂₀ alkyl group substituted with at least one deuterium and at least one deuterated phenyl group (e.g., a fully deuterated phenyl group, or the like),
a C₁-C₂₀ alkyl group substituted with at least one phenyl group, wherein the phenyl group is substituted with at least one deuterium, at least one C₁-C₂₀ alkyl group, or a combination thereof,
a phenyl group substituted with at least one deuterium,
a phenyl group substituted with at least one C₁-C₂₀ alkyl group,
a phenyl group substituted with at least one deuterium and at least one C₁-C₂₀ alkyl group,
a phenyl group substituted with at least one deuterium and at least one deuterated C₁-C₂₀ alkyl group (e.g., -CD₃, CD₂H, -CDH₂, -CD₂CD₃, -CH₂CD₃, or the like),
a phenyl group substituted with at least one C₁-C₂₀ alkyl group and at least one deuterated C₁-C₂₀ alkyl group, or
a carbazolyl group substituted with at least one deuterium.

In one or more embodiments, R₂, R₃, R₄, R₁₁ to R₁₃, R₅₁ to R₅₄, R₆₁ to R₆₄, R₇₁ to R₇₄, R₁₀₁, R₁₀₂, R', and R" may each independently be:
hydrogen or deuterium;
a methyl group, an ethyl group, an n-propyl group, an isopropyl group, an n-butyl group, a sec-butyl group, an isobutyl group, a tert-butyl group, an n-pentyl group, a tert-pentyl group, a neopentyl group, an isopentyl group, a sec-pentyl group, a 3-pentyl group, a sec-isopentyl group, an n-hexyl group, an isohexyl group, a sec-hexyl group, a tert-hexyl group, an n-heptyl group, an isoheptyl group, a sec-heptyl group, a tert-heptyl group, an n-octyl group, an isooctyl group, a sec-octyl group, a tert-octyl group, an n-nonyl group, an isononyl group, a sec-nonyl group, a tert-nonyl group, an n-decyl group, an isodecyl group, a sec-decyl group, or a tert-decyl group, each unsubstituted or substituted with deuterium, a phenyl group, or a combination thereof; or
a phenyl group or a carbazolyl group, each unsubstituted or substituted with deuterium, a methyl group, an ethyl group, an n-propyl group, an isopropyl group, an n-butyl group, a sec-butyl group, an isobutyl group, a tert-butyl group, an n-pentyl group, a tert-pentyl group, a neopentyl group, an isopentyl group, a sec-pentyl group, a 3-pentyl group, a sec-isopentyl group, an n-hexyl group, an isohexyl group, a sec-hexyl group, a tert-hexyl group, an n-heptyl group, an isoheptyl group, a sec-heptyl group, a tert-heptyl group, an n-octyl group, an isooctyl group, a sec-octyl group, a tert-octyl group, an n-nonyl group, an isononyl group, a sec-nonyl group, a tert-nonyl group, an n-decyl group, an isodecyl group, a sec-decyl group, a tert-decyl group, or a combination thereof.

In one or more embodiments, the organometallic compound represented by Formula 1 may include deuterium, a tert-butyl group unsubstituted or substituted with at least one deuterium, or a combination thereof.

In Formula 1, a2 to a4 indicate the numbers of R₂ to R₄, respectively, and are each independently an integer from 0 to 20, 0 to 15, 0 to 10, 0 to 6, 0 to 5, 0 to 4, or 0 to 3. Each of a2 to a4 may be variously selected within the range described above, according to the structures of ring CY₂, ring CY₃₁, ring CY₃₂, and ring CY₄. When a2 is 2 or more, two or more of R₂ may be identical to or different from each other, when a3 is 2 or more, two or more of R₃ may be identical to or different from each other, and when a4 is 2 or more, two or more of R₄ may be identical to or different from each other.

In one or more embodiments, a2 may be an integer from 0 to 3.

In one or more embodiments, a3 may be an integer from 0 to 6.

In one or more embodiments, a4 may be an integer from 0 to 4.

In one or more embodiments, a2 may not be 0, and R₂ may not be hydrogen.

In one or more embodiments, a4 may not be 0, and R₄ may not be hydrogen.

In one or more embodiments, Formula 1 may satisfy at least one of the following conditions:
Condition 11
   X₁₁ is C(R₁₁), and R₁₁ is not hydrogen
Condition 12
   X₁₂ is C(R₁₂), and R₁₂ is not hydrogen
Condition 13
   X₁₃ is C(R₁₃), and R₁₃ is not hydrogen
Condition 51
   X₅₁ is C(R₅₁), and R₅₁ is not hydrogen
Condition 52
   X₅₂ is C(R₅₂), and R₅₂ is not hydrogen
Condition 53
   X₅₃ is C(R₅₃), and R₅₃ is not hydrogen
Condition 54
   X₅₄ is C(R₅₄), and R₅₄ is not hydrogen
Condition 61
   X₆₁ is C(R₆₁), and R₆₁ is not hydrogen
Condition 62
   X₆₂ is C(R₆₂), and R₆₂ is not hydrogen
Condition 63
   X₆₃ is C(R₆₃), and R₆₃ is not hydrogen
Condition 64
   X₆₄ is C(R₆₄), and R₆₄ is not hydrogen
Condition 71
   X₇₁ is C(R₇₁), and R₇₁ is not hydrogen
Condition 72
   X₇₂ is C(R₇₂), and R₇₂ is not hydrogen
Condition 73
   X₇₃ is C(R₇₃), and R₇₃ is not hydrogen
Condition 74
   X₇₄ is C(R₇₄), and R₇₄ is not hydrogen.

R₁₁ to R₁₃, R₅₁ to R₅₄, R₆₁ to R₆₄, and R₇₁ to R₇₄ in Conditions 11 to 13, 51 to 54, 61 to 64, and 71 to 74 may each be as described herein.

In one or more embodiments, Formula 1 may satisfy at least one of Conditions 51 to 54, at least one of Conditions 61 to 64, at least one of Conditions 71 to 74, or a combination thereof.

In one or more embodiments, Formula 1 may satisfy at least one of Conditions 51 or 53.

In one or more embodiments, Formula 1 may satisfy at least one of Conditions 62 or 63.

In one or more embodiments, Formula 1 may satisfy at least one of Conditions 71 or 74.

In one or more embodiments, R₁₁ to R₁₃, R₅₁ to R₅₄, R₆₁ to R₆₄, and R₇₁ to R₇₄ in Conditions 11 to 13, 51 to 54, 61 to 64, and 71 to 74 may each independently be:
deuterium, -F, or a cyano group;
a C₁-C₂₀ alkyl group or a C₁-C₂₀ alkoxy group, each unsubstituted or substituted with deuterium, -F, a cyano group, or a combination thereof;
a C₃-C₁₀ cycloalkyl group, a phenyl group, a naphthyl group, a pyridinyl group, a furanyl group, a thiophenyl group, a benzofuranyl group, a benzothiophenyl group, a carbazolyl group, a dibenzofuranyl group, or a dibenzothiophenyl group, each unsubstituted or substituted with deuterium, - F, a cyano group, a C₁-C₂₀ alkyl group, a C₁-C₂₀ alkoxy group, a deuterated C₁-C₂₀ alkyl group, a fluorinated C₁-C₂₀ alkyl group, a C₃-C₁₀ cycloalkyl group, a deuterated C₃-C₁₀ cycloalkyl group, a fluorinated C₃-C₁₀ cycloalkyl group, a (C₁-C₂₀ alkyl)C₃-C₁₀ cycloalkyl group, a phenyl group, a deuterated phenyl group, a fluorinated phenyl group, a (C₁-C₂₀ alkyl)phenyl group, a naphthyl group, a pyridinyl group, a furanyl group, a thiophenyl group, a benzofuranyl group, a benzothiophenyl group, a carbazolyl group, a dibenzofuranyl group, a dibenzothiophenyl group, -Si(Q₃₁)(Q₃₂)(Q₃₃), -Ge(Q₃₁)(Q₃₂)(Q₃₃), or a combination thereof; or
-Si(Q₁)(Q₂)(Q₃) or -Ge(Q₁)(Q₂)(Q₃).

In Formula 1,
two or more of R₁₁ to R₁₃ are optionally linked to each other to form a C₅-C₃₀ carbocyclic group unsubstituted or substituted with at least one R₁₀ₐ or a C₁-C₃₀ heterocyclic group unsubstituted or substituted with at least one R₁₀ₐ,
two or more of a plurality of R₂ are optionally linked to each other to form a C₅-C₃₀ carbocyclic group unsubstituted or substituted with at least one R₁₀ₐ or a C₁-C₃₀ heterocyclic group unsubstituted or substituted with at least one R₁₀ₐ,
two or more of a plurality of R₃ are optionally linked to each other to form a C₅-C₃₀ carbocyclic group unsubstituted or substituted with at least one R₁₀ₐ or a C₁-C₃₀ heterocyclic group unsubstituted or substituted with at least one R₁₀ₐ,
two or more of a plurality of R₄ are optionally linked to each other to form a C₅-C₃₀ carbocyclic group unsubstituted or substituted with at least one R₁₆ₐ or a C₁-C₃₀ heterocyclic group unsubstituted or substituted with at least one R₁₀ₐ,
two or more of R₅₁ to R₅₄ are optionally linked to each other to form a C₅-C₃₀ carbocyclic group unsubstituted or substituted with at least one R₁₆ₐ or a C₁-C₃₀ heterocyclic group unsubstituted or substituted with at least one R₁₆ₐ,
two or more of R₆₁ to R₆₄ are optionally linked to each other to form a C₅-C₃₀ carbocyclic group unsubstituted or substituted with at least one R₁₀ₐ or a C₁-C₃₀ heterocyclic group unsubstituted or substituted with at least one R₁₀ₐ,
two or more of R₇₁ to R₇₄ are optionally linked to each other to form a C₅-C₃₀ carbocyclic group unsubstituted or substituted with at least one R₁₀ₐ or a C₁-C₃₀ heterocyclic group unsubstituted or substituted with at least one R₁₀ₐ,
R₁₀₁ and R₁₀₂ are optionally linked to each other to form a C₅-C₃₀ carbocyclic group unsubstituted or substituted with at least one R₁₀ₐ or a C₁-C₃₀ heterocyclic group unsubstituted or substituted with at least one R₁₀ₐ, and
R' and R" are optionally linked to each other to form a C₅-C₃₀ carbocyclic group unsubstituted or substituted with at least one R₁₀ₐ or a C₁-C₃₀ heterocyclic group unsubstituted or substituted with at least one R₁₀ₐ. R₁₀ₐ may be as described in connection with R₁₁.

In one or more embodiments, the organometallic compound represented by Formula 1 may be represented by Formula 1-1: 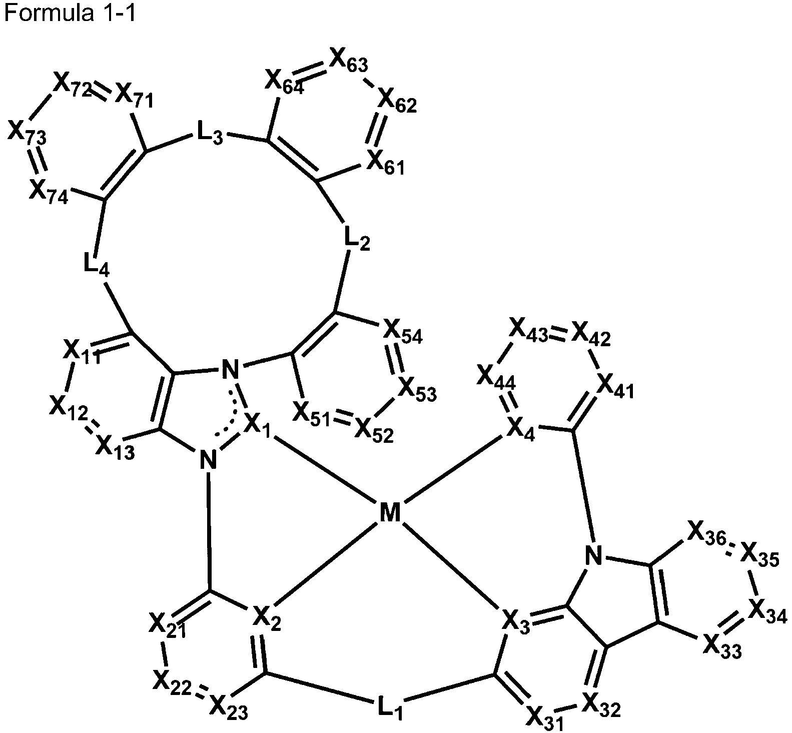 wherein, in Formula 1-1,
M, X₁ to X₄, X₁₁ to X₁₃, X₅₁ to X₅₄, X₆₁ to X₆₄, X₇₁ to X₇₄, and L₁ to L₄ may each be as described herein,
X₂₁ may be N or C(R₂₁), X₂₂ may be N or C(R₂₂), and X₂₃ may be N or C(R₂₃),
R₂₁ to R₂₃ may each be as described in connection with R₂,
X₃₁ may be N or C(R₃₁), X₃₂ may be N or C(R₃₂), X₃₃ may be N or C(R₃₃), X₃₄ may be N or C(R₃₄), X₃₅ may be N or C(R₃₅), and X₃₆ may be N or C(R₃₆),
R₃₁ to R₃₆ may each be as described in connection with R₃,
X₄₁ may be N or C(R₄₁), X₄₂ may be N or C(R₄₂), X₄₃ may be N or C(R₄₃), and X₄₄ may be N or C(R₄₄),
R₄₁ to R₄₄ may each be as described in connection with R₄,
two or more of R₁₁ to R₁₃ may optionally be linked to each other to form a C₅-C₃₀ carbocyclic group unsubstituted or substituted with at least one R₁₀ₐ or a C₁-C₃₀ heterocyclic group unsubstituted or substituted with at least one R₁₀ₐ,
two or more of R₂₁ to R₂₃ may optionally be linked to each other to form a C₅-C₃₀ carbocyclic group unsubstituted or substituted with at least one R₁₀ₐ or a C₁-C₃₀ heterocyclic group unsubstituted or substituted with at least one R₁₀ₐ,
two or more of R₃₁ to R₃₆ may optionally be linked to each other to form a C₅-C₃₀ carbocyclic group unsubstituted or substituted with at least one R₁₀ₐ or a C₁-C₃₀ heterocyclic group unsubstituted or substituted with at least one R₁₀ₐ,
two or more of R₄₁ to R₄₄ may optionally be linked to each other to form a C₅-C₃₀ carbocyclic group unsubstituted or substituted with at least one R₁₀ₐ or a C₁-C₃₀ heterocyclic group unsubstituted or substituted with at least one R₁₀ₐ, and
R₁₀ₐ may be as described in connection with R₁₁.

All descriptions of Formula 1 provided herein may be applied to Formula 1-1.

In one or more embodiments, Formula 1-1 may satisfy at least one of the following conditions:
Condition 21
   X₂₁ is C(R₂₁), and R₂₁ is not hydrogen
Condition 22
   X₂₂ is C(R₂₂), and R₂₂ is not hydrogen
Condition 23
   X₂₃ is C(R₂₃), and R₂₃ is not hydrogen
Condition 31
   X₃₁ is C(R₃₁), and R₃₁ is not hydrogen
Condition 32
   X₃₂ is C(R₃₂), and R₃₂ is not hydrogen
Condition 33
   X₃₃ is C(R₃₃), and R₃₃ is not hydrogen
Condition 34
   X₃₄ is C(R₃₄), and R₃₄ is not hydrogen
Condition 35
   X₃₅ is C(R₃₅), and R₃₅ is not hydrogen
Condition 36
   X₃₆ is C(R₃₆), and R₃₆ is not hydrogen
Condition 41
   X₄₁ is C(R₄₁), and R₄₁ is not hydrogen
Condition 42
   X₄₂ is C(R₄₂), and R₄₂ is not hydrogen
Condition 43
   X₄₃ is C(R₄₃), and R₄₃ is not hydrogen
Condition 44
   X₄₄ is C(R₄₄), and R₄₄ is not hydrogen.

R₂₁ to R₂₃, R₃₁ to R₃₆, and R₄₁ to R₄₄ in Conditions 21 to 23, 31 to 36, and 41 to 44 may each be as described herein.

In one or more embodiments, Formula 1-1 may satisfy Condition 42.

In one or more embodiments, Formula 1-1 may satisfy Conditions 22 and 42.

In one or more embodiments, R₂₁ to R₂₃, R₃₁ to R₃₆, and R₄₁ to R₄₄ in Conditions 21 to 23, 31 to 36, and 41 to 44 may each independently be:
deuterium, -F, or a cyano group;
a C₁-C₂₀ alkyl group or a C₁-C₂₀ alkoxy group, each unsubstituted or substituted with deuterium, -F, a cyano group, or a combination thereof;
a C₃-C₁₀ cycloalkyl group, a phenyl group, a naphthyl group, a pyridinyl group, a furanyl group, a thiophenyl group, a benzofuranyl group, a benzothiophenyl group, a carbazolyl group, a dibenzofuranyl group, or a dibenzothiophenyl group, each unsubstituted or substituted with deuterium, - F, a cyano group, a C₁-C₂₀ alkyl group, a C₁-C₂₀ alkoxy group, a deuterated C₁-C₂₀ alkyl group, a fluorinated C₁-C₂₀ alkyl group, a C₃-C₁₀ cycloalkyl group, a deuterated C₃-C₁₀ cycloalkyl group, a fluorinated C₃-C₁₀ cycloalkyl group, a (C₁-C₂₀ alkyl)C₃-C₁₀ cycloalkyl group, a phenyl group, a deuterated phenyl group, a fluorinated phenyl group, a (C₁-C₂₀ alkyl)phenyl group, a naphthyl group, a pyridinyl group, a furanyl group, a thiophenyl group, a benzofuranyl group, a benzothiophenyl group, a carbazolyl group, a dibenzofuranyl group, a dibenzothiophenyl group, -Si(Q₃₁)(Q₃₂)(Q₃₃), -Ge(Q₃₁)(Q₃₂)(Q₃₃), or a combination thereof; or
-Si(Q₁)(Q₂)(Q₃) or -Ge(Q₁)(Q₂)(Q₃).

In one or more embodiments, the organometallic compound represented by Formula 1 may be one of Compounds 1 to 420:

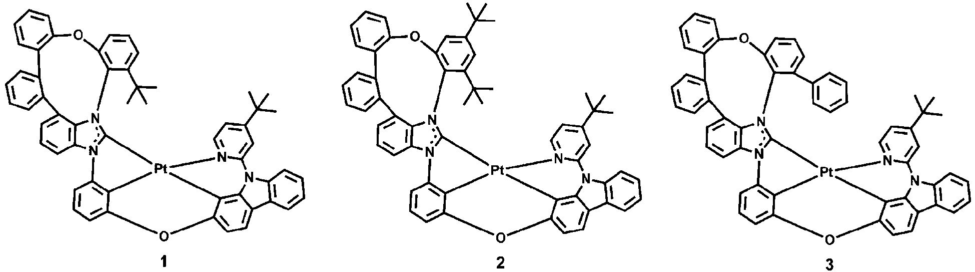

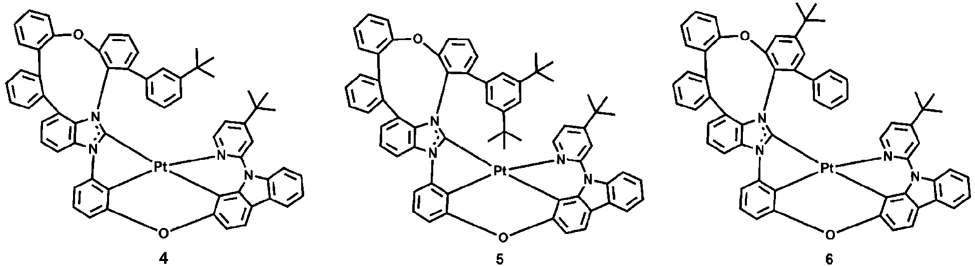

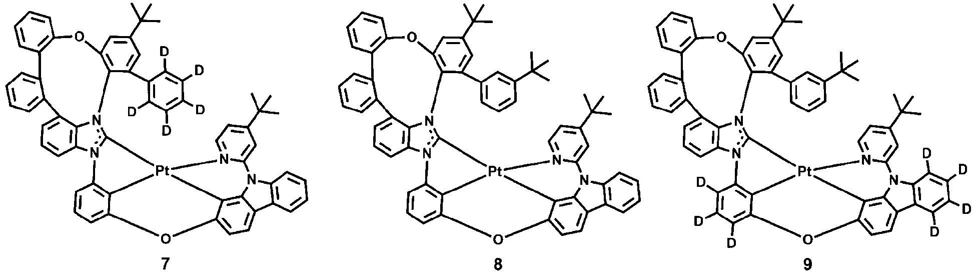

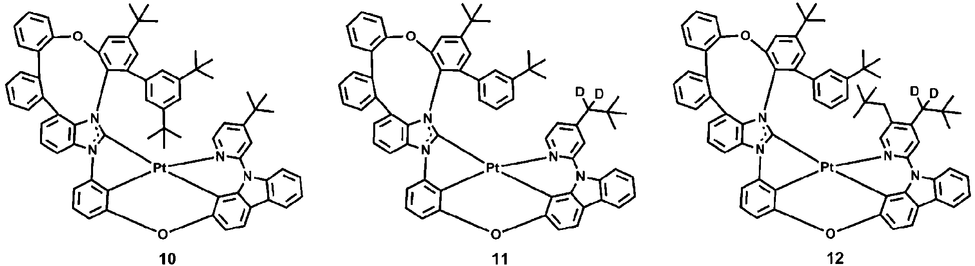

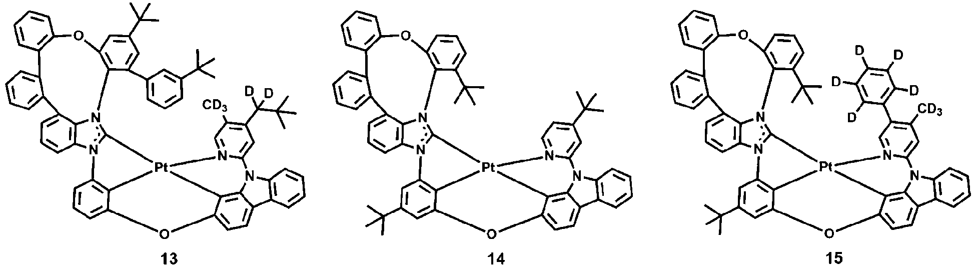

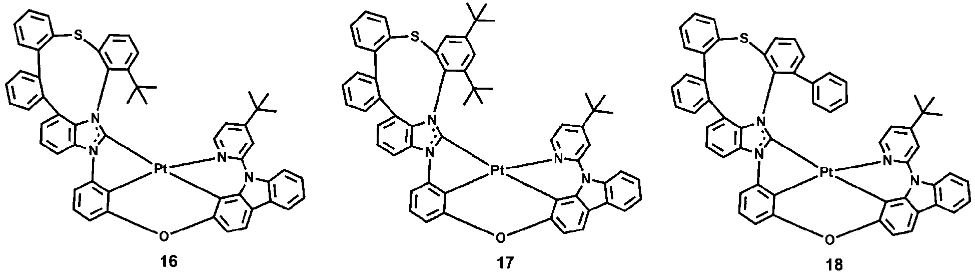

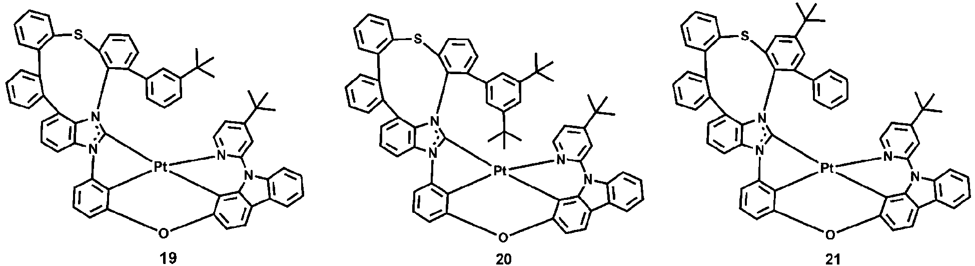

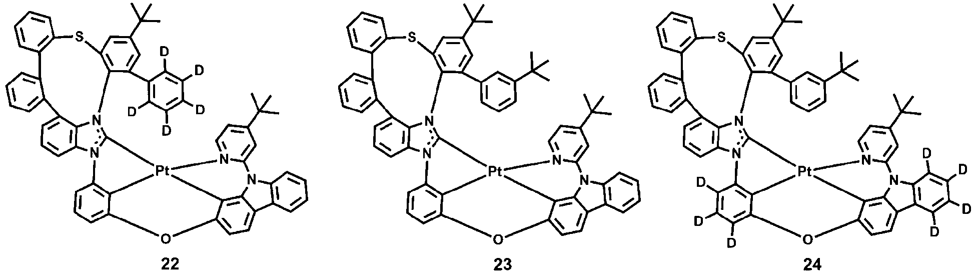

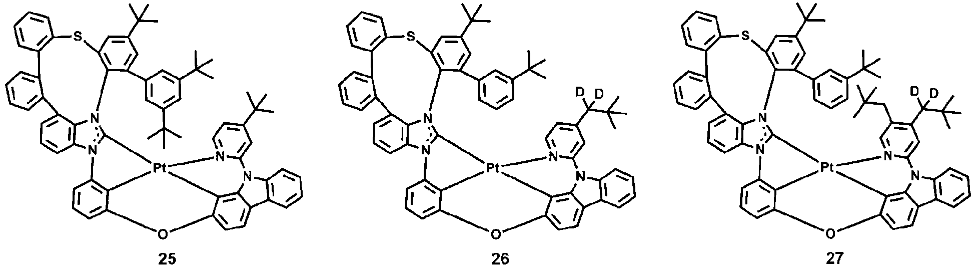

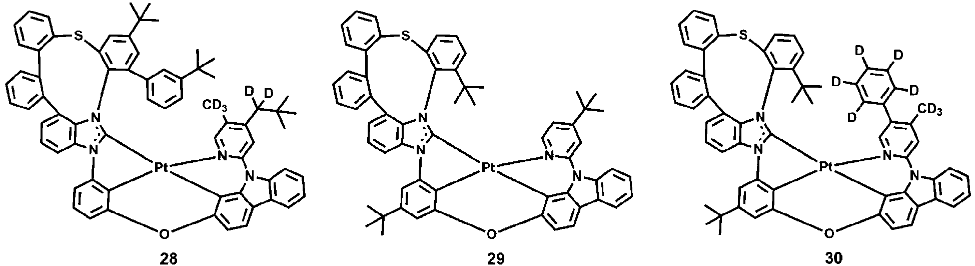

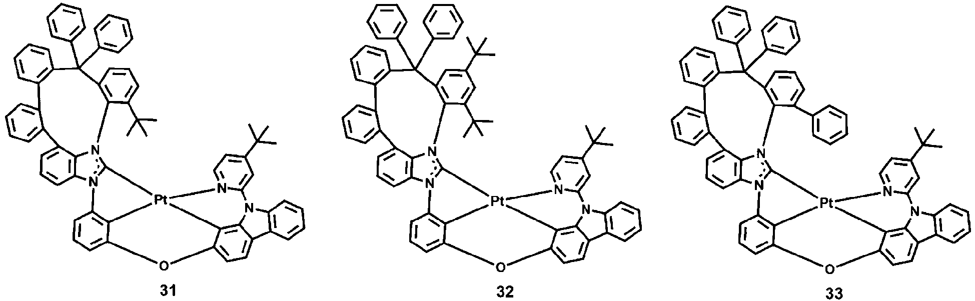

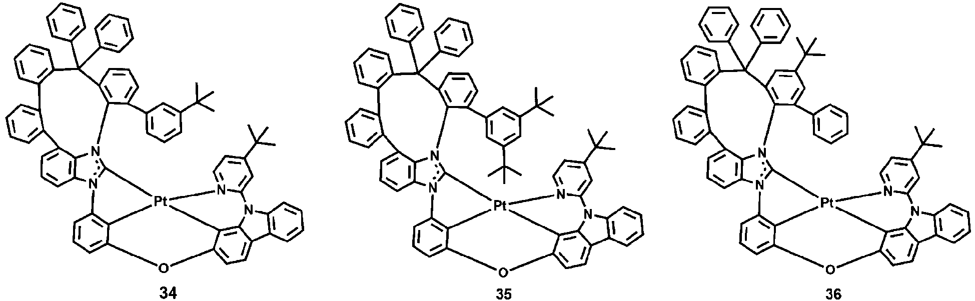

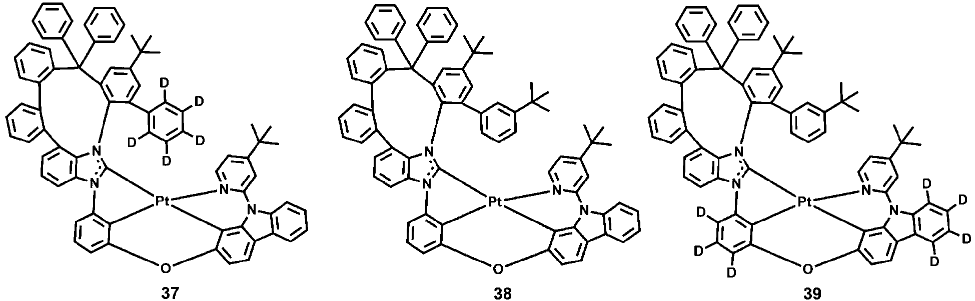

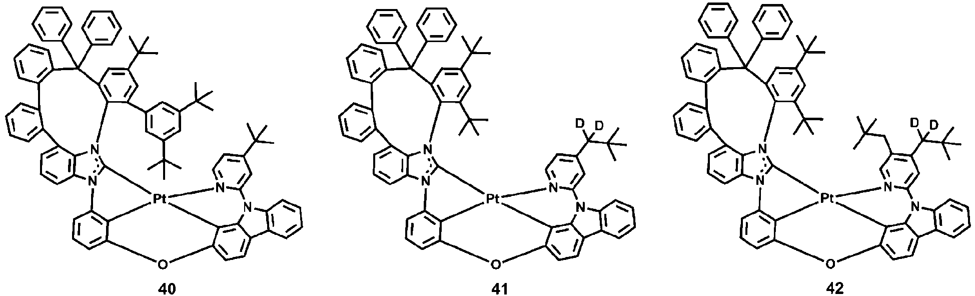

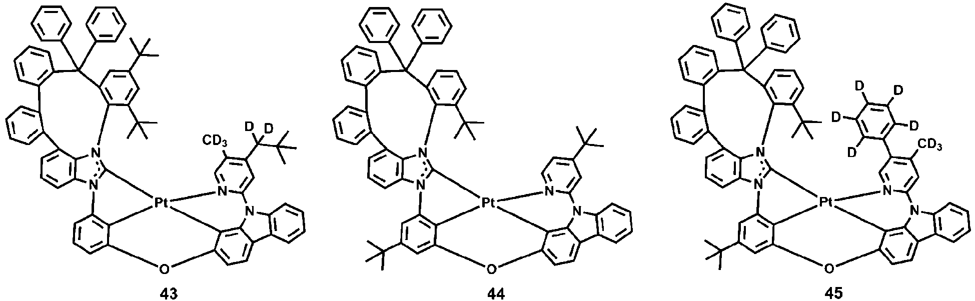

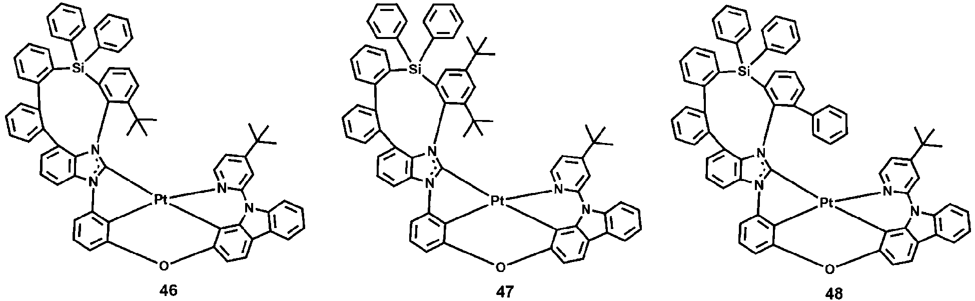

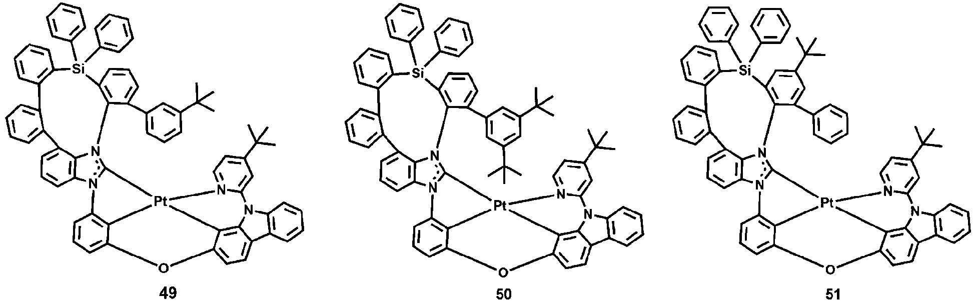

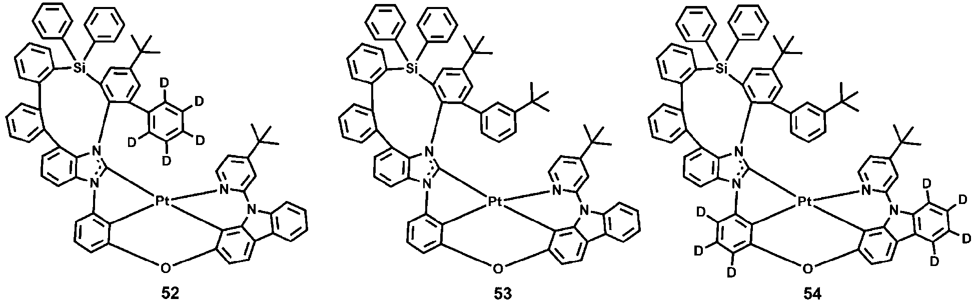

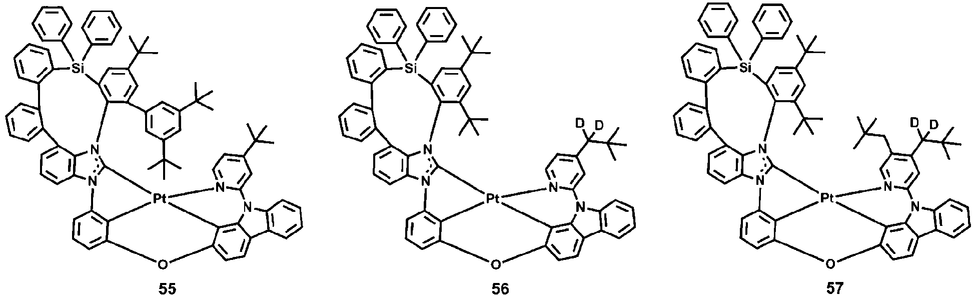

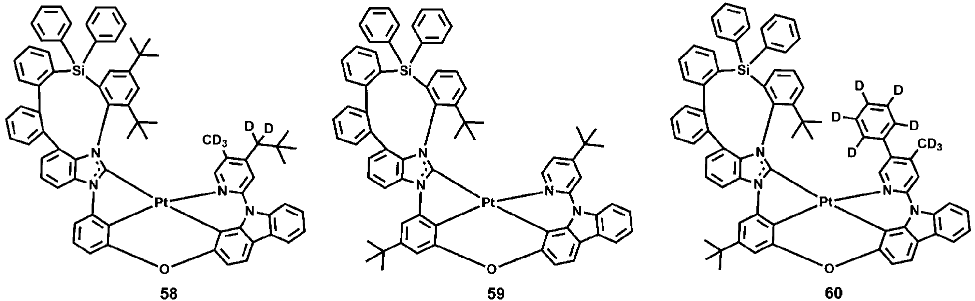

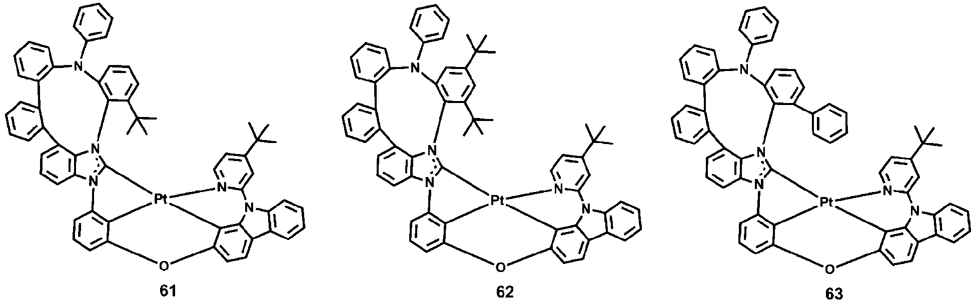

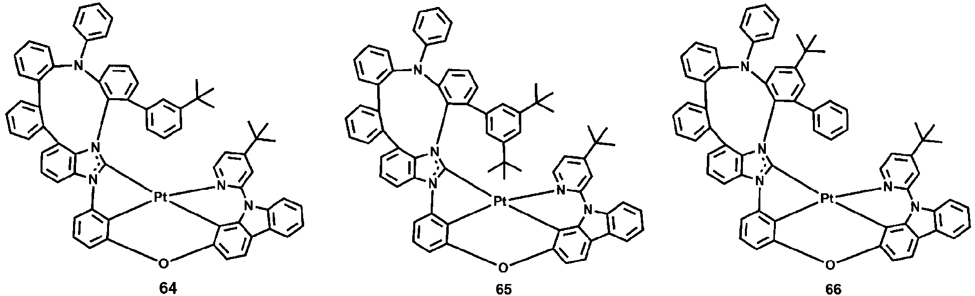

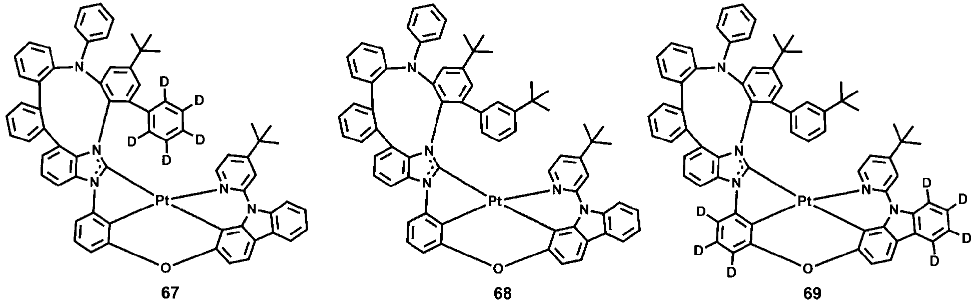

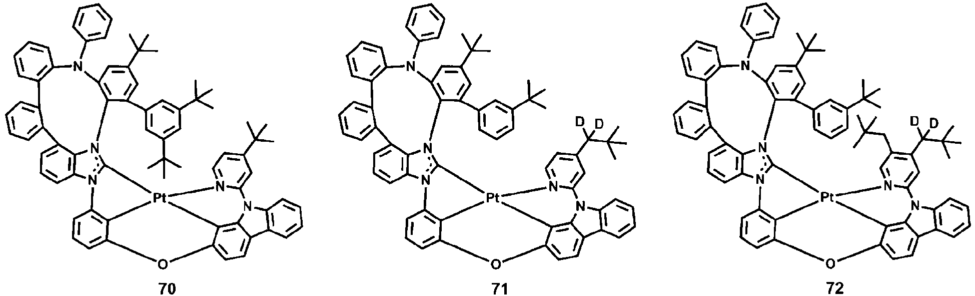

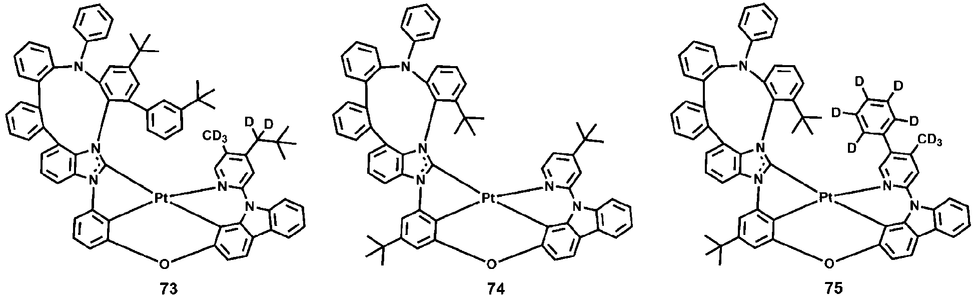

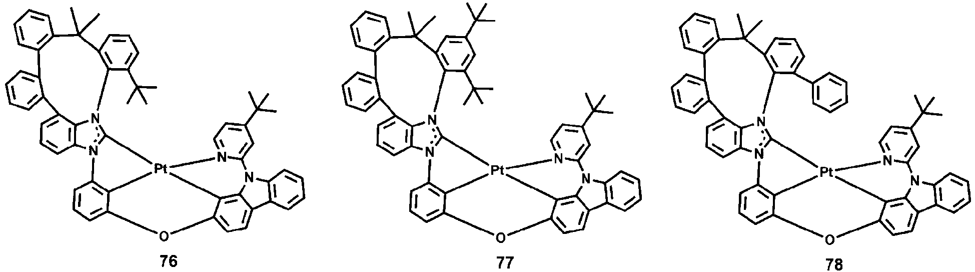

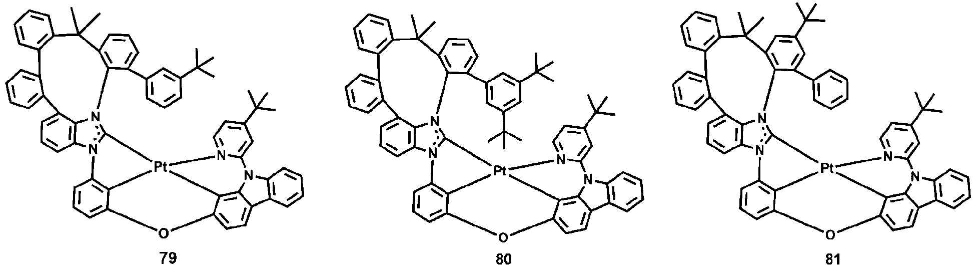

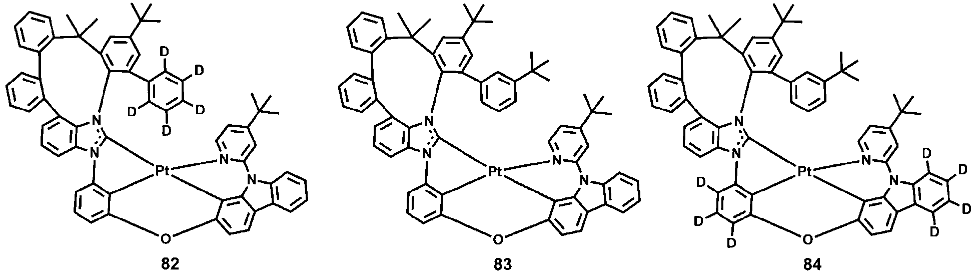

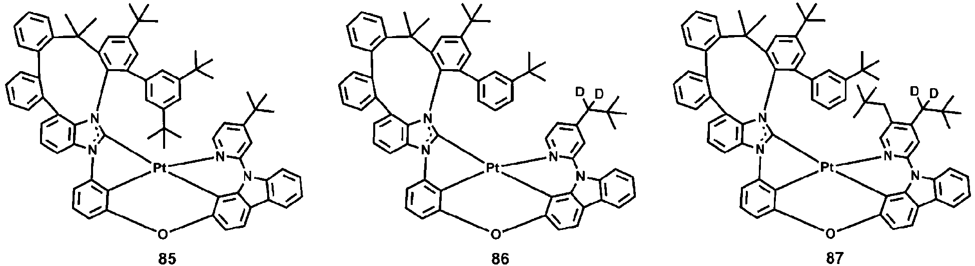

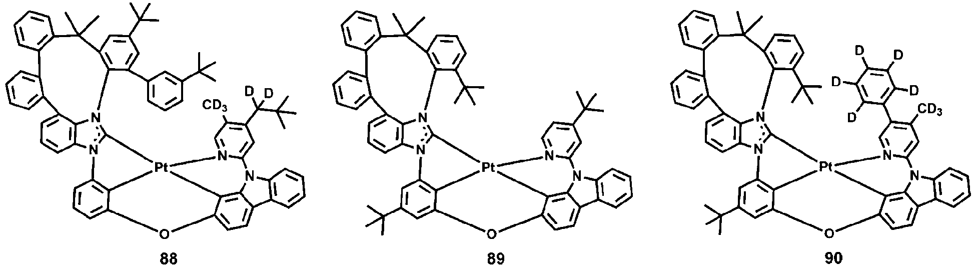

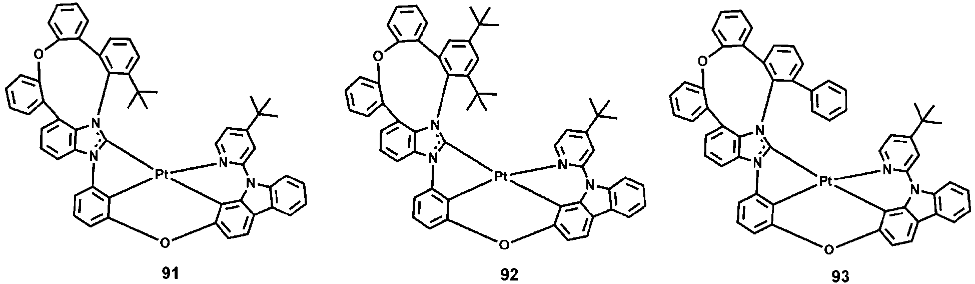

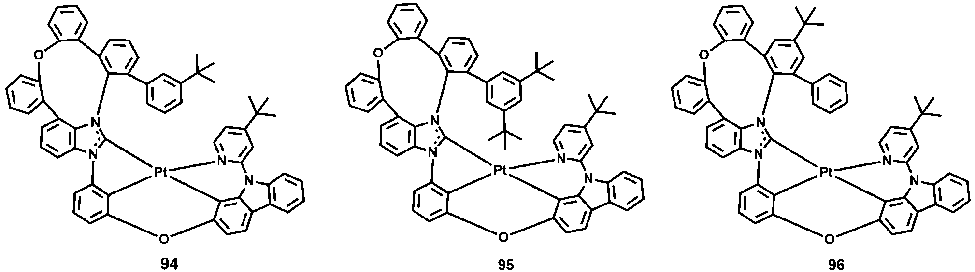

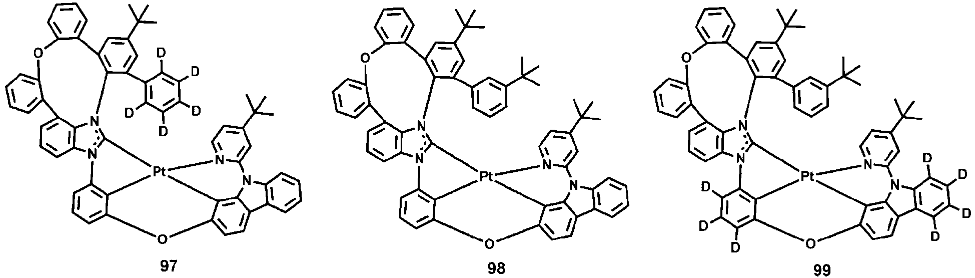

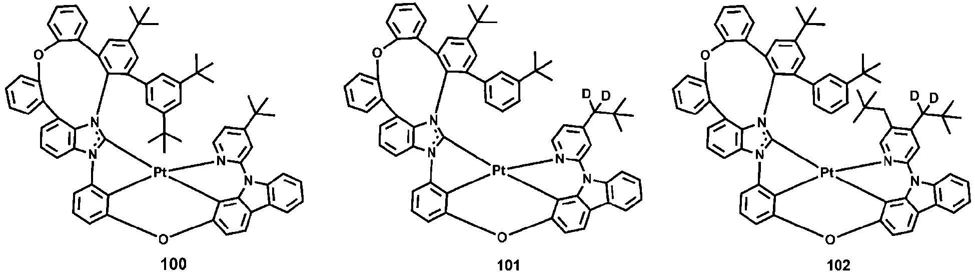

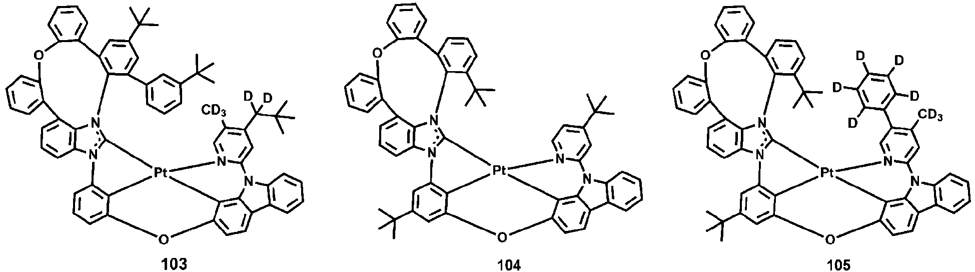

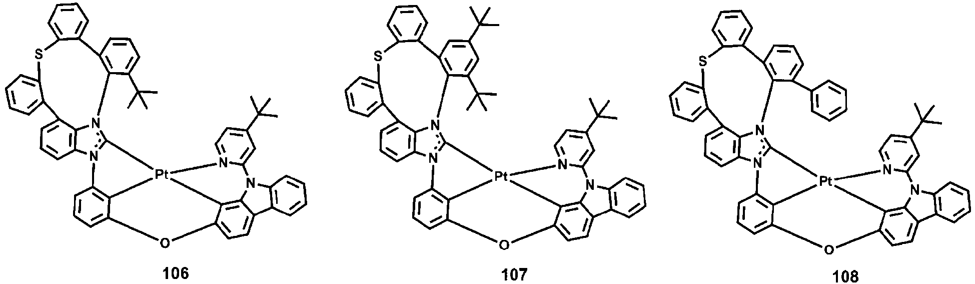

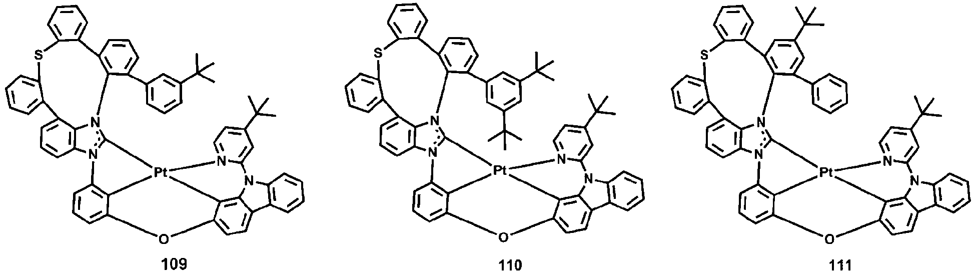

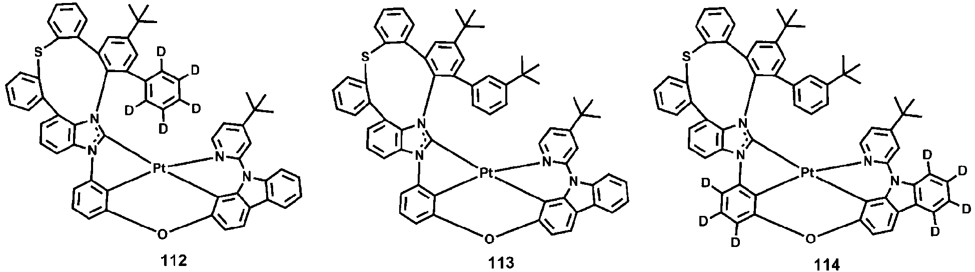

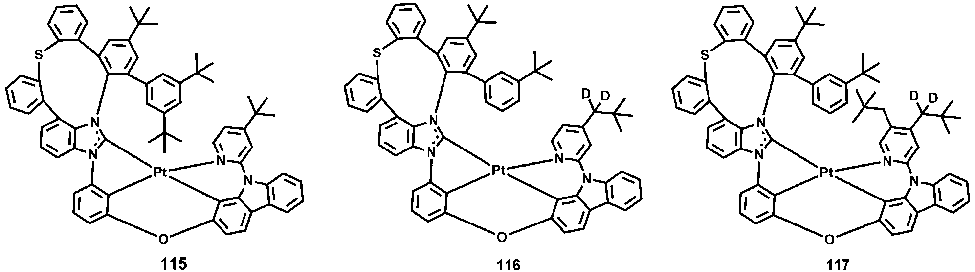

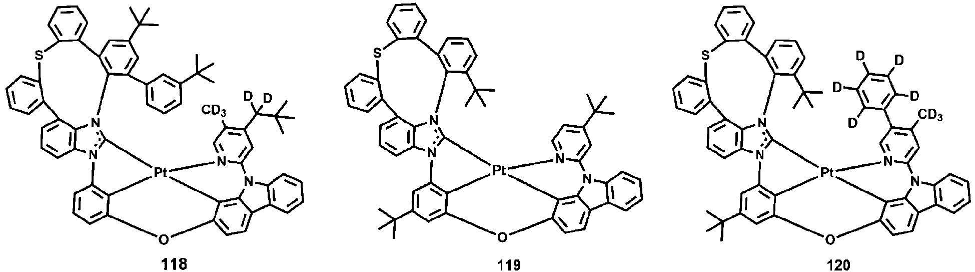

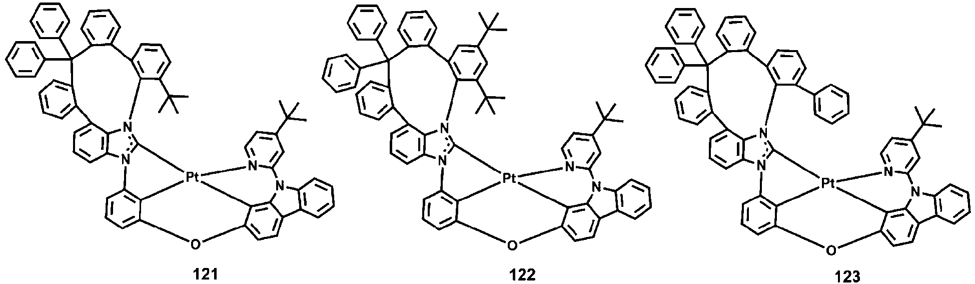

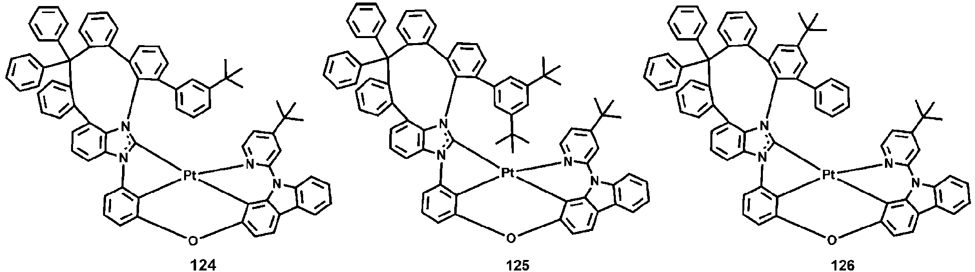

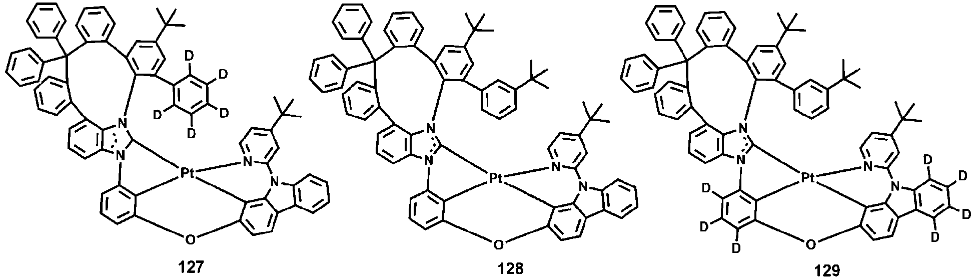

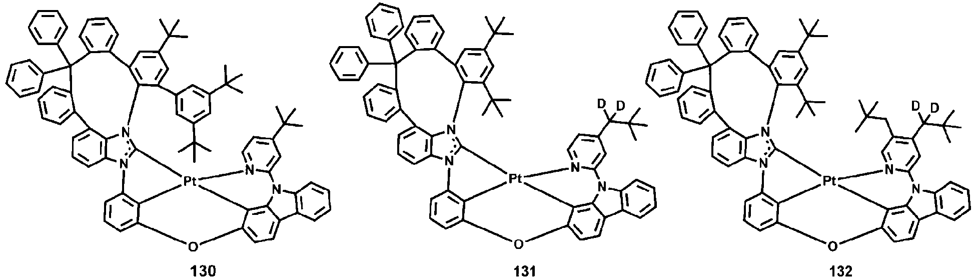

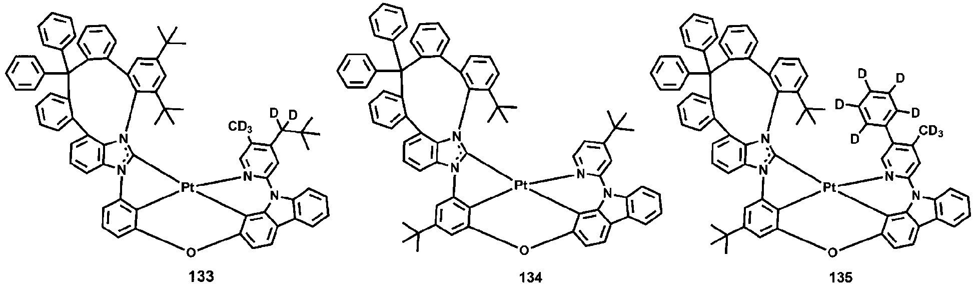

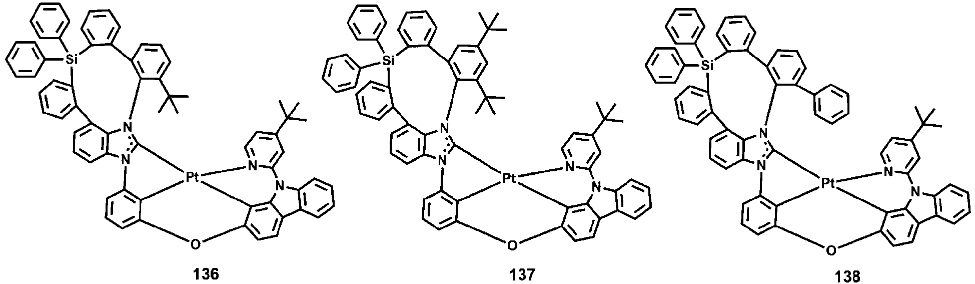

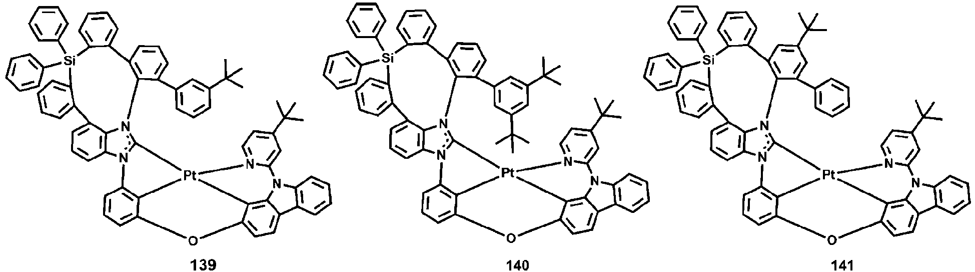

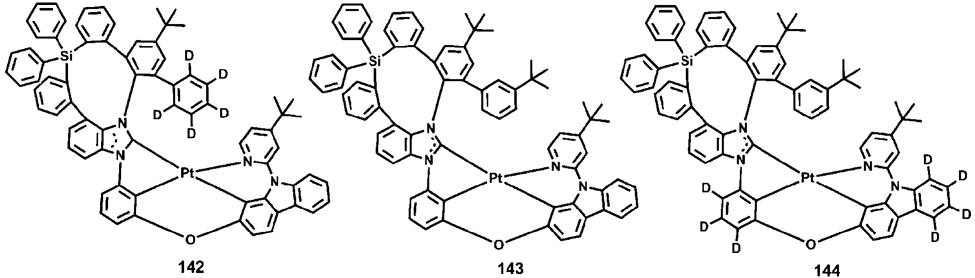

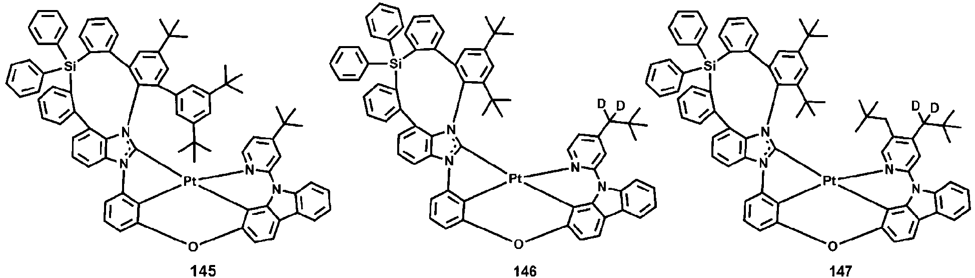

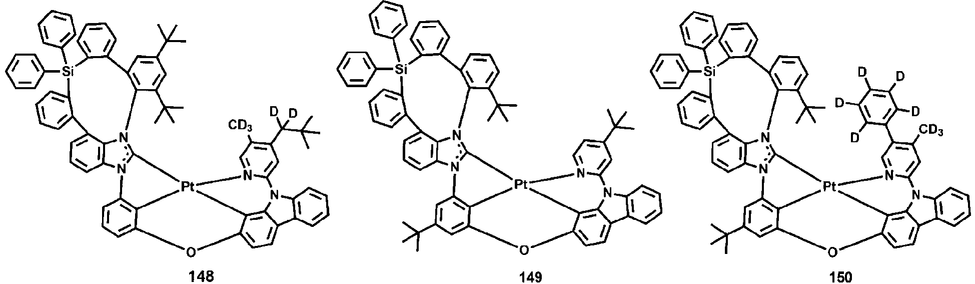

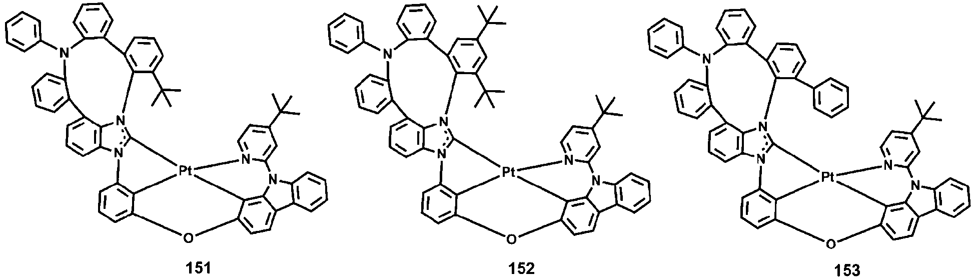

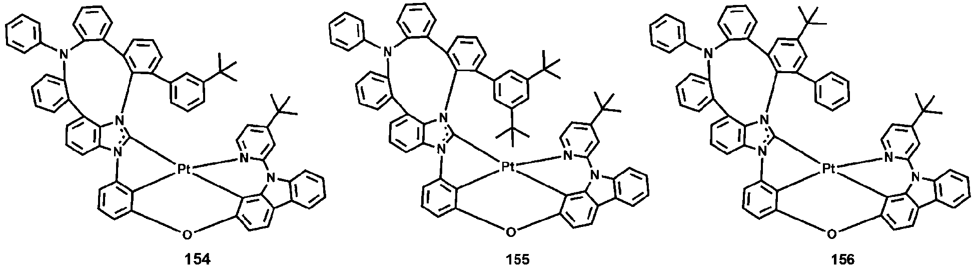

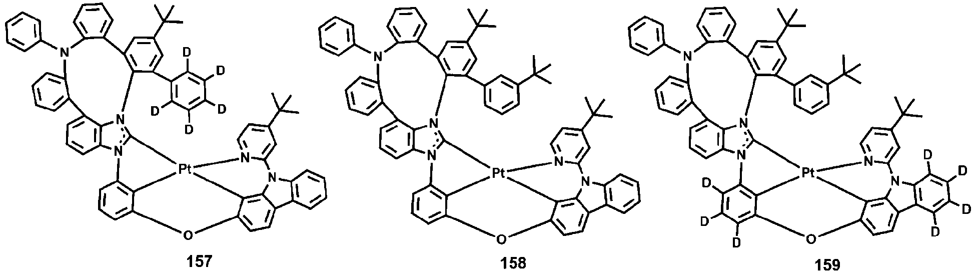

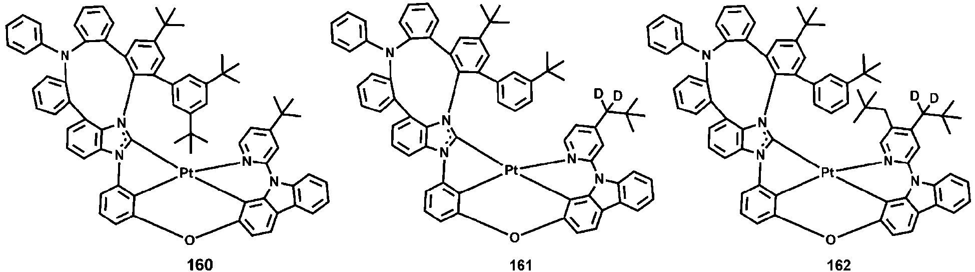

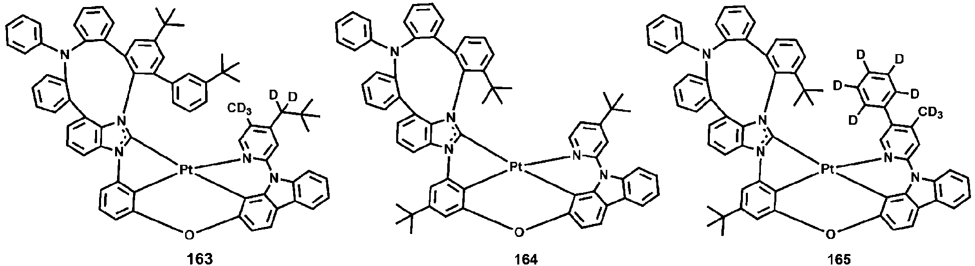

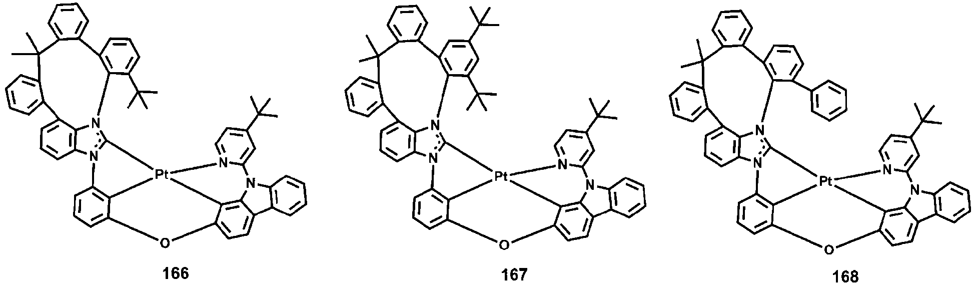

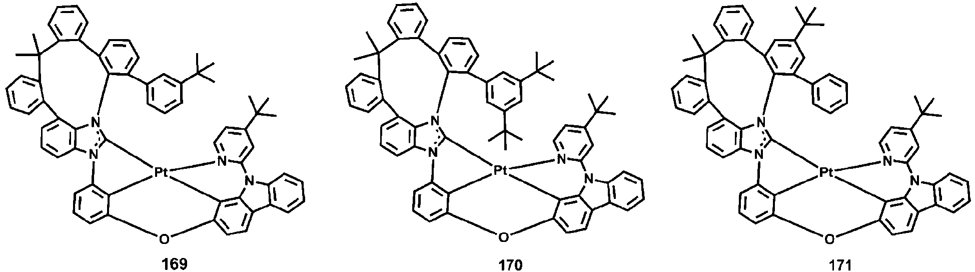

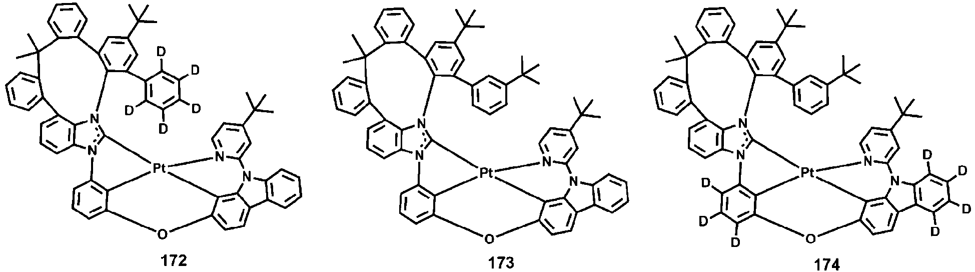

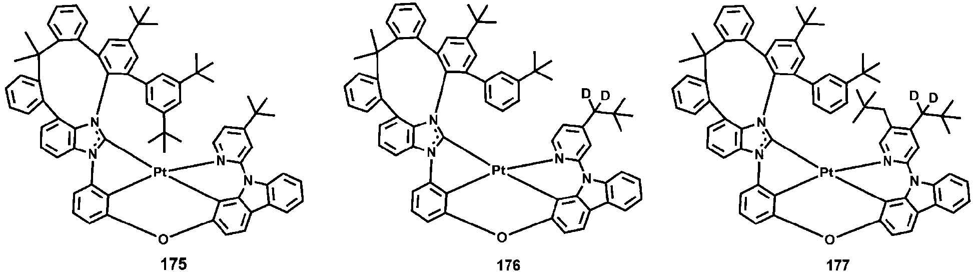

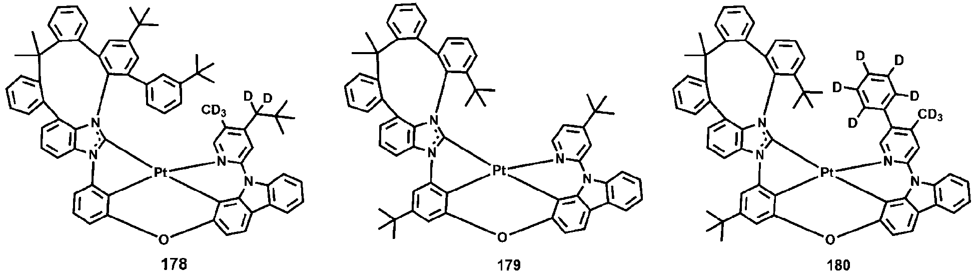

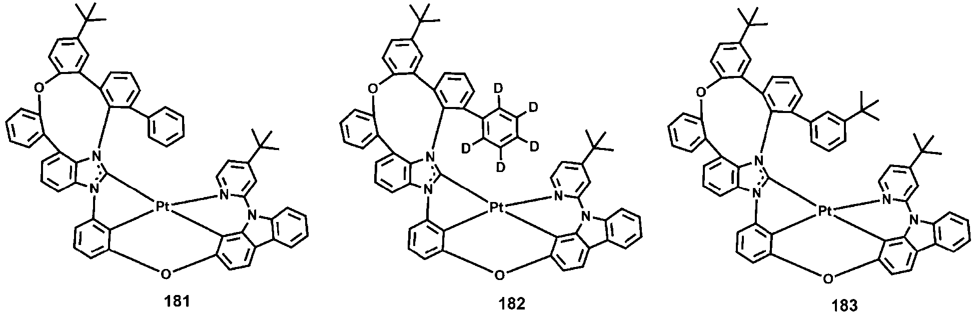

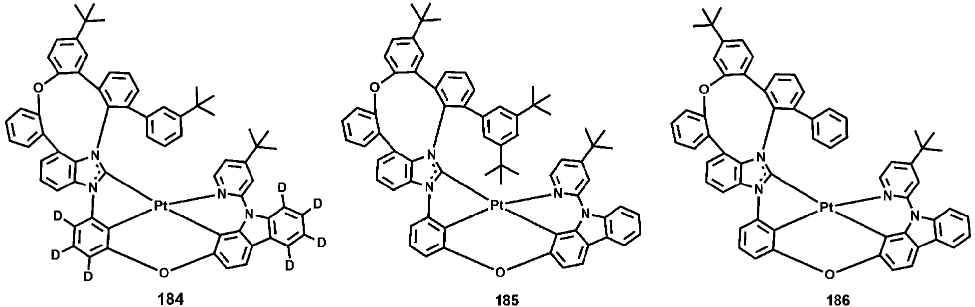

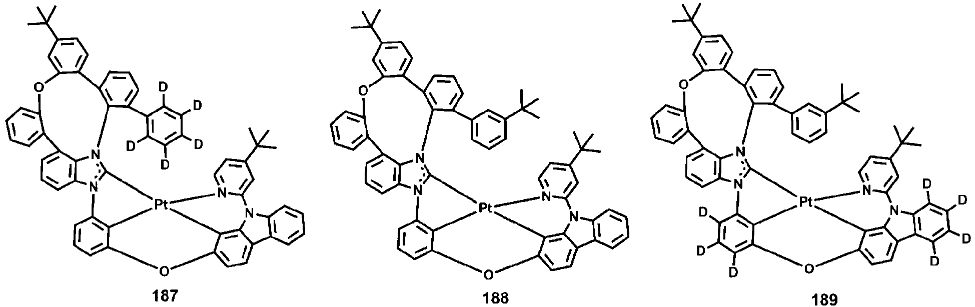

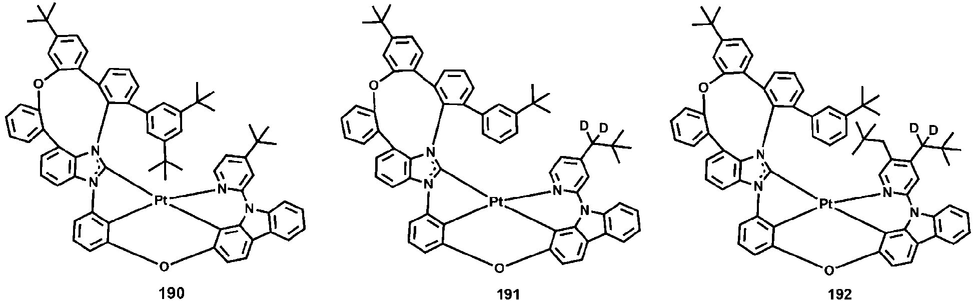

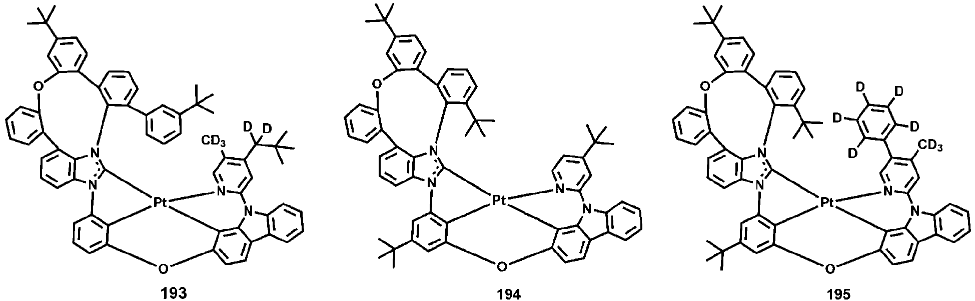

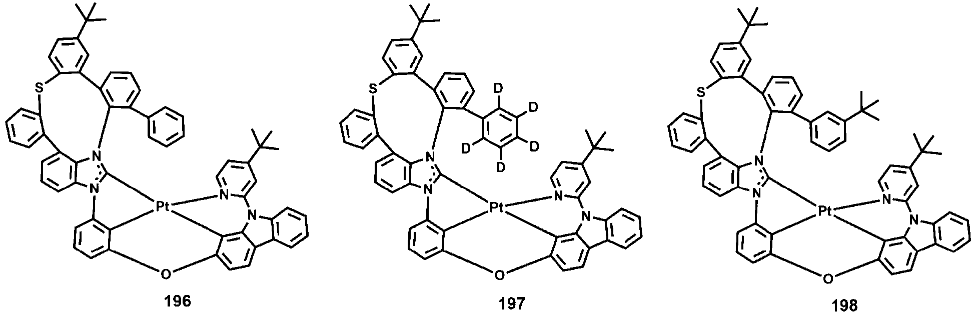

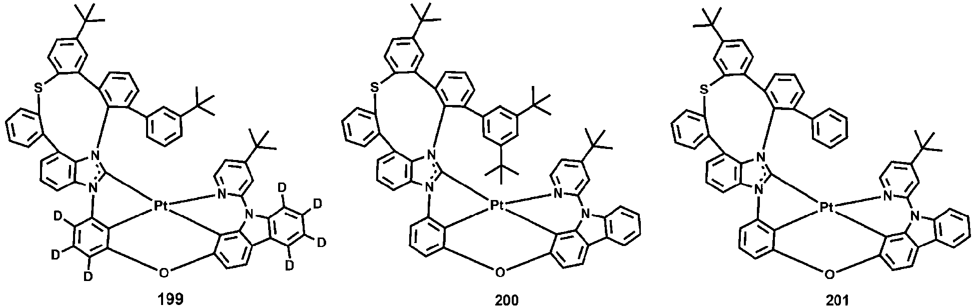

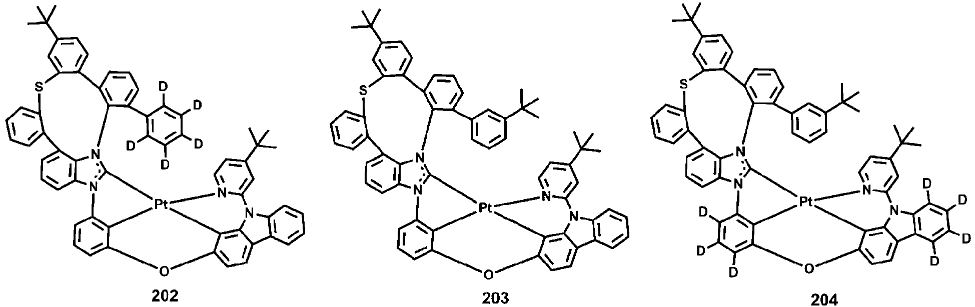

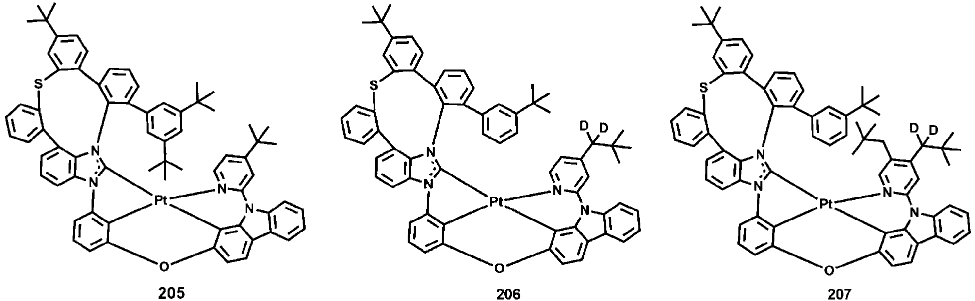

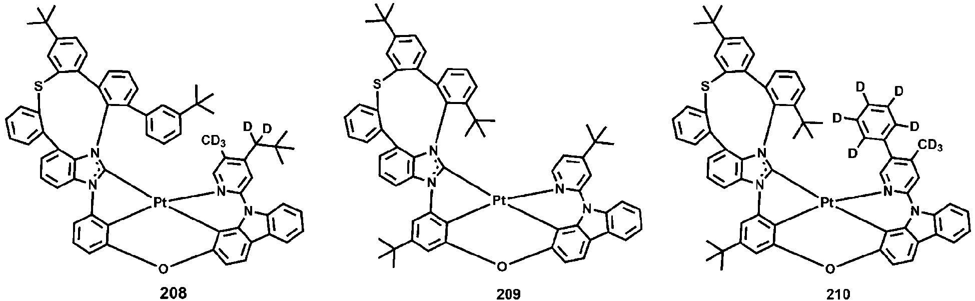

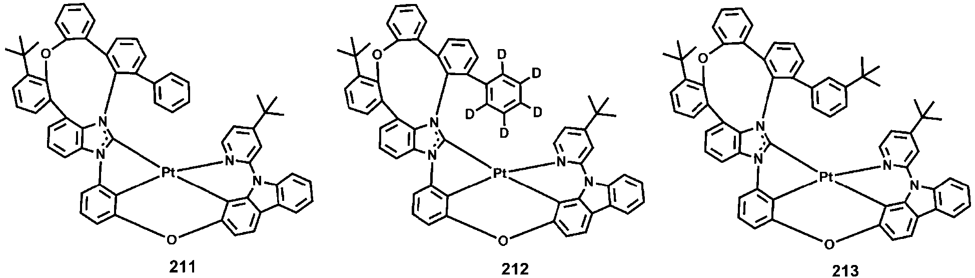

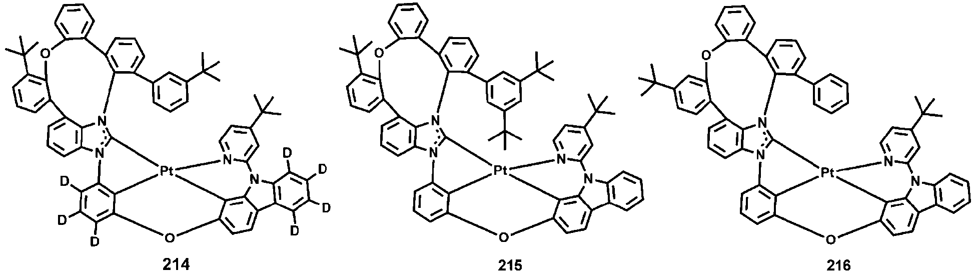

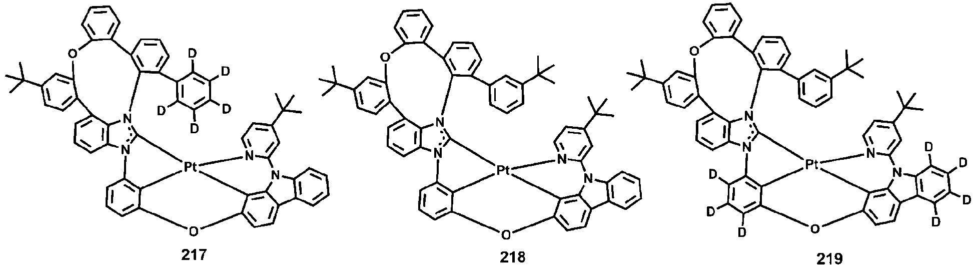

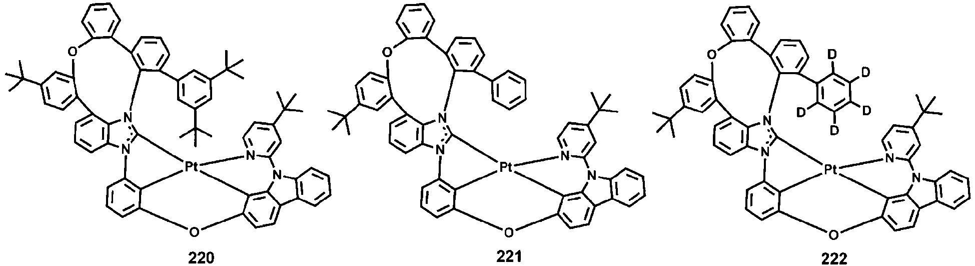

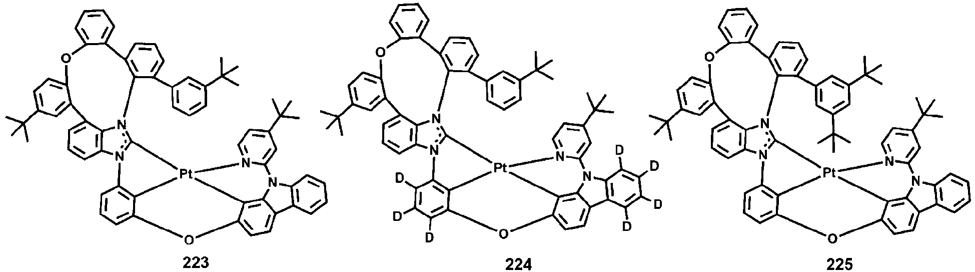

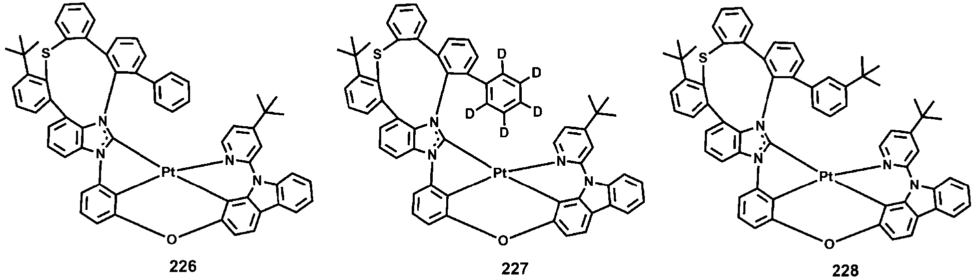

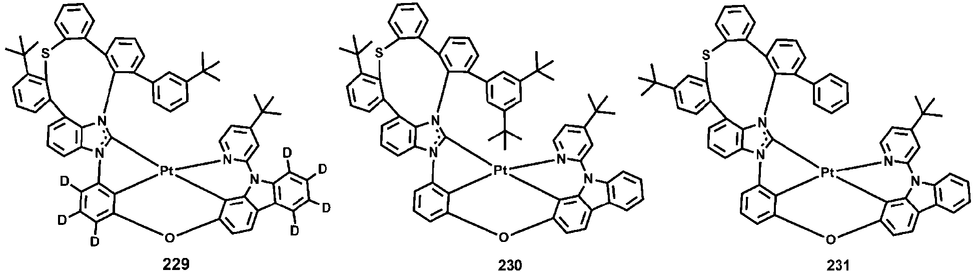

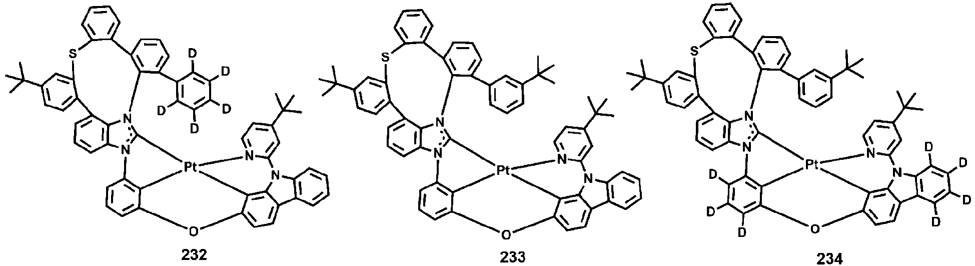

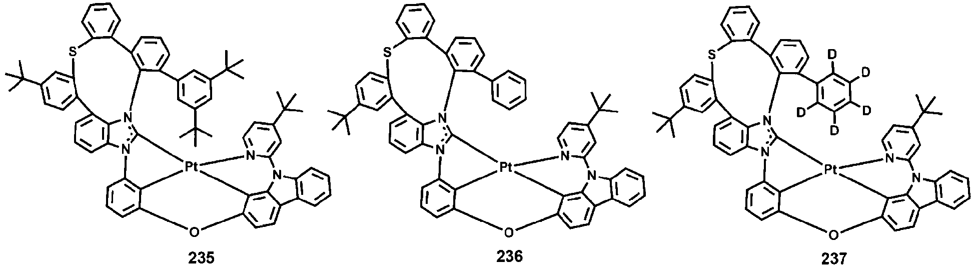

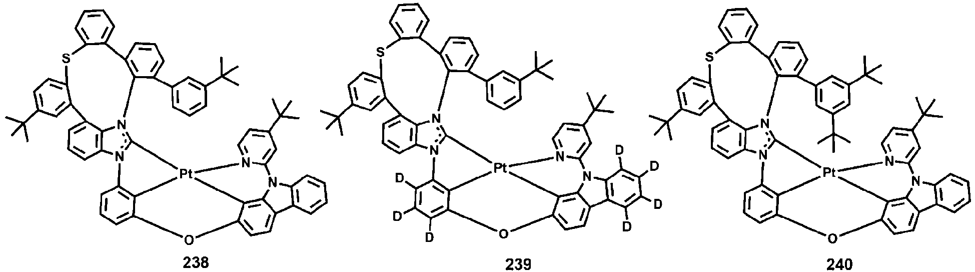

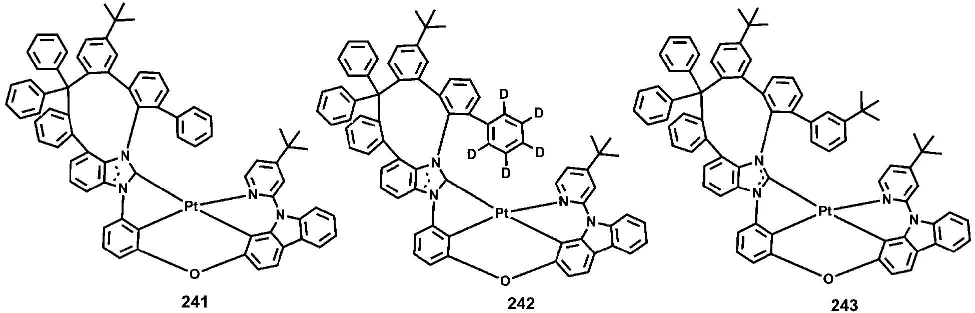

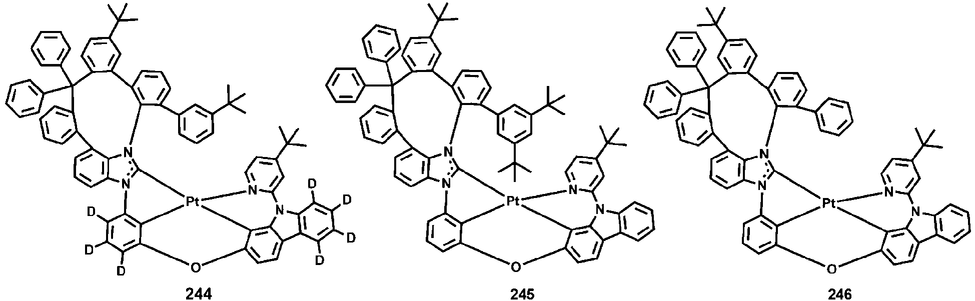

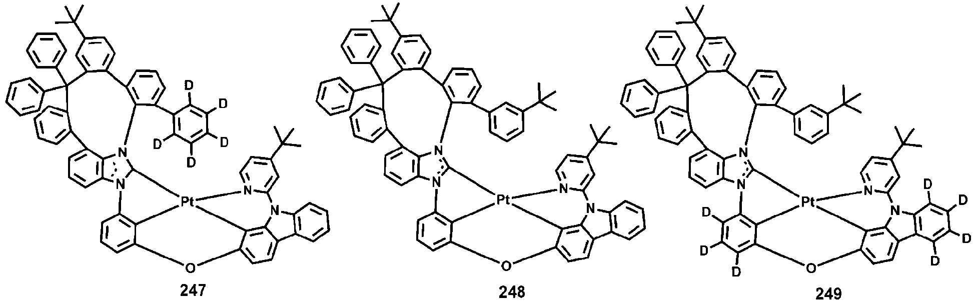

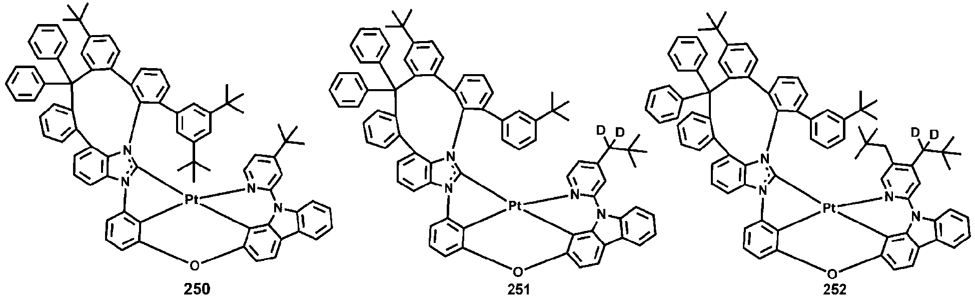

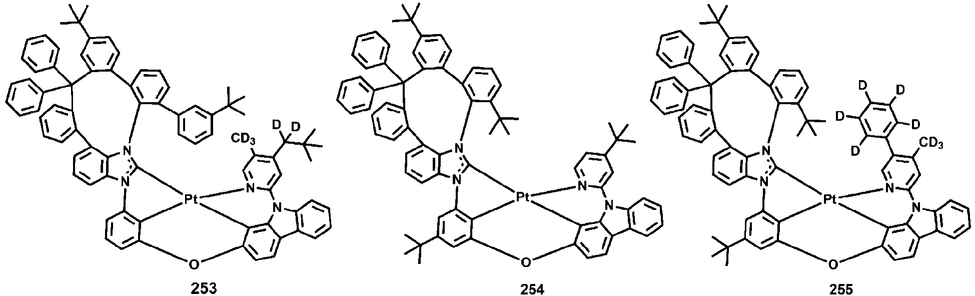

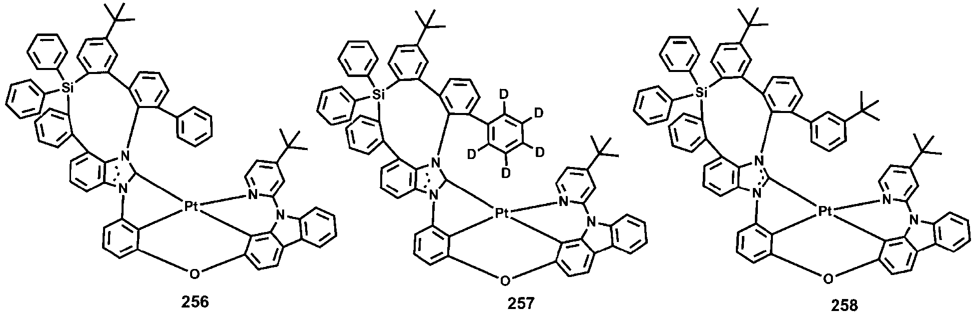

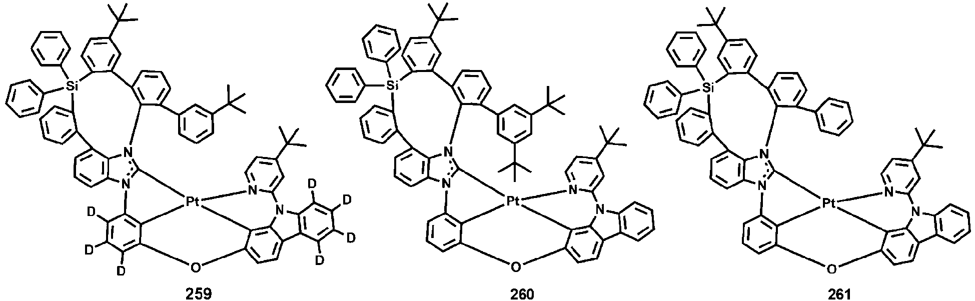

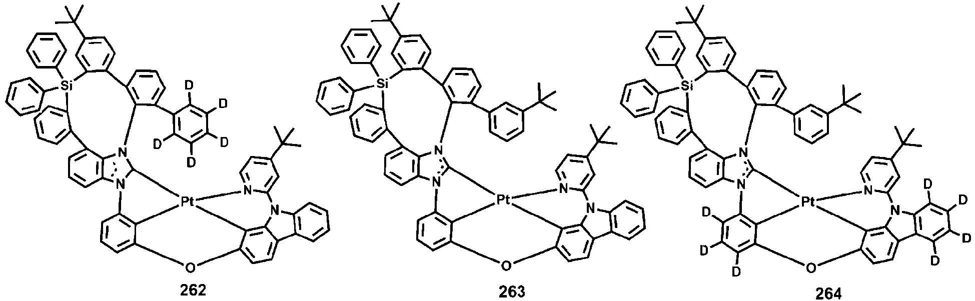

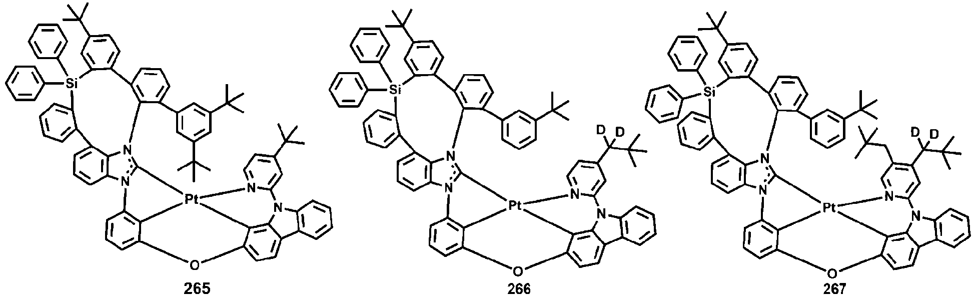

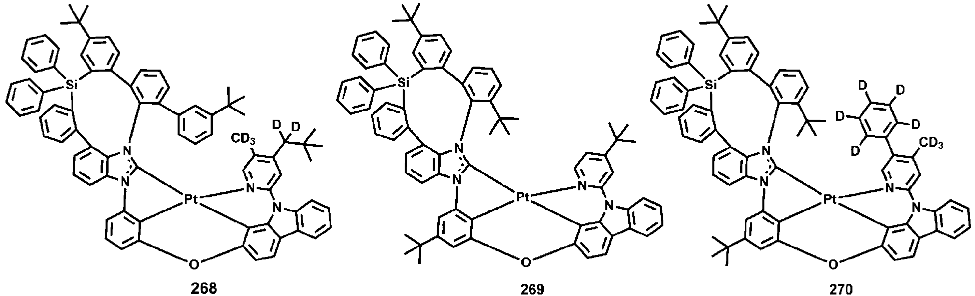

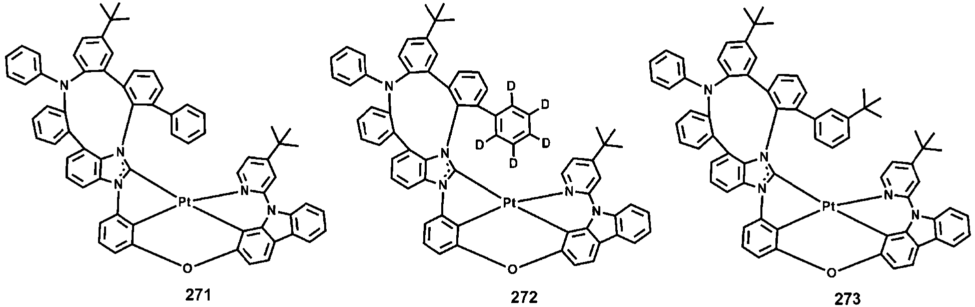

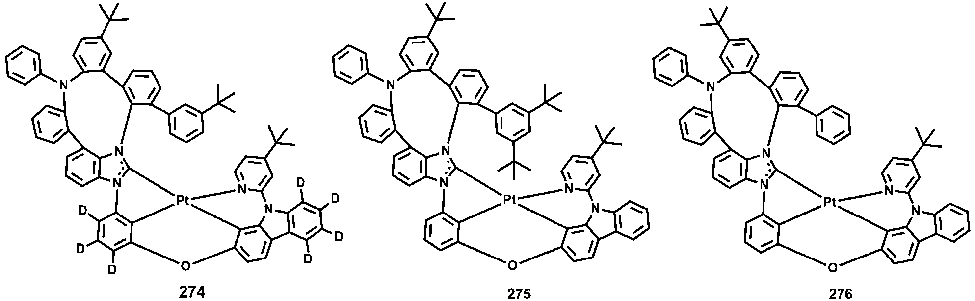

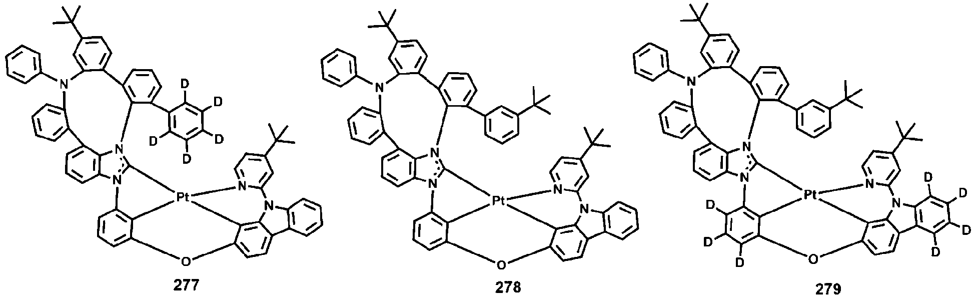

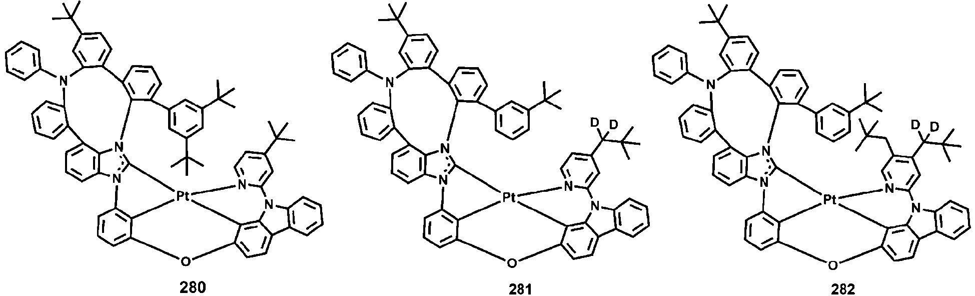

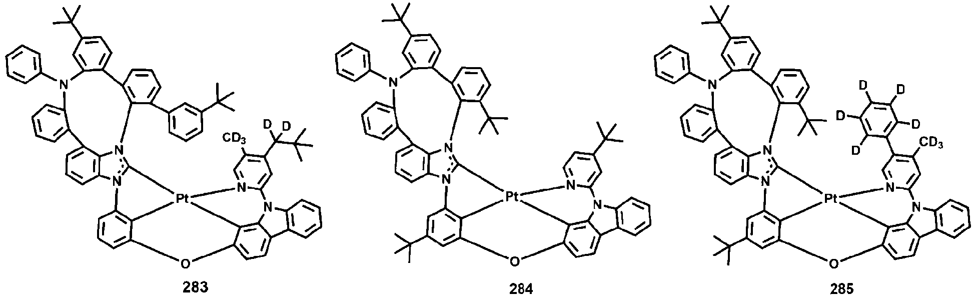

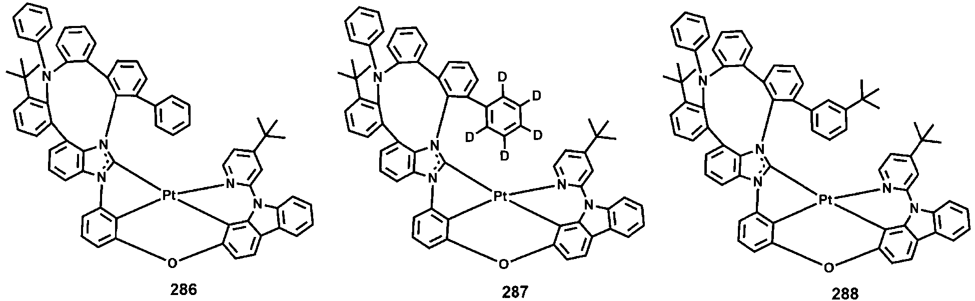

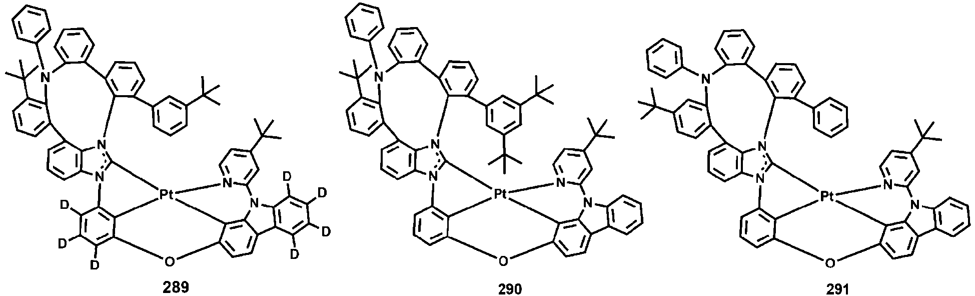

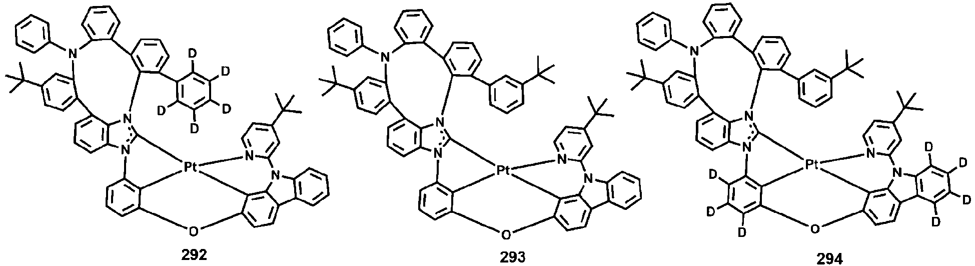

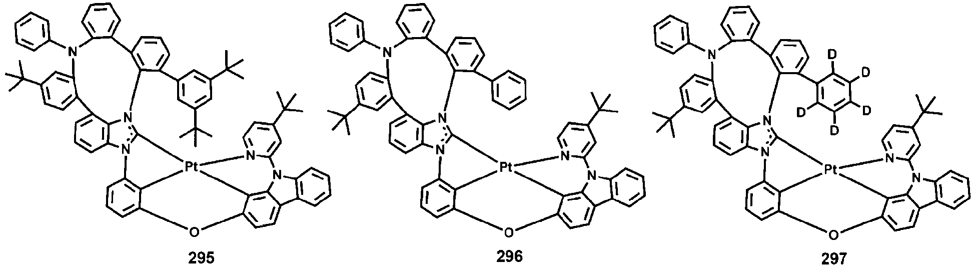

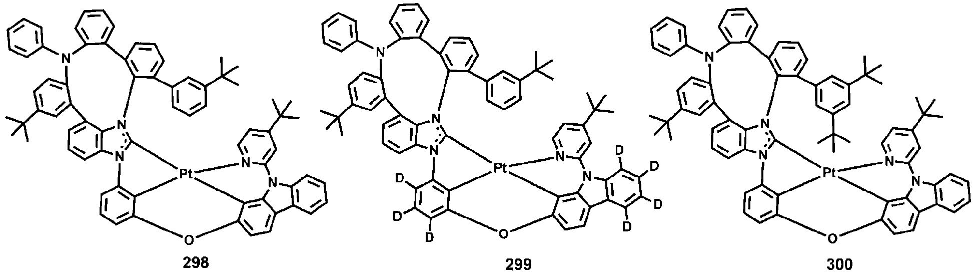

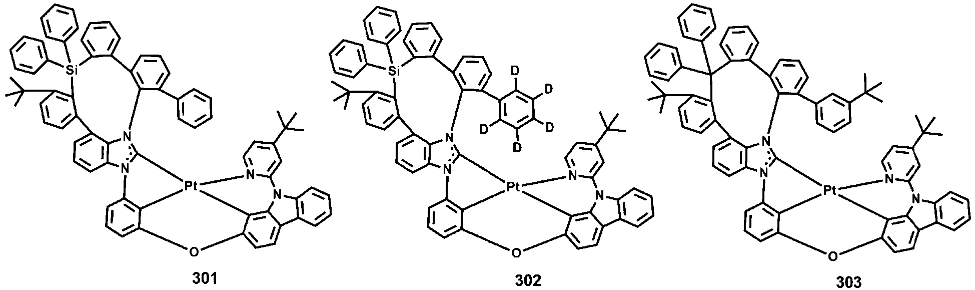

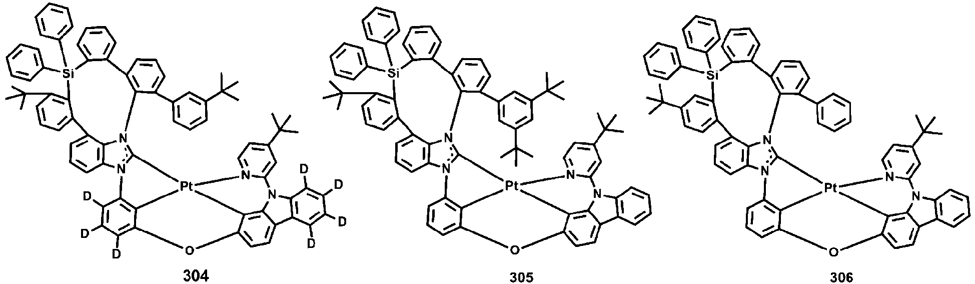

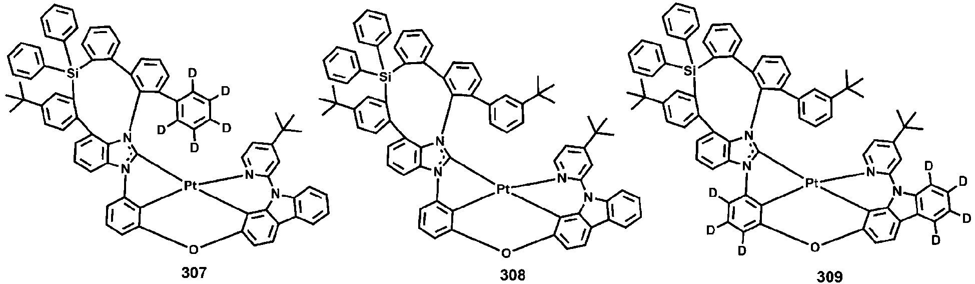

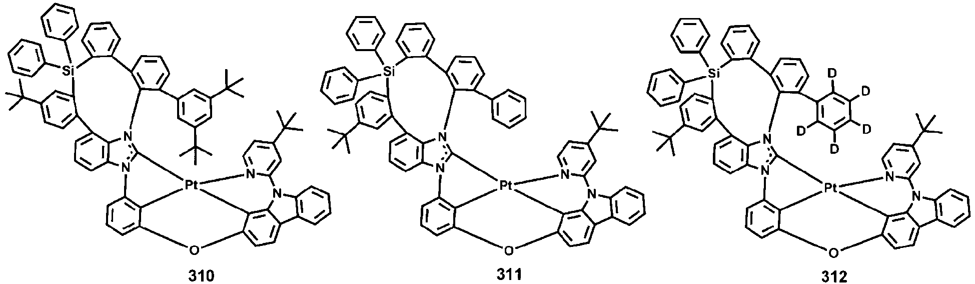

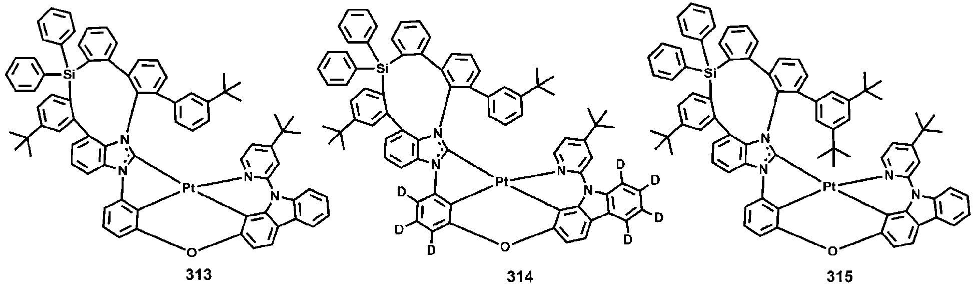

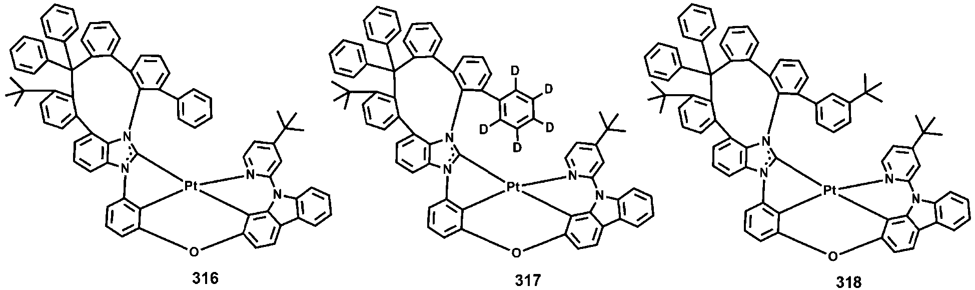

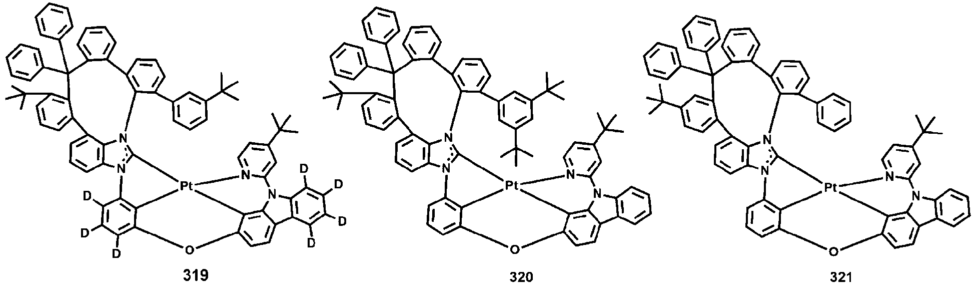

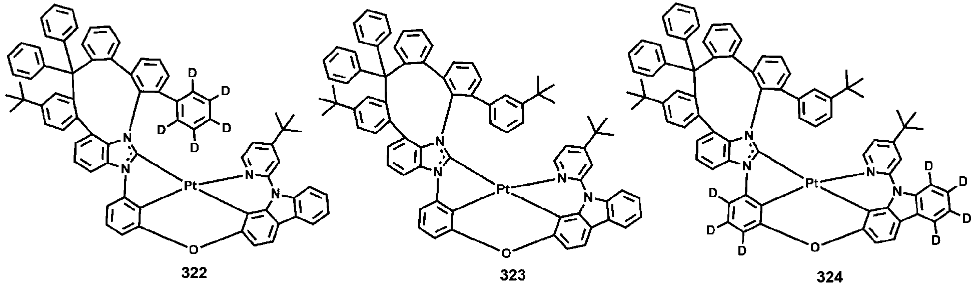

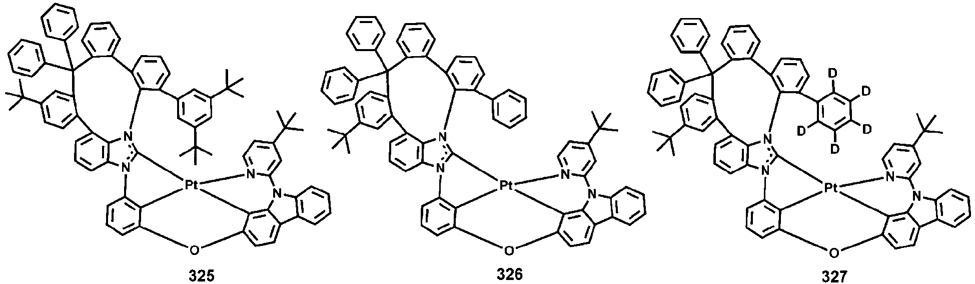

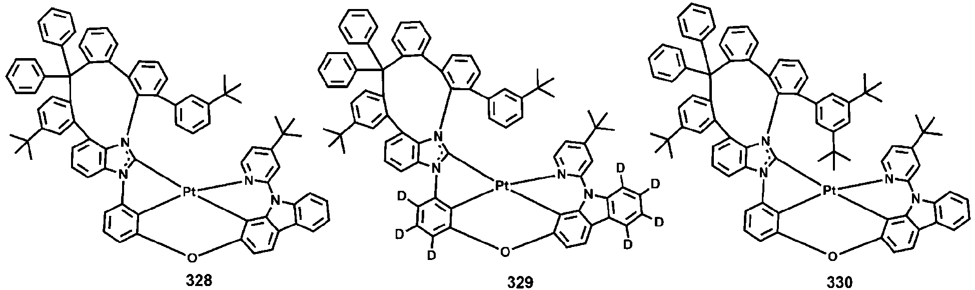

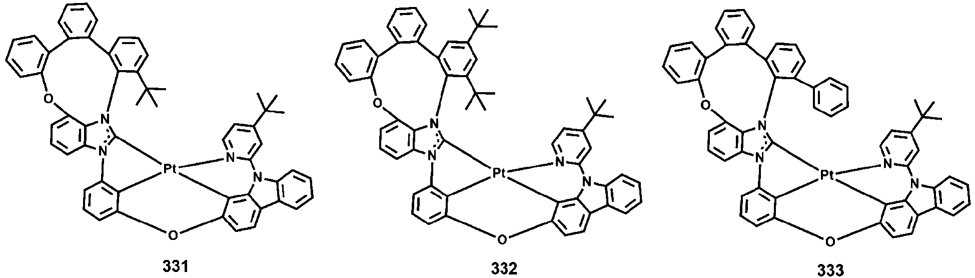

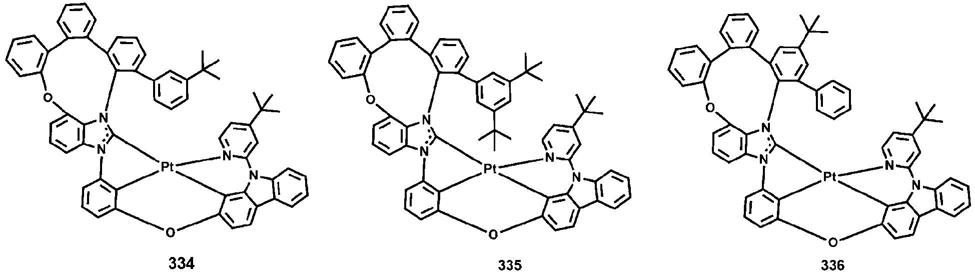

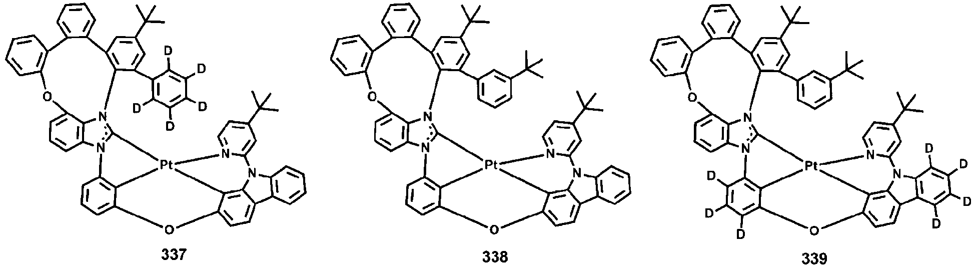

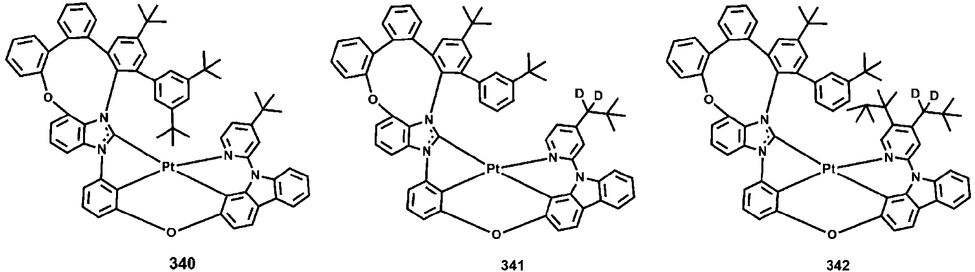

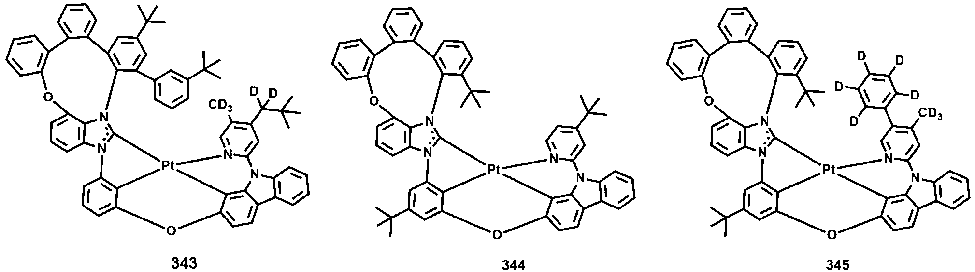

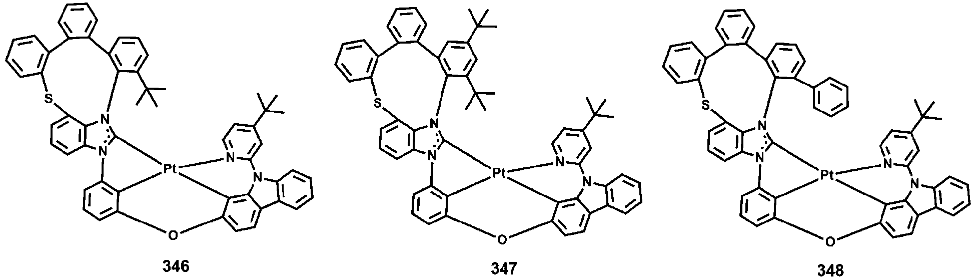

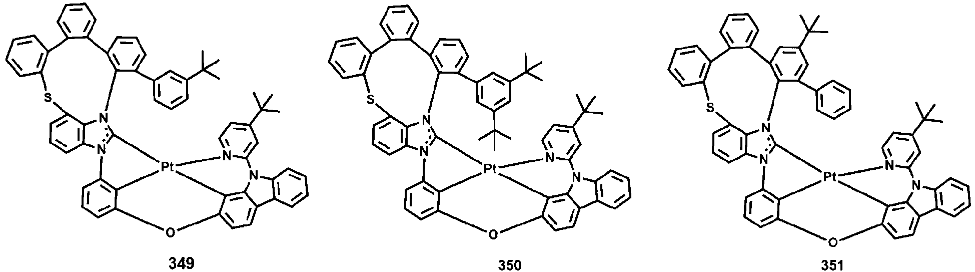

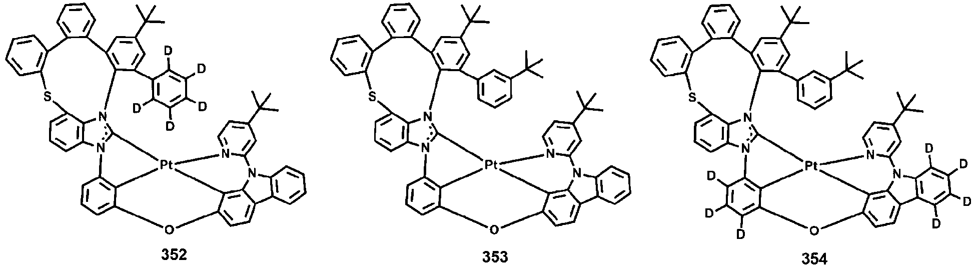

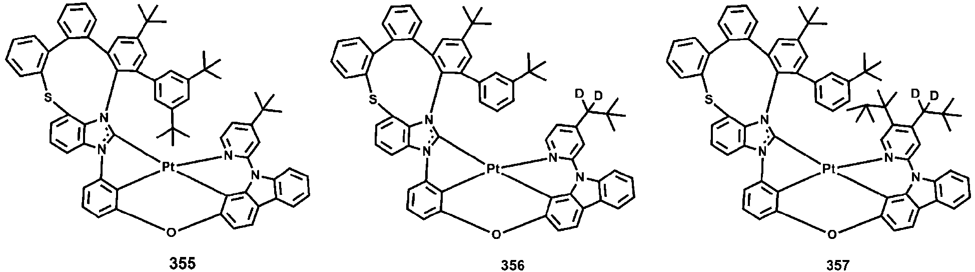

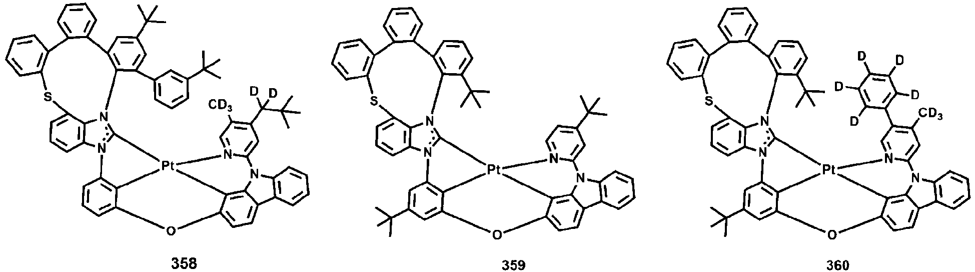

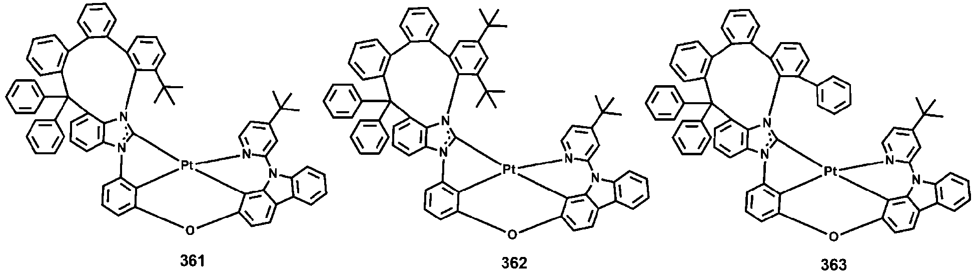

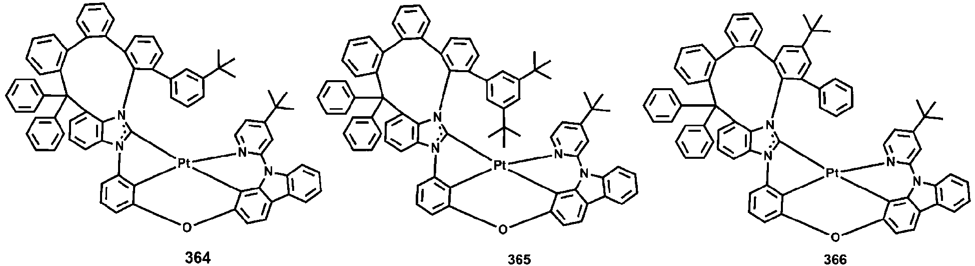

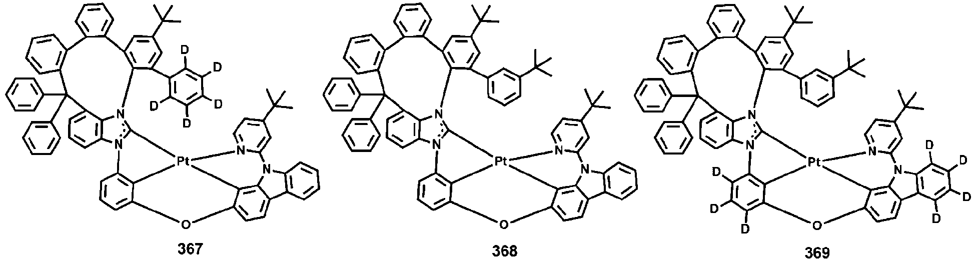

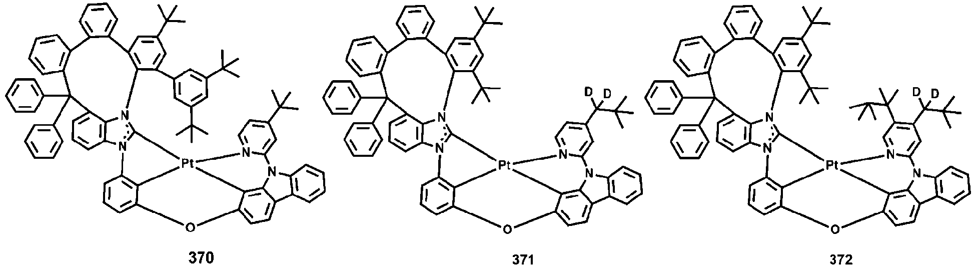

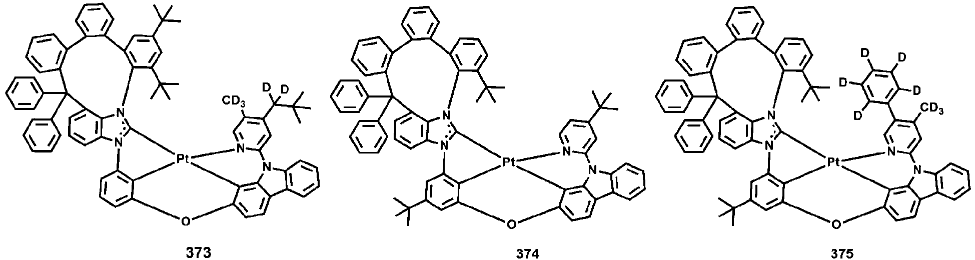

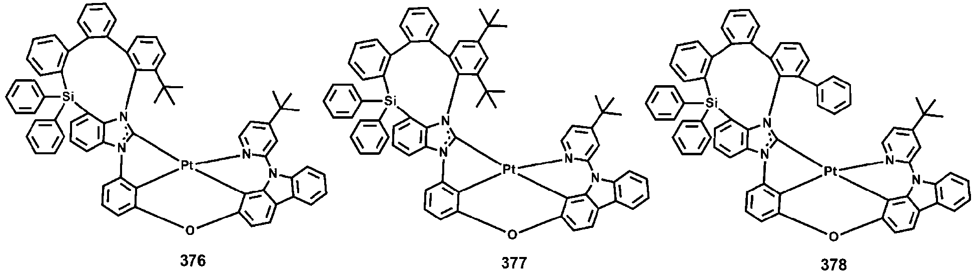

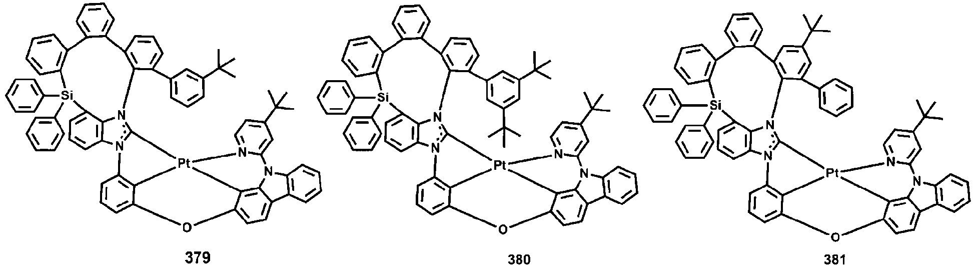

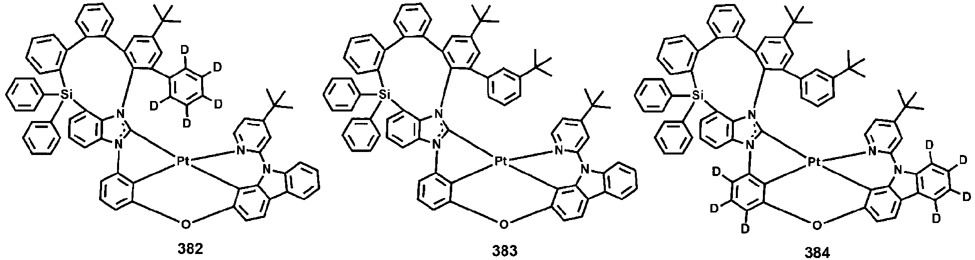

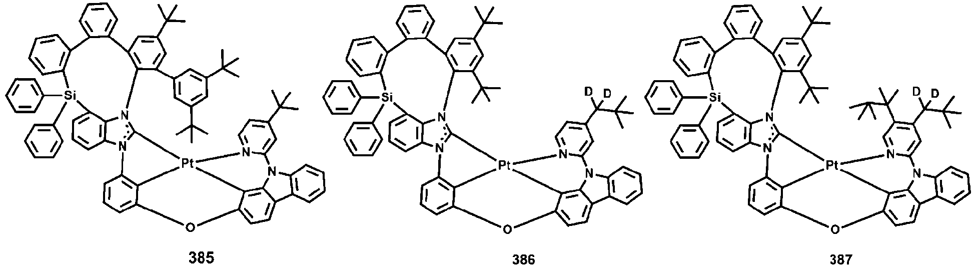

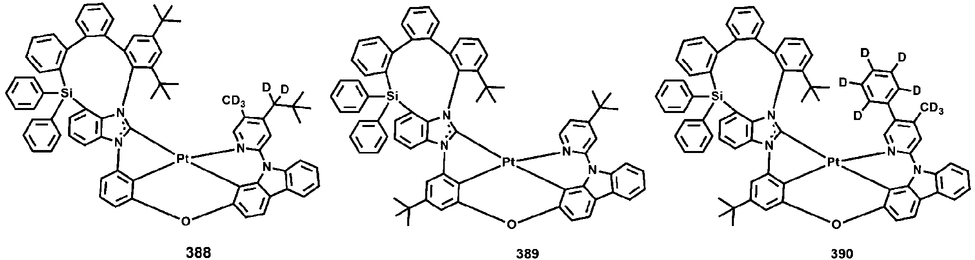

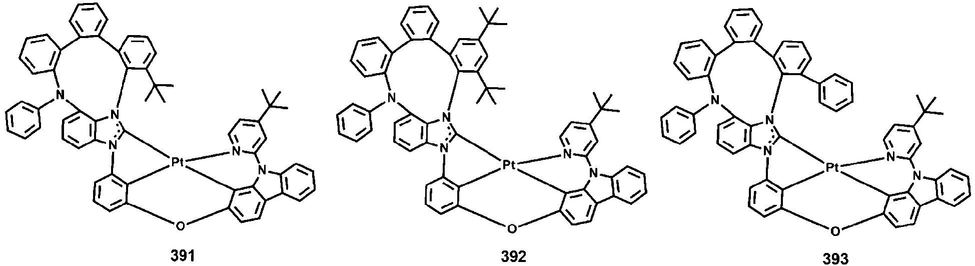

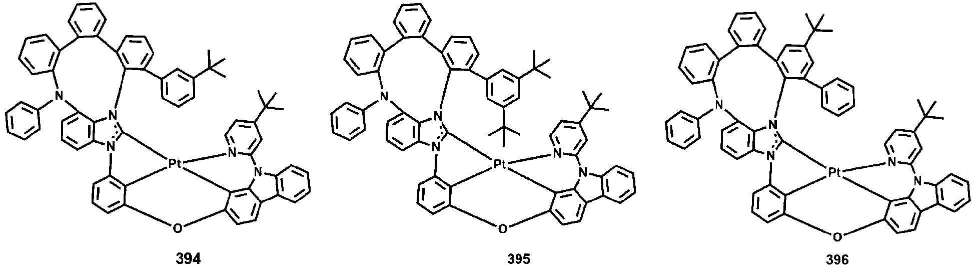

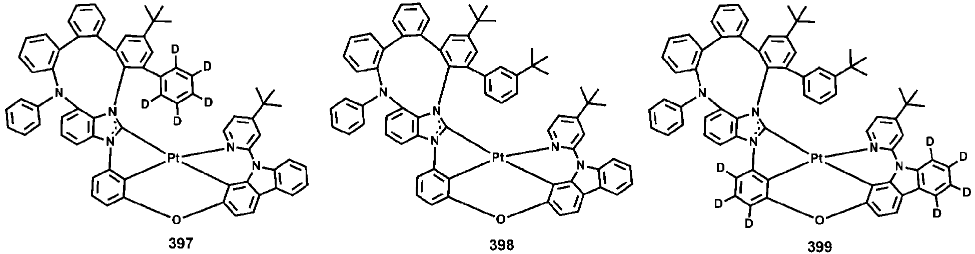

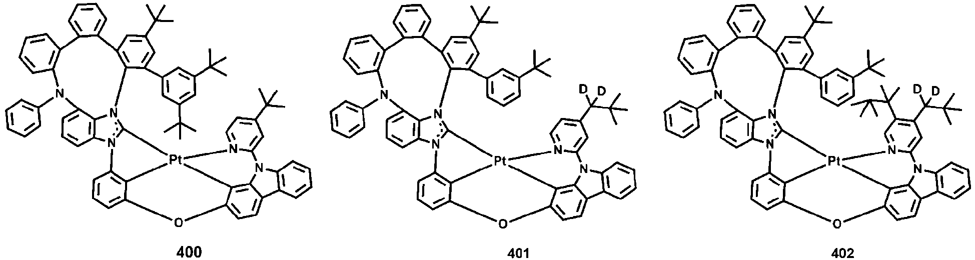

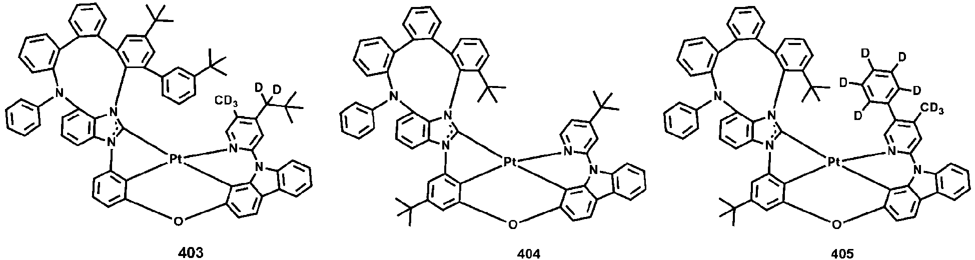

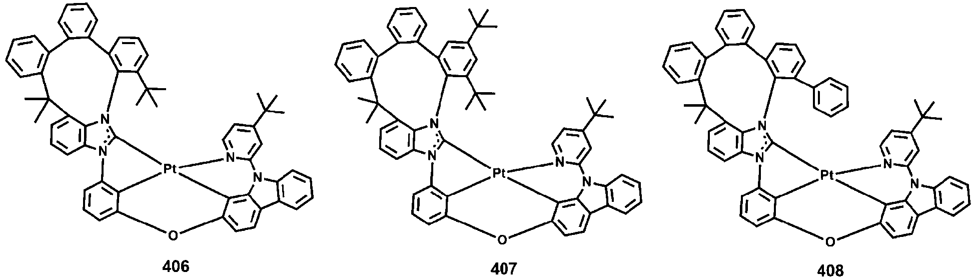

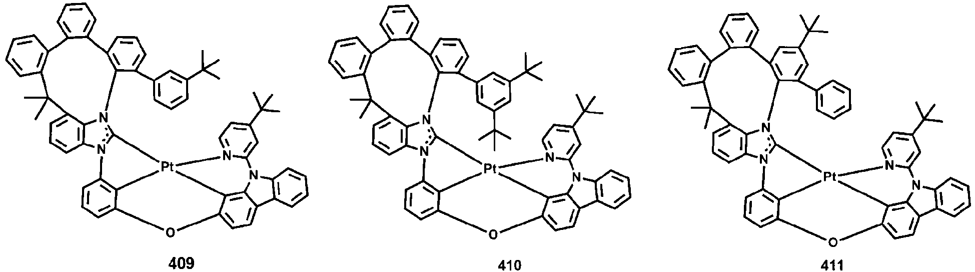

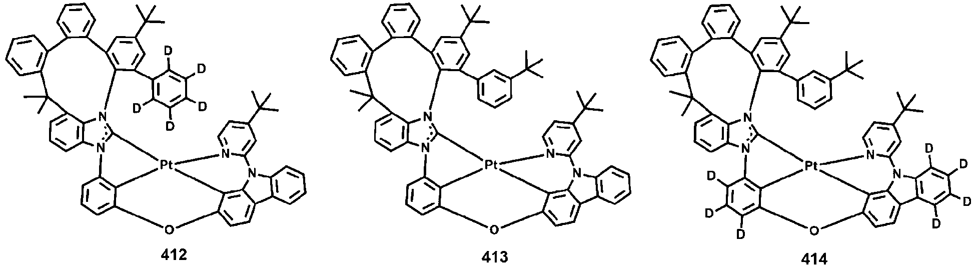

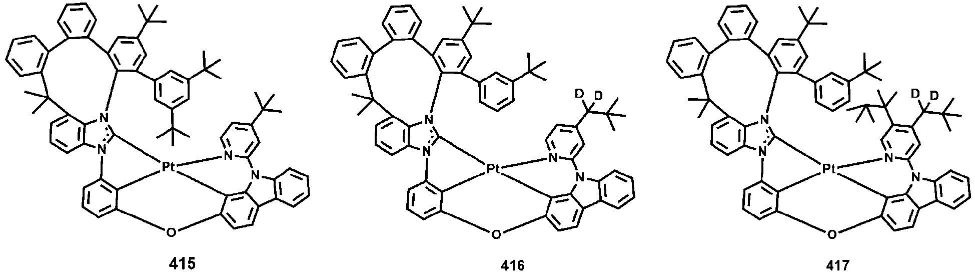

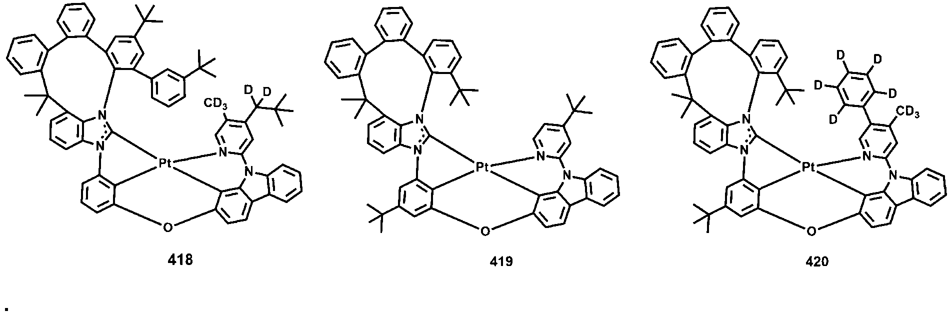

In Formula 1, L₂, L₃, and L₄ are each independently a single bond, O, S, Se, N(R'), C(R')(R"), or Si(R')(R"), wherein at least one of L₂, L₃, and L₄ is O, S, Se, N(R'), C(R')(R"), or Si(R')(R"). That is, a 10-membered ring, an 11-membered ring, or a 12-membered ring may be condensed to an X₁-containing benzimidazole ring in Formula 1 while sharing a nitrogen atom adjacent to X₁ (see Formula 1", below). As such, due to the 10-membered ring, the 11-membered ring, or the 12-membered ring that is condensed to the X₁-containing benzimidazole ring while sharing the nitrogen atom adjacent to X₁, M, which is the central metal of Formula 1, may be effectively shielded, and X₁, which is a carbene moiety, may be stabilized, thereby improving the stability and rigidity of Formula 1. In addition, the electron-donating characteristics of the organometallic compound represented by Formula 1 may be improved, thereby improving the luminescence efficiency of the organometallic compound represented by Formula 1.

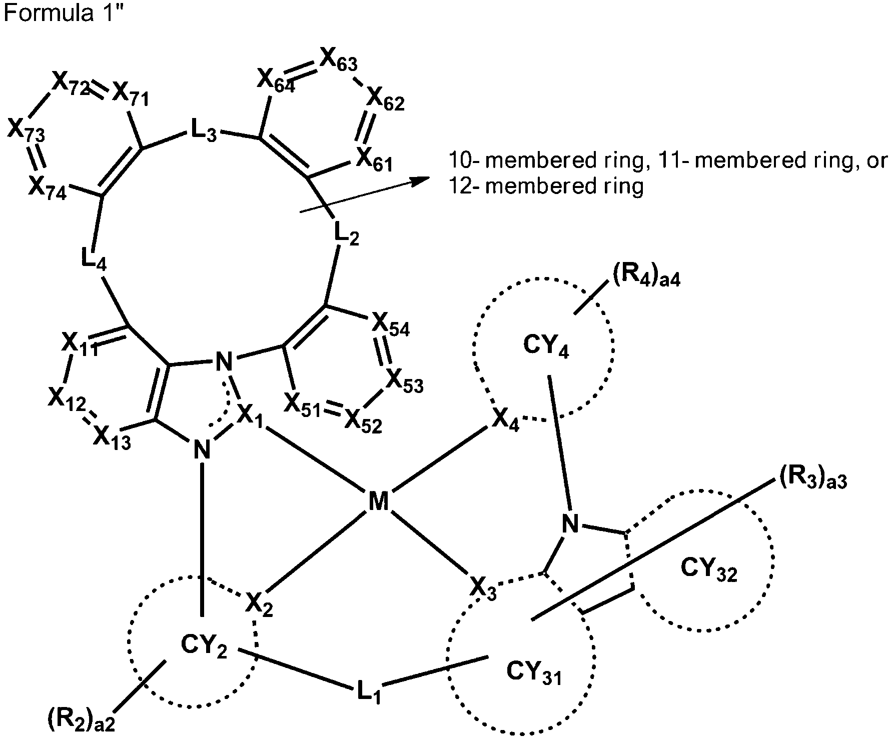

Furthermore, in Formula 1, i) when L₂ is N(R'), R' is not linked to either of X₅₄ and X₆₁, ii) when L₃ is N(R'), R' is not linked to either of X₆₄ and X₇₁, and iii) when L₄ is N(R'), R' is not linked to either of X₇₄ and X₁₁. That is, for example, Compounds C3 and C4 described below may not be included in Formula 1 described herein. As a result, the structural freedom of the 10-membered ring, the 11-membered ring, or the 12-membered ring that is condensed to the X₁-containing benzimidazole ring in Formula 1 while sharing the nitrogen atom adjacent to X₁ (see Formula 1") may be relatively increased, and the angle of structural distortion caused by the 10-membered ring, the 11-membered ring, or the 12-membered ring (see Formula 1") may be relatively reduced, thereby improving the structural stability of the organometallic compound represented by Formula 1.

A peak wavelength (also referred to as an emission peak wavelength, a maximum emission peak wavelength, or a maximum emission wavelength) of a peak having a maximum emission intensity in an emission spectrum of the organometallic compound represented by Formula 1 may be about 440 nanometers (nm) to about 470 nm, about 445 nm to about 470 nm, about 450 nm to about 470 nm, about 455 nm to about 470 nm, about 460 nm to about 470 nm, about 440 nm to about 465 nm, about 445 nm to about 465 nm, about 450 nm to about 465 nm, about 455 nm to about 465 nm, or about 460 nm to about 465 nm.

A full width at half maximum (FWHM) of an emission spectrum of the organometallic compound represented by Formula 1 may be about 5 nm to about 50 nm, about 5 nm to about 40 nm, about 5 nm to about 30 nm, about 5 nm to about 20 nm, about 10 nm to about 50 nm, about 10 nm to about 40 nm, about 10 nm to about 30 nm, about 10 nm to about 20 nm, about 15 nm to about 50 nm, about 15 nm to about 40 nm, about 15 nm to about 30 nm, or about 15 nm to about 24 nm.

A triplet (T₁) energy level of the organometallic compound represented by Formula 1 may be about 2.00 electron Volts (eV) to about 3.20 eV, about 2.00 eV to about 3.00 eV, about 2.00 eV to about 2.80 eV, about 2.50 eV to about 3.20 eV, about 2.50 eV to about 3.00 eV, or about 2.50 eV to about 2.80 eV.

A highest occupied molecular orbital (HOMO) energy level, a lowest unoccupied molecular orbital (LUMO) energy level, and a T₁ energy level of each of Compounds 5, 8, 10, 49, 50, 53, 66, 68, 78, 81, 95, 96, 125, 140, 155, 190, 280, 334, 335, 340, and 395 were evaluated by density functional theory (DFT) using a Gaussian 09 program with molecular structure optimization obtained at the B3LYP level, and the results thereof are shown in Table 1.

**Table 1**

| Compound No. | HOMO energy level (eV) | LUMO energy level (eV) | T₁ energy level (eV) |
|---|---|---|---|
| 5 | -4.63 | -1.21 | 2.64 |
| 8 | -4.53 | -1.11 | 2.64 |
| 10 | -4.55 | -1.11 | 2.64 |
| 49 | -4.58 | -1.14 | 2.66 |
| 50 | -4.58 | -1.15 | 2.64 |
| 53 | -4.56 | -1.14 | 2.66 |
| 66 | -4.56 | -1.13 | 2.64 |
| 68 | -4.57 | -1.13 | 2.64 |
| 78 | -4.63 | -1.16 | 2.68 |
| 81 | -4.62 | -1.17 | 2.68 |
| 95 | -4.64 | -1.20 | 2.64 |
| 96 | -4.62 | -1.20 | 2.67 |
| 125 | -4.59 | -1.13 | 2.67 |
| 140 | -4.66 | -1.20 | 2.67 |
| 155 | -4.64 | -1.19 | 2.64 |
| 190 | -4.64 | -1.19 | 2.64 |
| 280 | -4.65 | -1.18 | 2.65 |
| 334 | -4.61 | -1.17 | 2.65 |
| 335 | -4.60 | -1.17 | 2.64 |
| 340 | -4.59 | -1.17 | 2.65 |
| 395 | -4.61 | -1.20 | 2.61 |

A synthesis method of each of the organometallic compounds represented by Formula 1 may be recognizable by one of ordinary skill in the art and by referring to Synthesis Examples provided below.

Accordingly, each of the organometallic compounds represented by Formula 1 may be suitable for use as a material for an interlayer of a light-emitting device, for example, a material for an emission layer of the interlayer. Thus, another aspect provides a light-emitting device including a first electrode; a second electrode; and an interlayer arranged between the first electrode and the second electrode, wherein the interlayer includes an emission layer, and wherein the interlayer further includes at least one organometallic compound represented by Formula 1.

Since the light-emitting device has an interlayer including at least one organometallic compound represented by Formula 1 as described herein, the light-emitting device may have an excellent driving voltage, an excellent external quantum efficiency, and a relatively narrow FWHM of an emission peak of an electroluminescence (EL) spectrum.

The organometallic compound represented by Formula 1 may be used between a pair of electrodes of the light-emitting device. For example, the organometallic compound represented by Formula 1 may be included in the emission layer. In this regard, the emission layer may further include a host. An amount (e.g., a weight) of the host may be greater than an amount (e.g., a weight) of the at least one organometallic compound represented by Formula 1 in the emission layer. The emission layer may emit a red light, a green light, and/or a blue light. For example, the organometallic compound represented by Formula 1 may emit a blue light.

In one or more embodiments, a CIEy value of light emitted from the emission layer may be about 0.040 to about 0.170, about 0.050 to about 0.170, about 0.060 to about 0.170, about 0.040 to about 0.165, about 0.050 to about 0.165, or about 0.060 to about 0.165.

In one or more embodiments, a CIEy value of light emitted from the emission layer including the at least one organometallic compound represented by Formula 1 as an emitter may be about 0.130 to about 0.170, about 0.135 to about 0.170, about 0.140 to about 0.170, about 0.130 to about 0.165, about 0.135 to about 0.165, about 0.140 to about 0.165, about 0.130 to about 0.160, about 0.135 to about 0.160, or about 0.140 to about 0.160.

In one or more embodiments, a CIEy value of light emitted from the emission layer including the at least one organometallic compound represented by Formula 1 as a sensitizer may be about 0.070 to about 0.140, about 0.080 to about 0.140, about 0.090 to about 0.140, about 0.070 to about 0.135, about 0.080 to about 0.135, about 0.090 to about 0.135, about 0.100 to about 0.135, about 0.110 to about 0.135, about 0.120 to about 0.135, or about 0.125 to about 0.135.

In one or more embodiments, a maximum emission wavelength of light emitted from the emission layer may be about 440 nm to about 470 nm, about 445 nm to about 470 nm, about 450 nm to about 470 nm, about 455 nm to about 470 nm, about 460 nm to about 470 nm, about 440 nm to about 465 nm, about 445 nm to about 465 nm, about 450 nm to about 465 nm, about 455 nm to about 465 nm, or about 460 nm to about 465 nm.

The emission layer may further include a host. The host may be as described herein.

In one or more embodiments, the emission layer may have a configuration as described in a first embodiment or a second embodiment:

### First Embodiment for Emission Layer

The emission layer may include at least one organometallic compound represented by Formula 1, and the organometallic compound represented by Formula 1 may act as an emitter, for example, a phosphorescent emitter. That is, the organometallic compound represented by Formula 1 may be an emitter. For example, a ratio of a luminescent component emitted from the organometallic compound represented by Formula 1 with respect to all luminescent components of the emission layer may be about 80 % or more, about 85 % or more, about 90 % or more, or about 95 % or more. Light emitted from the organometallic compound represented by Formula 1 may be a blue light. The emission layer may further include, in addition to the at least one organometallic compound represented by Formula 1, a phosphorescent compound, a fluorescent compound, or a combination thereof, each of which is different from the organometallic compound represented by Formula 1. In this regard, the phosphorescent compound and/or the fluorescent compound may act as a sensitizer or as an auxiliary dopant.

### Second Embodiment for Emission Layer

The emission layer may include at least one organometallic compound represented by Formula 1, and the organometallic compound represented by Formula 1 may act as a sensitizer or as an auxiliary dopant. That is, the organometallic compound represented by Formula 1 may be a sensitizer or an auxiliary dopant. The emission layer may further include an emitter that is different from the at least one organometallic compound represented by Formula 1. For example, a ratio of a luminescent component emitted from the emitter with respect to all luminescent components of the emission layer may be about 80 % or more, about 85 % or more, about 90 % or more, or about 95 % or more. Light emitted from the emitter may be a blue light. The emitter may include a phosphorescent compound, a fluorescent compound, or a combination thereof, which is different from the at least one organometallic compound represented by Formula 1.

In the second embodiment of the emission layer, an amount of the emitter may be about 1 part by weight to about 100 parts by weight, about 5 parts by weight to about 50 parts by weight, or about 10 parts by weight to about 20 parts by weight, based on 100 parts by weight of the at least one organometallic compound represented by Formula 1.

In the second embodiment of the emission layer, a total amount of the at least one organometallic compound represented by Formula 1 and the emitter may be about 1 part by weight to 30 parts by weight, about 3 parts by weight to about 20 parts by weight, or about 5 parts by weight to about 15 parts by weight, based on 100 parts by weight of the emission layer.

The fluorescent compound that may be used as an emitter in the second embodiment of the emission layer may not include a transition metal.

In one or more embodiments, the fluorescent compound that may be used as an emitter in the second embodiment of the emission layer may be a fluorescence-emitting material that does not include a cyano group (-CN), a fluoro group (-F), or a combination thereof.

In one or more embodiments, the fluorescent compound that may be used as an emitter in the second embodiment of the emission layer may include a prompt fluorescence compound, a delayed fluorescence compound (e.g., a thermally activated delayed fluorescence compound), or a combination thereof.

In one or more embodiments, the fluorescent compound that may be used as an emitter in the second embodiment of the emission layer may be a condensed ring-containing compound, an amino group-containing compound, a styryl group-containing compound, a boron-containing compound, or a combination thereof.

In one or more embodiments, the fluorescent compound that may be used as an emitter in the second embodiment of the emission layer may be a multi-resonance thermally activated delayed fluorescence compound.

In one or more embodiments, the fluorescent compound that may be used as an emitter in the second embodiment of the emission layer may include i) an amine-containing fluorescent compound, and/or ii) a fluorescent compound containing a condensed polycyclic ring in which a 6-membered ring including nitrogen and boron are condensed with each other.

In one or more embodiments, the fluorescent compound that may be used as an emitter in the second embodiment of the emission layer may include a naphthalene group, a fluorene group, a spiro-bifluorene group, a benzofluorene group, a dibenzofluorene group, a phenanthrene group, an anthracene group, a fluoranthene group, a triphenylene group, a pyrene group, a chrysene group, a naphthacene group (a tetracene group), a picene group, a perylene group, a pentaphene group, an indenoanthracene group, a group represented by one of Formulae 501-1 to 501-21, or a combination thereof:

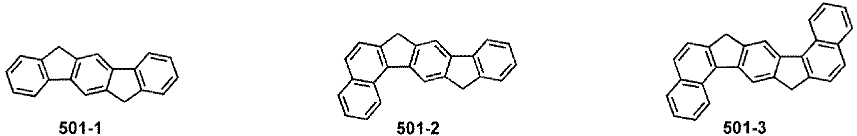

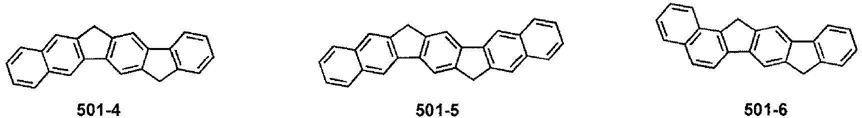

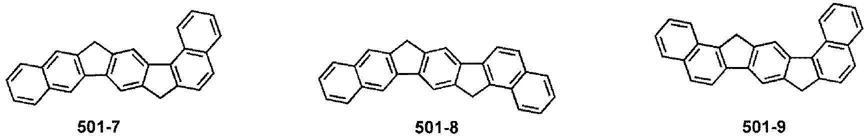

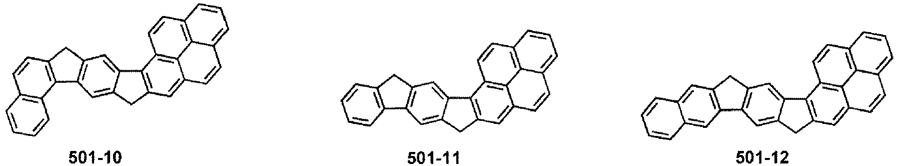

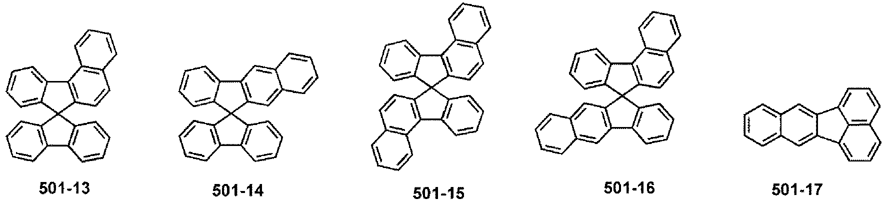

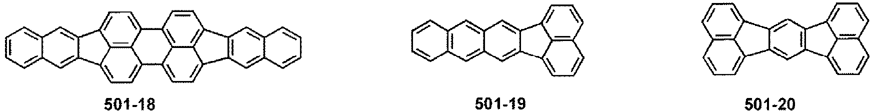

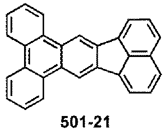

In one or more embodiments, the fluorescent compound that may be used as an emitter in the second embodiment of the emission layer may include a compound represented by Formula 501A or 501B: 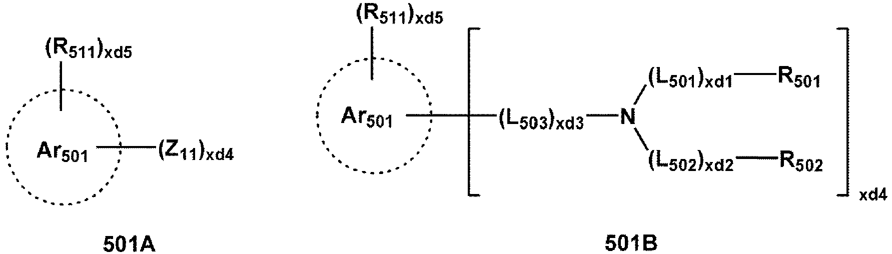 wherein, in Formulae 501A and 501B,
Ar₅₀₁ may be a naphthalene group, a fluorene group, a spiro-bifluorene group, a benzofluorene group, a dibenzofluorene group, a phenanthrene group, an anthracene group, a fluoranthene group, a triphenylene group, a pyrene group, a chrysene group, a naphthacene group, a picene group, a perylene group, a pentaphene group, an indenoanthracene group, a bisanthracene group, or a group represented by one of Formulae 501-1 to 501-21,
R₅₁₁ may be hydrogen, deuterium, -F, -Cl, -Br, -I, -SF₅, a hydroxyl group, a nitro group, an amino group, an amidino group, a hydrazine group, a hydrazone group, a carboxylic acid group or a salt thereof, a sulfonic acid group or a salt thereof, a phosphoric acid group or a salt thereof, a C₁-C₆₀ alkyl group, a C₂-C₆₀ alkenyl group, a C₂-C₆₀ alkynyl group, a C₁-C₆₀ alkoxy group, a C₁-C₆₀ alkylthio group, a C₃-C₁₀ cycloalkyl group, a C₁-C₁₀ heterocycloalkyl group, a C₃-C₁₀ cycloalkenyl group, a C₁-C₁₀ heterocycloalkenyl group, a C₆-C₆₀ aryl group, a C₇-C₆₀ alkyl aryl group, a C₇-C₆₀ aryl alkyl group, a C₆-C₆₀ aryloxy group, a C₆-C₆₀ arylthio group, a C₁-C₆₀ heteroaryl group, a C₂-C₆₀ alkyl heteroaryl group, a C₂-C₆₀ heteroaryl alkyl group, a C₁-C₆₀ heteroaryloxy group, a C₁-C₆₀ heteroarylthio group, a monovalent non-aromatic condensed polycyclic group, a monovalent non-aromatic condensed heteropolycyclic group, **or** -Si(Q₅₀₁)(Q₅₀₂)(Q₅₀₃),
xd5 may be an integer from 0 to 10,
L₅₀₁ to L₅₀₃ may each independently be:
   a single bond; or
   a C₃-C₁₀ cycloalkylene group, a C₁-C₁₀ heterocycloalkylene group, a C₃-C₁₀ cycloalkenylene group, a C₁-C₁₀ heterocycloalkenylene group, a C₆-C₆₀ arylene group, a C₁-C₆₀ heteroarylene group, a divalent non-aromatic condensed polycyclic group, or a divalent non-aromatic condensed heteropolycyclic group, each unsubstituted or substituted with deuterium, -F, - Cl, -Br, -I, -SF₅, a hydroxyl group, a nitro group, an amino group, an amidino group, a hydrazine group, a hydrazone group, a carboxylic acid group or a salt thereof, a sulfonic acid group or a salt thereof, a phosphoric acid group or a salt thereof, a C₁-C₆₀ alkyl group, a C₂-C₆₀ alkenyl group, a C₂-C₆₀ alkynyl group, a C₁-C₆₀ alkoxy group, a C₁-C₆₀ alkylthio group, a C₃-C₁₀ cycloalkyl group, a C₁-C₁₀ heterocycloalkyl group, a C₃-C₁₀ cycloalkenyl group, a C₁-C₁₀ heterocycloalkenyl group, a C₆-C₆₀ aryl group, a C₇-C₆₀ alkyl aryl group, a C₇-C₆₀ aryl alkyl group, a C₆-C₆₀ aryloxy group, a C₆-C₆₀ arylthio group, a C₁-C₆₀ heteroaryl group, a C₂-C₆₀ alkyl heteroaryl group, a C₂-C₆₀ heteroaryl alkyl group, a C₁-C₆₀ heteroaryloxy group, a C₁-C₆₀ heteroarylthio group, a monovalent non-aromatic condensed polycyclic group, a monovalent non-aromatic condensed heteropolycyclic group, -Si(Q₅₀₁)(Q₅₀₂)(Q₅₀₃), or a combination thereof,
   xd1 to xd3 may each independently be 1, 2, or 3,
   R₅₀₁ and R₅₀₂ may each independently be a phenyl group, a naphthyl group, a fluorenyl group, a spiro-bifluorenyl group, a benzofluorenyl group, a dibenzofluorenyl group, a phenanthrenyl group, an anthracenyl group, a pyrenyl group, a chrysenyl group, a pyridinyl group, a pyrazinyl group, a pyrimidinyl group, a pyridazinyl group, a quinolinyl group, an isoquinolinyl group, a quinoxalinyl group, a quinazolinyl group, a carbazole group, a triazinyl group, a dibenzofuranyl group, a dibenzothiophenyl group, or a dibenzosilolyl group, each unsubstituted or substituted with deuterium, -F, -Cl, -Br, -I, -SF₅, a hydroxyl group, a nitro group, an amino group, an amidino group, a hydrazine group, a hydrazone group, a carboxylic acid group or a salt thereof, a sulfonic acid group or a salt thereof, a phosphoric acid group or a salt thereof, a C₁-C₆₀ alkyl group, a C₂-C₆₀ alkenyl group, a C₂-C₆₀ alkynyl group, a C₁-C₆₀ alkoxy group, a C₁-C₆₀ alkylthio group, a C₃-C₁₀ cycloalkyl group, a C₁-C₁₀ heterocycloalkyl group, a C₃-C₁₀ cycloalkenyl group, a C₁-C₁₀ heterocycloalkenyl group, a C₆-C₆₀ aryl group, a C₇-C₆₀ alkyl aryl group, a C₇-C₆₀ aryl alkyl group, a C₆-C₆₀ aryloxy group, a C₆-C₆₀ arylthio group, a C₁-C₆₀ heteroaryl group, a C₂-C₆₀ alkyl heteroaryl group, a C₂-C₆₀ heteroaryl alkyl group, a C₁-C₆₀ heteroaryloxy group, a C₁-C₆₀ heteroarylthio group, a monovalent non-aromatic condensed polycyclic group, a monovalent non-aromatic condensed heteropolycyclic group, -Si(Q₅₀₁)(Q₅₀₂)(Q₅₀₃), or a combination thereof,
   Z₁₁ may be a C₁-C₆₀ alkyl group, a C₂-C₆₀ alkenyl group, a C₂-C₆₀ alkynyl group, a C₁-C₆₀ alkoxy group, a C₁-C₆₀ alkylthio group, a C₃-C₁₀ cycloalkyl group, a C₁-C₁₀ heterocycloalkyl group, a C₃-C₁₀ cycloalkenyl group, a C₁-C₁₀ heterocycloalkenyl group, a C₆-C₆₀ aryl group, a C₇-C₆₀ alkyl aryl group, a C₇-C₆₀ aryl alkyl group, a C₆-C₆₀ aryloxy group, a C₆-C₆₀ arylthio group, a C₁-C₆₀ heteroaryl group, a C₂-C₆₀ alkyl heteroaryl group, a C₂-C₆₀ heteroaryl alkyl group, a C₁-C₆₀ heteroaryloxy group, a C₁-C₆₀ heteroarylthio group, a monovalent non-aromatic condensed polycyclic group, or a monovalent non-aromatic condensed heteropolycyclic group, each unsubstituted or substituted with deuterium, -F, -Cl, -Br, -I, -SF₅, a hydroxyl group, a nitro group, an amino group, an amidino group, a hydrazine group, a hydrazone group, a carboxylic acid group or a salt thereof, a sulfonic acid group or a salt thereof, a phosphoric acid group or a salt thereof, a C₁-C₆₀ alkyl group, a C₂-C₆₀ alkenyl group, a C₂-C₆₀ alkynyl group, a C₁-C₆₀ alkoxy group, a C₁-C₆₀ alkylthio group, a C₃-C₁₀ cycloalkyl group, a C₁-C₁₀ heterocycloalkyl group, a C₃-C₁₀ cycloalkenyl group, a C₁-C₁₀ heterocycloalkenyl group, a C₆-C₆₀ aryl group, a C₇-C₆₀ alkyl aryl group, a C₇-C₆₀ aryl alkyl group, a C₆-C₆₀ aryloxy group, a C₆-C₆₀ arylthio group, a C₁-C₆₀ heteroaryl group, a C₂-C₆₀ alkyl heteroaryl group, a C₂-C₆₀ heteroaryl alkyl group, a C₁-C₆₀ heteroaryloxy group, a C₁-C₆₀ heteroarylthio group, a monovalent non-aromatic condensed polycyclic group, a monovalent non-aromatic condensed heteropolycyclic group, -Si(Q₅₀₁)(Q₅₀₂)(Q₅₀₃), or a combination thereof,
   xd4 may be 1, 2, 3, 4, 5, or 6, and
   Q₅₀₁ to Q₅₀₃ may each independently be hydrogen, a C₁-C₆₀ alkyl group, a C₁-C₆₀ alkoxy group, a C₁-C₆₀ alkylthio group, a C₆-C₆₀ aryl group, a C₁-C₆₀ heteroaryl group, a monovalent non-aromatic condensed polycyclic group, or a monovalent non-aromatic condensed heteropolycyclic group.

In one or more embodiments, the fluorescent compound may include the compound represented by Formula 501A or 501B, wherein xd4 in Formula 501A may be 1, 2, 3, 4, 5, or 6, and xd4 in Formula 501B may be 2, 3, or 4.

In one or more embodiments, the fluorescent compound that may be used as an emitter in the second embodiment of the emission layer may include a compound represented by Formula 503-1 or 503-2: 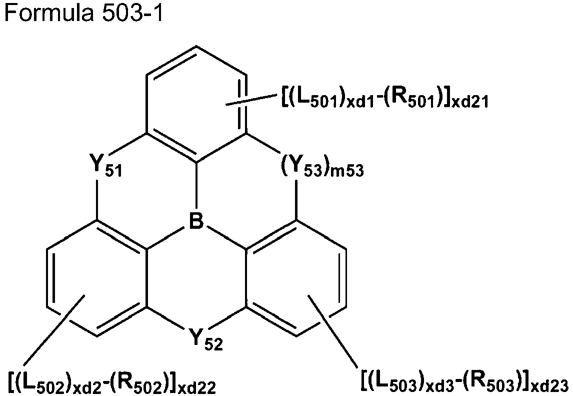 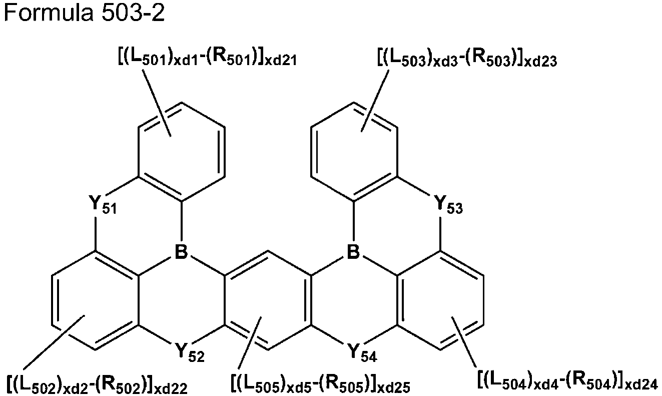 wherein, in Formulae 503-1 and 503-2,
Y₅₁ to Y₅₄ may each independently be a single bond, O, S, N[(L₅₀₆)_{xd6}-R₅₀₆], C[(L₅₀₆)_{xd6}-R₅₀₆][(L₅₀₇)_{xd7}-R₅₀₇], or Si[(L₅₀₆)_{xd6}-R₅₀₆][(L₅₀₇)_{xd7}-R₅₀₇],
m53 may be 0 or 1,
L₅₀₁ to L₅₀₇ may each be as described in connection with L₅₀₁ in Formula 501B,
xd1 to xd7 may each be as described in connection with xd1 in Formula 501B,
R₅₀₁ to R₅₀₇ may each independently be:
   hydrogen, deuterium, -F, -Cl, -Br, -I, -SF₅, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, a C₁-C₂₀ alkyl group, a C₁-C₂₀ alkoxy group, or a C₁-C₂₀ alkylthio group;
   a phenyl group, a biphenyl group, a terphenyl group, a naphthyl group, a fluorenyl group, a spiro-bifluorenyl group, a benzofluorenyl group, a dibenzofluorenyl group, a phenanthrenyl group, an anthracenyl group, a pyrenyl group, a chrysenyl group, a pyridinyl group, a pyrazinyl group, a pyrimidinyl group, a pyridazinyl group, a quinolinyl group, an isoquinolinyl group, a quinoxalinyl group, a quinazolinyl group, a carbazole group, a triazinyl group, a dibenzofuranyl group, or a dibenzothiophenyl group; or
   a phenyl group, a biphenyl group, a terphenyl group, a naphthyl group, a fluorenyl group, a spiro-bifluorenyl group, a benzofluorenyl group, a dibenzofluorenyl group, a phenanthrenyl group, an anthracenyl group, a pyrenyl group, a chrysenyl group, a pyridinyl group, a pyrazinyl group, a pyrimidinyl group, a pyridazinyl group, a quinolinyl group, an isoquinolinyl group, a quinoxalinyl group, a quinazolinyl group, a carbazolyl group, a triazinyl group, a dibenzofuranyl group, or a dibenzothiophenyl group, each substituted with deuterium, -F, -Cl, -Br, -I, -SF₅, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, a C₁-C₂₀ alkyl group, a C₁-C₂₀ alkoxy group, a C₁-C₂₀ alkylthio group, a phenyl group, a biphenyl group, a terphenyl group, a naphthyl group, a fluorenyl group, a spiro-bifluorenyl group, a benzofluorenyl group, a dibenzofluorenyl group, a phenanthrenyl group, an anthracenyl group, a pyrenyl group, a chrysenyl group, a pyridinyl group, a pyrazinyl group, a pyrimidinyl group, a pyridazinyl group, a quinolinyl group, an isoquinolinyl group, a quinoxalinyl group, a quinazolinyl group, a carbazolyl group, a triazinyl group, a dibenzofuranyl group, a dibenzothiophenyl group, or a combination thereof,
   xd21 and xd23 may each independently be 0, 1, 2, 3, or 4,
   xd22 and xd24 may each independently be 0, 1, 2, or 3,
   xd25 may be 0, 1, or 2, and
   two of R₅₀₁ to R₅₀₇ may optionally be bonded to each other to form a saturated or unsaturated ring.

The fluorescent compound may include, for example, at least one of Compounds FD(1) to FD(16) or FD1 to FD14, or a combination thereof, but embodiments are not limited thereto:

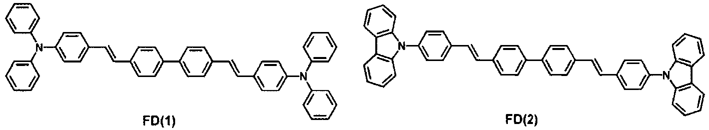

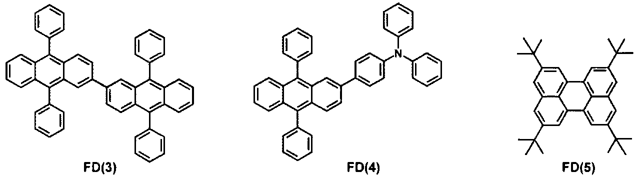

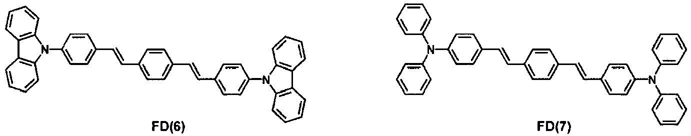

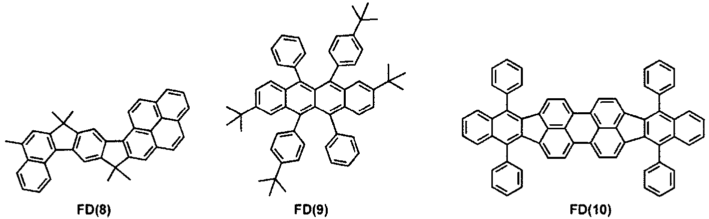

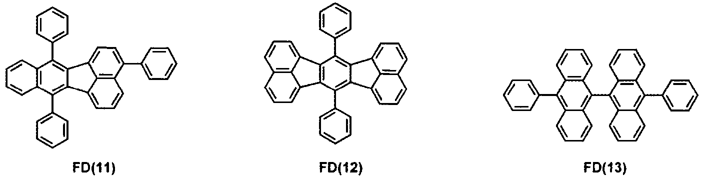

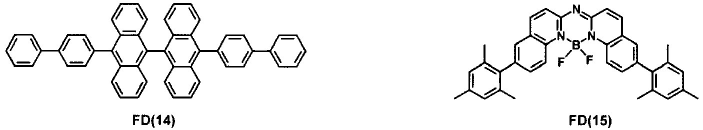

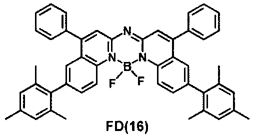

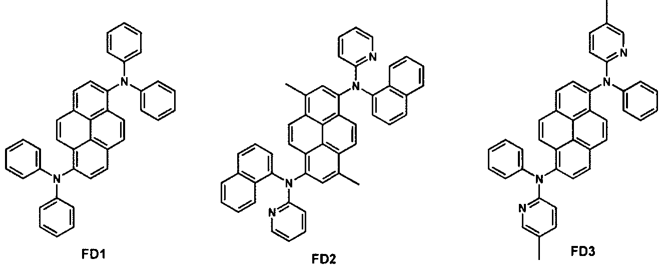

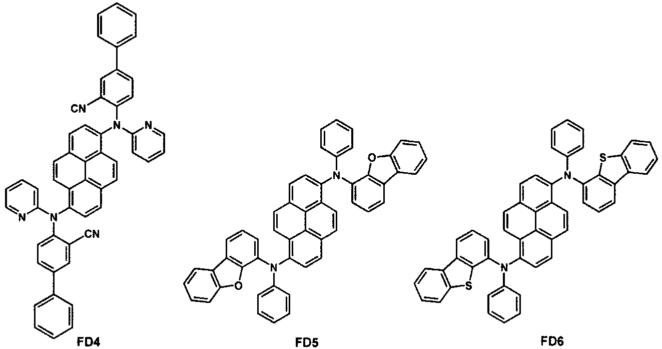

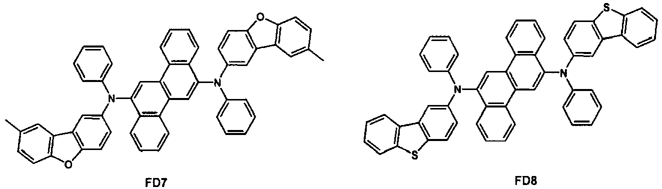

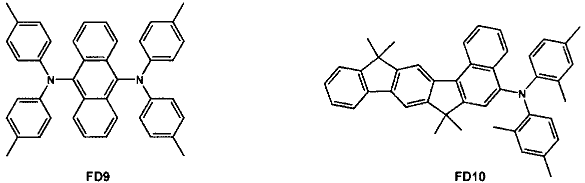

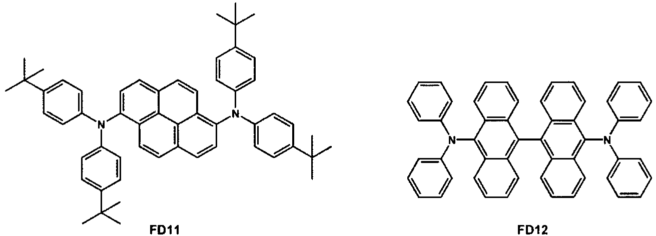

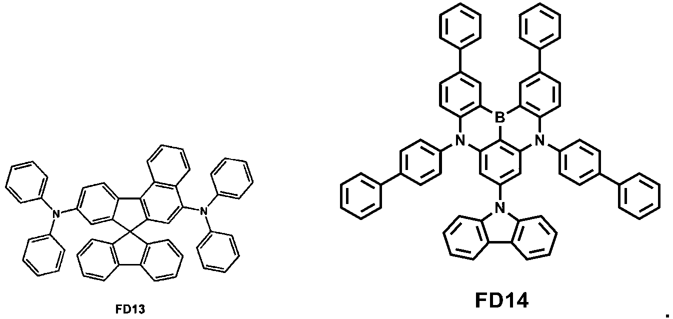

The expression "(an interlayer) includes at least one organometallic compound represented by Formula 1" as used herein may include a case in which "(an interlayer) includes identical organometallic compounds represented by Formula 1" and a case in which "(an interlayer) includes two or more different organometallic compounds represented by Formula 1."

In one or more embodiments, the interlayer may include, as the at least one organometallic compound represented by Formula 1, only Compound 1. In this regard, Compound 1 may be present in the emission layer of the light-emitting device. In one or more embodiments, the interlayer may include, as the at least one organometallic compound represented by Formula 1, Compound 1 and Compound 2. In this regard, Compound 1 and Compound 2 may be present in the same layer (e.g., both Compound 1 and Compound 2 may be present in the emission layer).

The first electrode may be an anode, which is a hole injection electrode, and the second electrode may be a cathode, which is an electron injection electrode; or the first electrode may be a cathode, which is an electron injection electrode, and the second electrode may be an anode, which is a hole injection electrode.

In one or more embodiments, in the light-emitting device, the first electrode may be an anode, the second electrode may be a cathode, and the interlayer may further include a hole transport region arranged between the first electrode and the emission layer, and an electron transport region arranged between the emission layer and the second electrode, wherein the hole transport region may include a hole injection layer, a hole transport layer, an electron-blocking layer, a buffer layer, or a combination thereof, and the electron transport region may include a hole-blocking layer, an electron transport layer, an electron injection layer, or a combination thereof.

The term "interlayer" as used herein refers to a single layer and/or multiple layers arranged between the first electrode and the second electrode of the light-emitting device. The "interlayer" may include, in addition to an organic compound, an organometallic complex including a metal.

The FIGURE is a schematic cross-sectional view of an organic light-emitting device 10, which is a light-emitting device according to one or more embodiments. Hereinafter, the structure and manufacturing method of the organic light-emitting device 10 according to one or more embodiments will be described in further detail with reference to the FIGURE. The organic light-emitting device 10 may have a structure in which a first electrode 11, an interlayer 15, and a second electrode 19 are sequentially stacked in the stated order.

A substrate may be additionally arranged under the first electrode 11 or on the second electrode 19. The substrate may be a conventional substrate used in organic light-emitting devices, for example, a glass substrate or a transparent plastic substrate, each having excellent mechanical strength, thermal stability, transparency, surface smoothness, ease of handling, and/or water repellency.

The first electrode 11 may be formed by, for example, depositing or sputtering, onto the substrate, a material for forming the first electrode 11. The first electrode 11 may be an anode. The material for forming the first electrode 11 may include materials with a high work function to facilitate hole injection. The first electrode 11 may be a reflective electrode, a transflective electrode, or a transmissive electrode. The material for forming the first electrode 11 may be indium tin oxide (ITO), indium zinc oxide (IZO), tin oxide (SnO₂), or zinc oxide (ZnO). In one or more embodiments, the material for forming the first electrode 11 may be a metal, such as magnesium (Mg), aluminum (Al), silver (Ag), aluminum-lithium (Al-Li), calcium (Ca), magnesium-indium (Mg-In), or magnesium-silver (Mg-Ag).

The first electrode 11 may have a single-layered structure or a multi-layered structure including two or more layers. For example, the first electrode 11 may have a three-layered structure of ITO/Ag/ITO.

The interlayer 15 may be arranged on the first electrode 11.

The interlayer 15 may include: a hole transport region; an emission layer; and an electron transport region.

The hole transport region may be arranged between the first electrode 11 and the emission layer.

The hole transport region may include a hole injection layer, a hole transport layer, an electron-blocking layer, a buffer layer, or a combination thereof.

The hole transport region may include only either a hole injection layer or a hole transport layer. In one or more embodiments, the hole transport region may have a hole injection layer/hole transport layer structure or a hole injection layer/hole transport layer/electron-blocking layer structure, wherein respective layers of each structure are sequentially stacked in the stated order from the first electrode 11.

When the hole transport region includes a hole injection layer, the hole injection layer may be formed on the first electrode 11 by using one or more suitable methods, such as vacuum deposition, spin coating, casting, Langmuir-Blodgett (LB) deposition, or the like, but embodiments are not limited thereto.

When the hole injection layer is formed by vacuum deposition, deposition conditions may vary depending on a compound used as a material for forming the hole injection layer, and the structure and thermal characteristics of the desired hole injection layer. For example, a deposition temperature may be about 100°C to about 500°C, a vacuum degree may be about 10⁻⁸ torr to about 10⁻³ torr, and a deposition rate may be about 0.01 angstroms per second (Å/sec) to about 100 Å/sec, but embodiments are not limited thereto.

When the hole injection layer is formed by spin coating, coating conditions may vary depending on a compound used as a material for forming the hole injection layer, and the structure and thermal characteristics of the desired hole injection layer. For example, a coating rate may be about 2,000 revolutions per minute (rpm) to about 5,000 rpm, and a temperature at which heat treatment may be performed to remove a solvent after coating may be about 80°C to about 200°C, but embodiments are not limited thereto.

Conditions for forming the hole transport layer and the electron-blocking layer may be the same as the conditions for forming the hole injection layer.

The hole transport region may include at least one of 4,4',4"-tris(3-methylphenylphenylamino)triphenylamine (m-MTDATA), 4,4',4"-tris(N,N-diphenylamino)triphenylamine (TDATA), 4,4',4"-tris{N-(2-naphthyl)-N-phenylamino}-triphenylamine (2-TNATA), N,N'-di(1-naphthyl)-N,N'-diphenylbenzidine (NPB), β-NPB, N,N'-bis(3-methylphenyl)-N,N'-diphenyl-[1,1-biphenyl]-4,4'-diamine (TPD), Spiro-TPD, Spiro-NPB, methylated NPB, 4,4'-cyclohexylidene bis[N,N-bis(4-methylphenyl)benzenamine] (TAPC), 4,4'-bis[N,N'-(3-tolyl)amino]-3,3'-dimethylbiphenyl (HMTPD), α-NPD, 4,4',4"-tris(N-carbazolyl)triphenylamine (TCTA), polyaniline/dodecylbenzenesulfonic acid (PANI/DBSA), poly(3,4-ethylenedioxythiophene)/poly(4-styrenesulfonate) (PEDOT/PSS), polyaniline/camphor sulfonic acid (PANI/CSA), polyaniline/poly(4-styrenesulfonate) (PANI/PSS), a compound represented by Formula 201, a compound represented by Formula 202, or a combination thereof, but embodiments are not limited thereto:

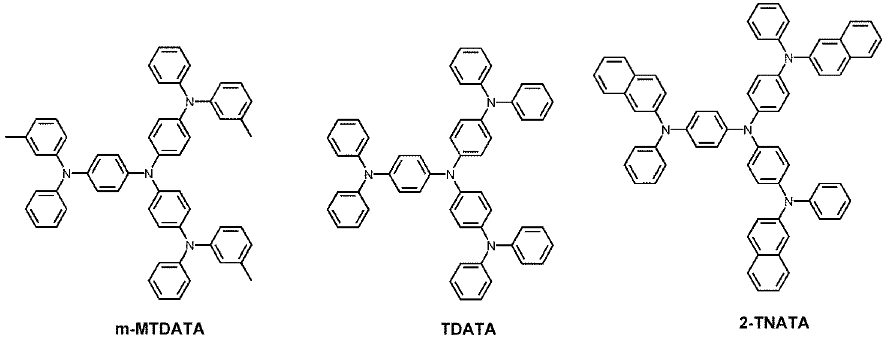

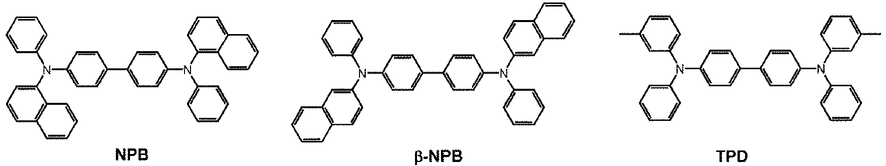

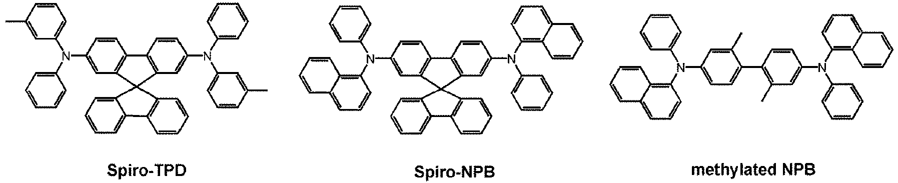

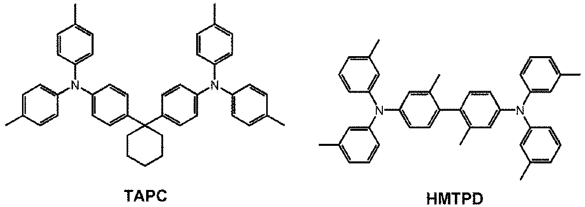

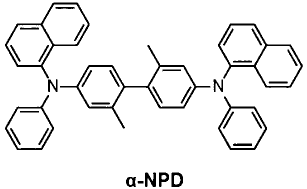

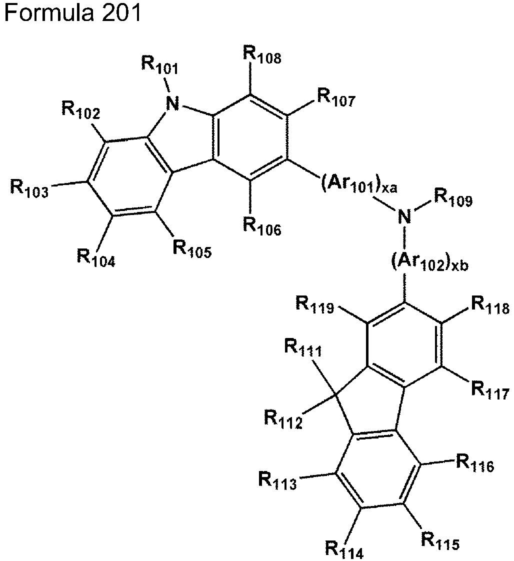

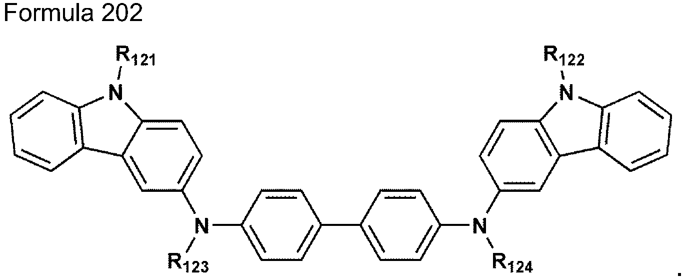

Ar₁₀₁ and Ar₁₀₂ in Formula 201 may each independently be a phenylene group, a pentalenylene group, an indenylene group, a naphthylene group, an azulenylene group, a heptalenylene group, an acenaphthyenlene group, a fluorenylene group, a phenalenylene group, a phenanthrenylene group, an anthracenylene group, a fluoranthenylene group, a triphenylenylene group, a pyrenylene group, a chrysenylenylene group, a naphthacenylene group, a picenylene group, a perylenylene group, or a pentacenylene group, each unsubstituted or substituted with deuterium, -F, -Cl, -Br, -I, -SF₅, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, a C₁-C₆₀ alkyl group, a C₂-C₆₀ alkenyl group, a C₂-C₆₀ alkynyl group, a C₁-C₆₀ alkoxy group, a C₁-C₆₀ alkylthio group, a C₃-C₁₀ cycloalkyl group, a C₃-C₁₀ cycloalkenyl group, a C₁-C₁₀ heterocycloalkyl group, a C₁-C₁₀ heterocycloalkenyl group, a C₆-C₆₀ aryl group, a C₇-C₆₀ alkyl aryl group, a C₇-C₆₀ aryl alkyl group, a C₆-C₆₀ aryloxy group, a C₆-C₆₀ arylthio group, a C₁-C₆₀ heteroaryl group, a C₂-C₆₀ alkyl heteroaryl group, a C₂-C₆₀ heteroaryl alkyl group, a C₁-C₆₀ heteroaryloxy group, a C₁-C₆₀ heteroarylthio group, a monovalent non-aromatic condensed polycyclic group, a monovalent non-aromatic condensed heteropolycyclic group, or a combination thereof.

xa and xb in Formula 201 may each independently be an integer from 0 to 5, or xa and xb may each independently be 0, 1, or 2. For example, xa may be 1, and xb may be 0, but embodiments are not limited thereto.

R₁₀₁ to R₁₀₈, R₁₁₁ to R₁₁₉, and R₁₂₁ to R₁₂₄ in Formulae 201 and 202 may each independently be:
hydrogen, deuterium, -F, -Cl, -Br, -I, -SF₅, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, a C₁-C₁₀ alkyl group (e.g., a methyl group, an ethyl group, a propyl group, a butyl group, a pentyl group, a hexyl group, or the like), a C₁-C₁₀ alkoxy group (e.g., a methoxy group, an ethoxy group, a propoxy group, a butoxy group, a pentoxy group, or the like), or a C₁-C₁₀ alkylthio group;
a C₁-C₁₀ alkyl group, a C₁-C₁₀ alkoxy group, or a C₁-C₁₀ alkylthio group, each substituted with deuterium, -F, -Cl, -Br, -I, -SF₅, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, or a combination thereof; or
a phenyl group, a naphthyl group, an anthracenyl group, a fluorenyl group, or a pyrenyl group, each unsubstituted or substituted with deuterium, - F, -Cl, -Br, -I, -SF₅, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, a C₁-C₁₀ alkyl group, a C₁-C₁₀ alkoxy group, a C₁-C₁₀ alkylthio group, or a combination thereof.

R₁₀₉ in Formula 201 may be a phenyl group, a naphthyl group, an anthracenyl group, or a pyridinyl group, each unsubstituted or substituted with deuterium, -F, -Cl, -Br, -I, -SF₅, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, a C₁-C₂₀ alkyl group, a C₁-C₂₀ alkoxy group, a C₁-C₂₀ alkylthio group, a phenyl group, a naphthyl group, an anthracenyl group, a pyridinyl group, or a combination thereof.

In one or more embodiments, the compound represented by Formula 201 may be represented by Formula 201A:

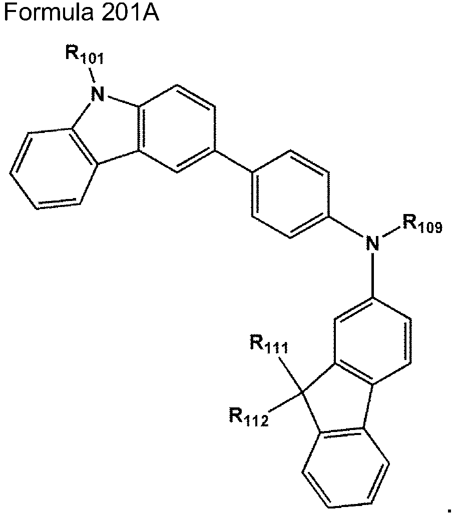

R₁₀₁, R₁₁₁, R₁₁₂, and R₁₀₉ in Formula 201A may each be as described herein. In one or more embodiments, the hole transport region may include one of Compounds HT1 to HT20, or a combination thereof, but embodiments are not limited thereto:

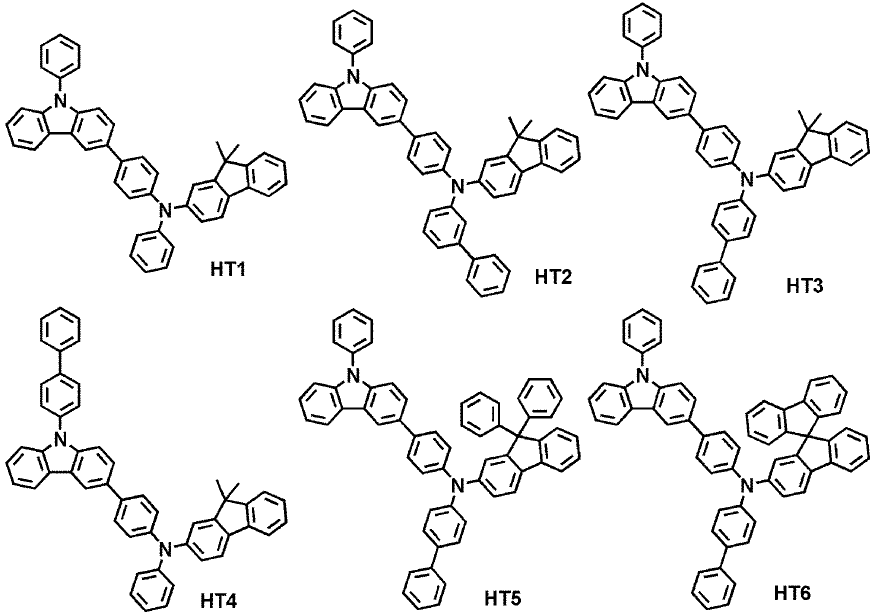

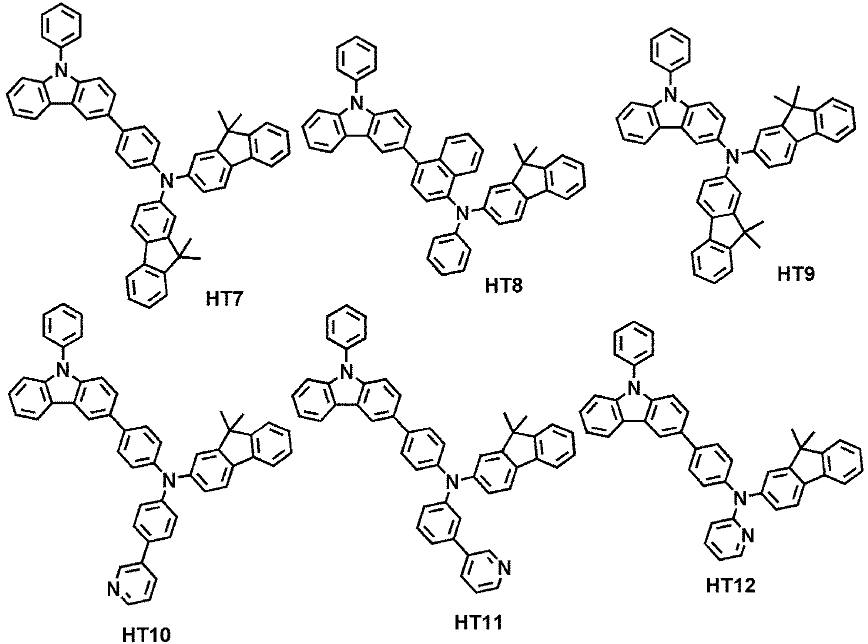

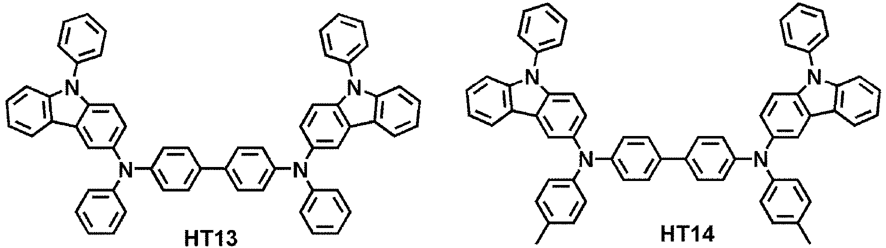

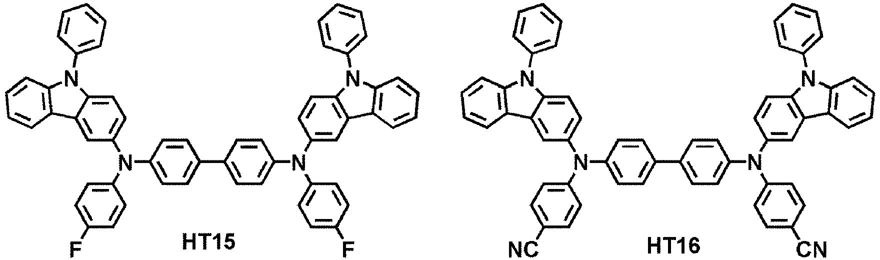

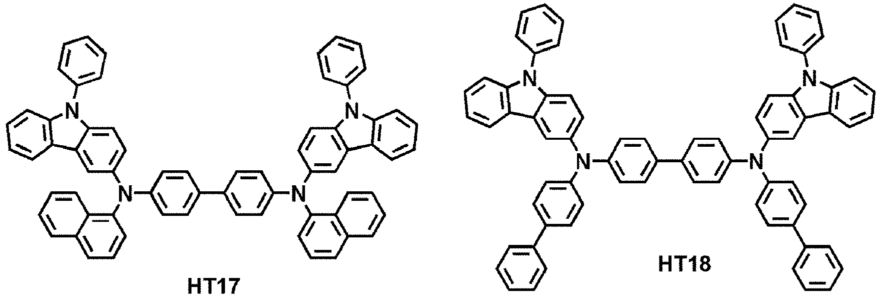

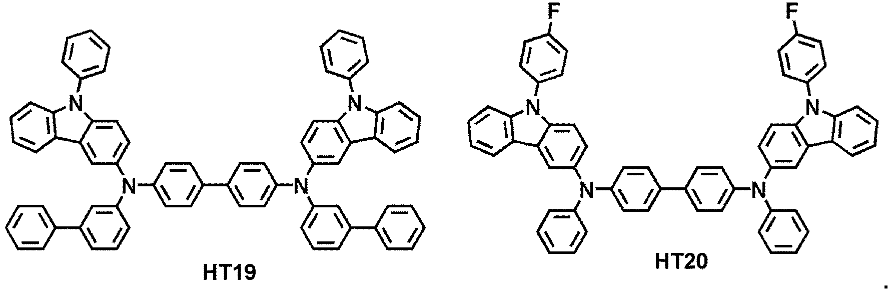

A thickness of the hole transport region may be about 100 Å to about 10,000 Å, for example, about 100 Å to about 1,000 Å. When the hole transport region includes a hole injection layer, a hole transport layer, an electron-blocking layer, or a combination thereof, a thickness of the hole injection layer may be about 100 Å to about 10,000 Å, for example, about 100 Å to about 1,000 Å, and a thickness of the hole transport layer may be about 50 Å to about 2,000 Å, for example, about 100 Å to about 1,500 Å. When the thicknesses of the hole transport region, the hole injection layer, and the hole transport layer are within the ranges described above, satisfactory hole-transporting characteristics may be obtained without a substantial increase in driving voltage.

The hole transport region may further include, in addition to the materials described above, a charge-generation material for improving conductivity. The charge-generation material may be homogeneously or non-homogeneously dispersed in the hole transport region.

The charge-generation material may be, for example, a p-dopant. The p-dopant may be a quinone derivative, a metal oxide, a cyano group-containing compound, or a combination thereof, but embodiments are not limited thereto. For example, the p-dopant may include a quinone derivative, such as tetracyanoquinonedimethane (TCNQ), 2,3,5,6-tetrafluoro-tetracyano-1,4-benzoquinonedimethane (F4-TCNQ), or F6-TCNNQ; a metal oxide, such as tungsten oxide or molybdenum oxide; a cyano group-containing compound, such as Compound HT-D1; or a combination thereof, but embodiments are not limited thereto:

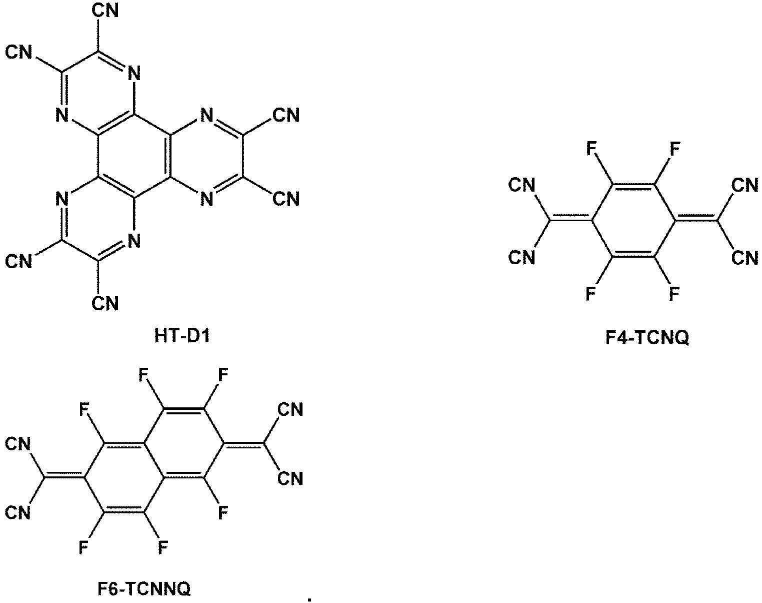

The hole transport region may include a buffer layer.

The buffer layer may compensate for an optical resonance distance according to a wavelength of light emitted from the emission layer to increase efficiency.

When the hole transport region includes an electron-blocking layer, a material for forming the electron-blocking layer may include a material that is used in the hole transport region as described above, a host material described below, or a combination thereof. For example, when the hole transport region includes an electron-blocking layer, a material for forming the electron-blocking layer may be mCP, which will be described below.

The emission layer may be formed on the hole transport region by vacuum deposition, spin coating, casting, LB deposition, or the like, but embodiments are not limited thereto. When the emission layer is formed by vacuum deposition or spin coating, the deposition or the coating conditions may be similar to those applied in forming the hole injection layer, although the deposition or coating conditions may vary depending on a material to be used.

The emission layer may include a host and a dopant, and the dopant may include at least one of the organometallic compounds represented by Formula 1 as described herein.

The host may include at least one of 1,3,5-tri(1-phenyl-1H-benzo[d]imidazol-2-yl)benzene (TPBi), 3-tert-butyl-9,10-di(naphth-2-yl)anthracene (TBADN), 9,10-di(naphth-2-yl)anthracene (ADN) (also referred to as "DNA"), 4,4'-bis(N-carbazolyl)-1,1'-biphenyl (CBP), 4,4'-bis(9-carbazolyl)-2,2'-dimethyl-biphenyl (CDBP), 1,3,5-tris(carbazol-9-yl)benzene (TCP), 1,3-bis(N-carbazolyl)benzene (mCP), Compound H50, Compound H51, Compound H52, or a combination thereof, but embodiments are not limited thereto:

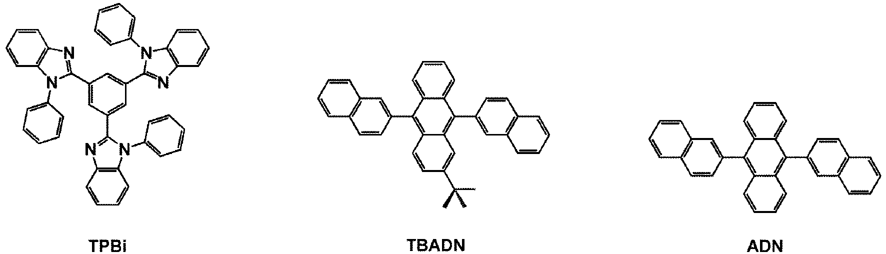

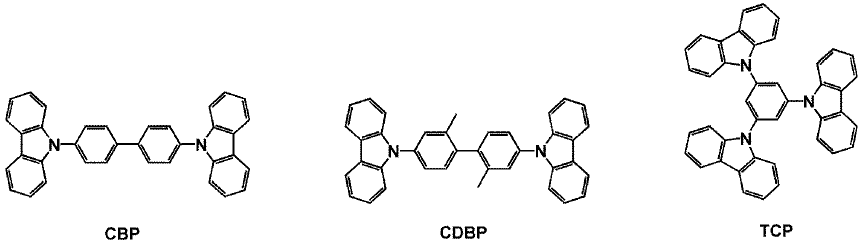

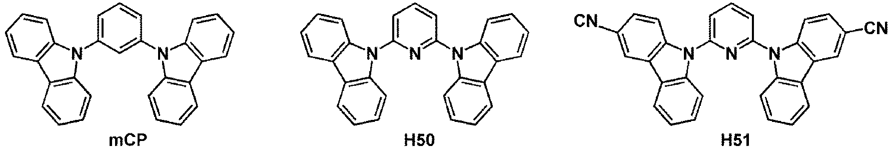

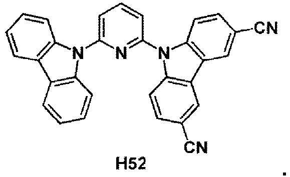

When the organic light-emitting device is a full-color organic light-emitting device, the emission layer may be patterned into a red emission layer, a green emission layer, and/or a blue emission layer. In one or more embodiments, due to a stacked structure including a red emission layer, a green emission layer, and/or a blue emission layer, the emission layer may emit white light, and various modifications are possible.

When the emission layer includes a host and a dopant, an amount of the dopant may be about 0.01 parts by weight to about 15 parts by weight based on 100 parts by weight of the host, but embodiments are not limited thereto.

A thickness of the emission layer may be about 100 Å to about 1,000 Å, for example, about 200 Å to about 600 Å. When the thickness of the emission layer is within the range described above, excellent luminescence characteristics may be obtained without a substantial increase in driving voltage.

The electron transport region may be arranged on the emission layer.

The electron transport region may include a hole-blocking layer, an electron transport layer, an electron injection layer, or a combination thereof.

In one or more embodiments, the electron transport region may have a hole-blocking layer/electron transport layer/electron injection layer structure or an electron transport layer/electron injection layer structure, but embodiments are not limited thereto. The electron transport layer may have a single-layered structure or a multi-layered structure including two or more different materials.

Conditions for forming the hole-blocking layer, the electron transport layer, and the electron injection layer which constitute the electron transport region may be the same as the conditions for forming the hole injection layer.

When the electron transport region includes a hole-blocking layer, the hole-blocking layer may include, for example, at least one of 2,9-dimethyl-4,7-diphenyl-1,10-phenanthroline (BCP), 4,7-diphenyl-1,10-phenanthroline (Bphen), bis(2-methyl-8-quinolinolato-N1,O8)-(1,1'-biphenyl-4-olato)aluminum (BAlq), or a combination thereof, but embodiments are not limited thereto:

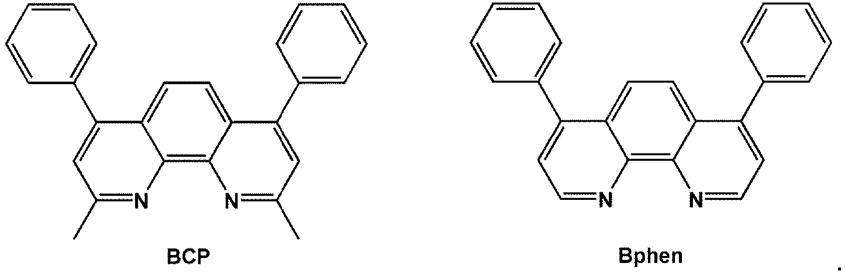

In one or more embodiments, the hole-blocking layer may include the host described above, a material for forming an electron transport layer, a material for forming an electron injection layer, which will be described below, or a combination thereof.

A thickness of the hole-blocking layer may be about 20 Å to about 1,000 Å, for example, about 30 Å to about 600 Å. When the thickness of the hole-blocking layer is within the range described above, excellent hole-blocking characteristics may be obtained without a substantial increase in driving voltage.

The electron transport layer may include at least one of 2,9-dimethyl-4,7-diphenyl-1,10-phenanthroline (BCP), 4,7-diphenyl-1,10-phenanthroline (Bphen), 1,3,5-tri(1-phenyl-1H-benzo[d]imidazol-2-yl)benzene (TPBi), tris(8-hydroxy-quinolinato)aluminum (Alq₃), bis(2-methyl-8-quinolinolato-N1,O8)-(1,1'-biphenyl-4-olato)aluminum (BAlq), 3-(4-biphenylyl)-4-phenyl-5-tert-butylphenyl-1,2,4-triazole (TAZ), 4-(naphthalen-1-yl)-3,5-diphenyl-4H-1,2,4-triazole (NTAZ), or a combination thereof, but embodiments are not limited thereto:

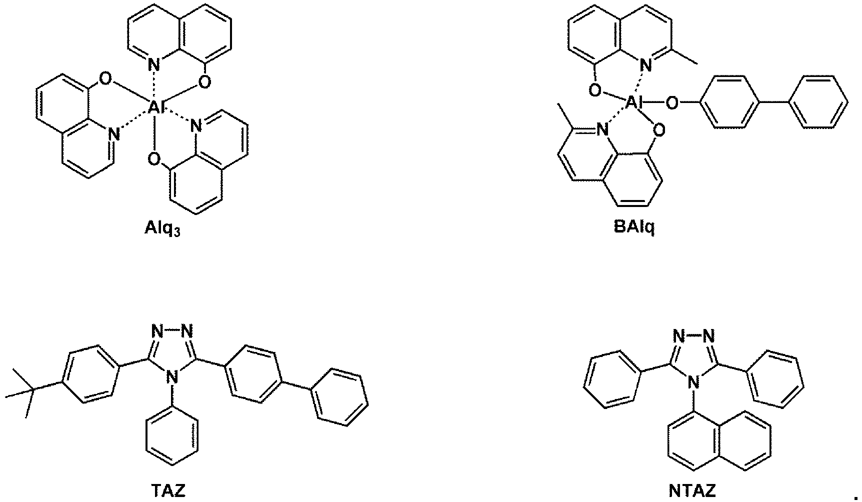

In one or more embodiments, the electron transport layer may include one of Compounds ET1 to ET25, or a combination thereof, but embodiments are not limited thereto:

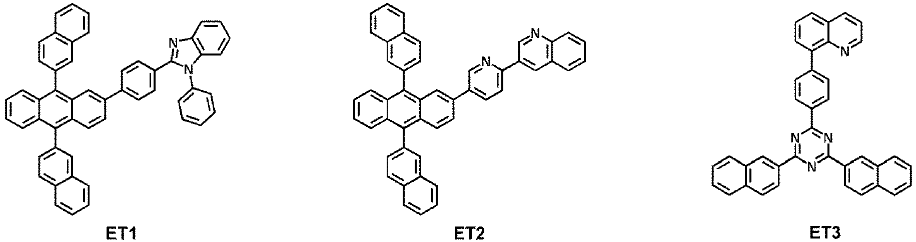

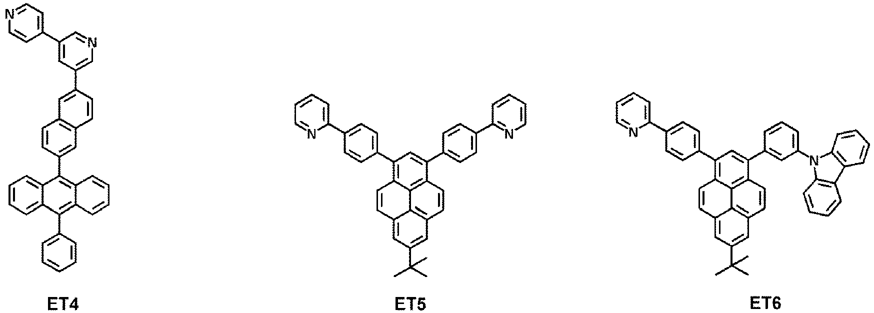

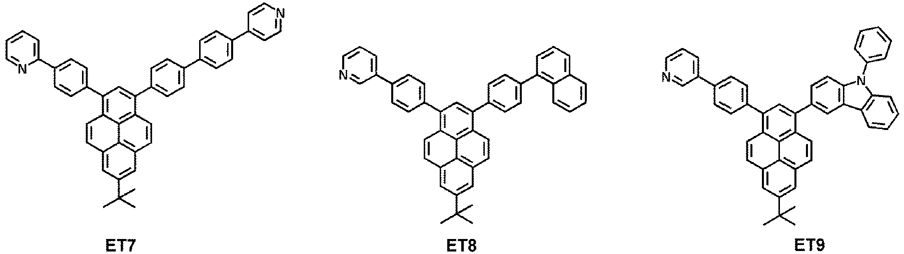

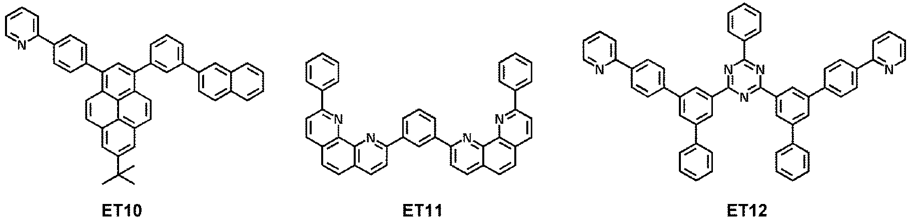

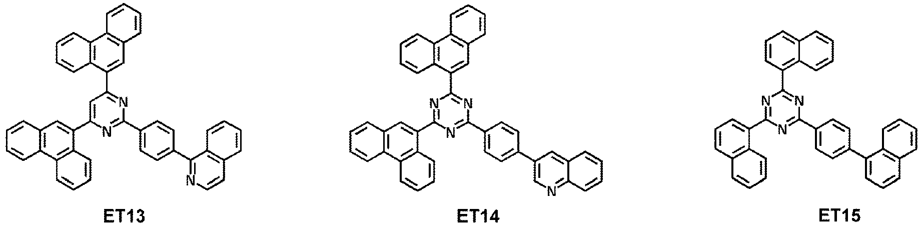

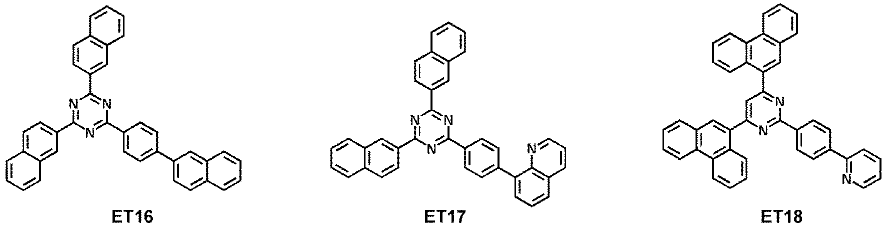

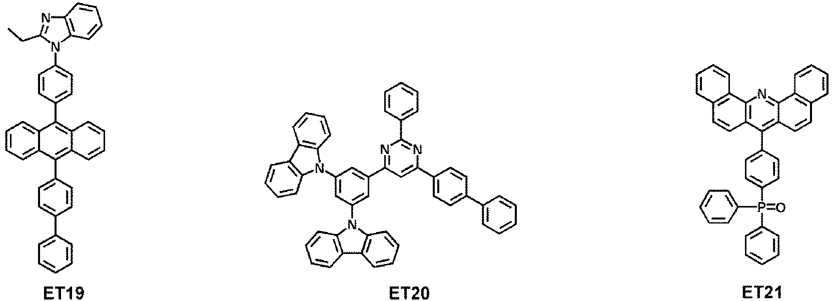

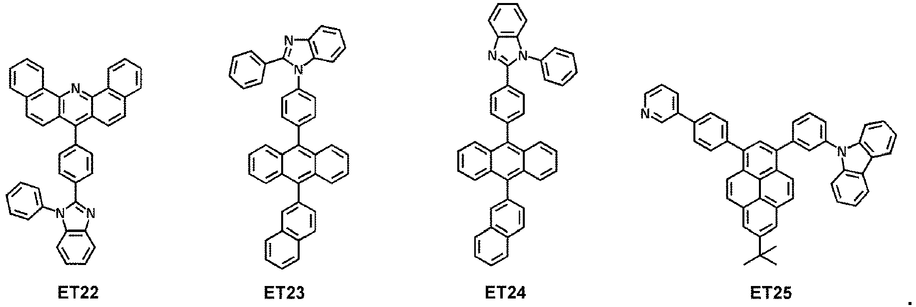

A thickness of the electron transport layer may be about 100 Å to about 1,000 Å, for example, about 150 Å to about 500 Å. When the thickness of the electron transport layer is within the ranges described above, satisfactory electron-transporting characteristics may be obtained without a substantial increase in driving voltage.

The electron transport layer may further include, in addition to the materials described above, a metal-containing material.

The metal-containing material may include a Li complex. The Li complex may include, for example, Compound ET-D1 or ET-D2, but embodiments are not limited thereto:

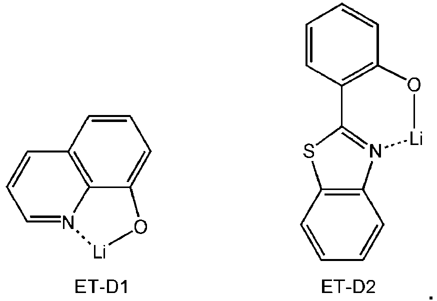

The electron transport region may also include an electron injection layer that facilitates the injection of electrons from the second electrode 19.

The electron injection layer may include LiF, NaCl, CsF, Li₂O, BaO, or a combination thereof.

A thickness of the electron injection layer may be about 1 Å to about 100 Å, for example, about 3 Å to about 90 Å. When the thickness of the electron injection layer is within the ranges described above, satisfactory electron injection characteristics may be obtained without a substantial increase in driving voltage.

The second electrode 19 may be arranged on the interlayer 15. The second electrode 19 may be a cathode. A material for forming the second electrode 19 may be a metal, an alloy, an electrically conductive compound, or a combination thereof, each having a relatively low work function. For example, the material for forming the second electrode 19 may be lithium (Li), magnesium (Mg), aluminum (Al), silver (Ag), aluminum-lithium (Al-Li), calcium (Ca), magnesium-indium (Mg-In), or magnesium-silver (Mg-Ag). In one or more embodiments, to manufacture a top-emission type light-emitting device, a transmissive electrode formed using ITO or IZO may be used as the second electrode 19, and various modifications are possible.

Hereinbefore, the organic light-emitting device has been described with reference to the FIGURE, but embodiments are not limited thereto.

According to another aspect, the light-emitting device may be included in various electronic apparatuses. Thus, provided is an electronic apparatus including the light-emitting device.

The electronic apparatus may further include, in addition to the light-emitting device, i) a color filter, ii) a color conversion layer, or iii) a color filter and a color conversion layer. The color filter and/or the color conversion layer may be arranged in at least one direction in which light emitted from the light-emitting device travels. For example, light emitted from the light-emitting device may be a blue light, a green light, or white light. The light-emitting device may be as described herein. In one or more embodiments, the color conversion layer may include quantum dots.

The electronic apparatus may include a first substrate. The first substrate may include a plurality of subpixel areas, the color filter may include a plurality of color filter areas respectively corresponding to the subpixel areas, and the color conversion layer may include a plurality of color conversion areas respectively corresponding to the subpixel areas.

A pixel-defining film may be arranged among the subpixel areas to define each of the subpixel areas.

The color filter may further include a plurality of color filter areas and light-shielding patterns arranged among the color filter areas, and the color conversion layer may further include a plurality of color conversion areas and light-shielding patterns arranged among the color conversion areas.

The electronic apparatus may further include a thin-film transistor, in addition to the light-emitting device described above. The thin-film transistor may include a source electrode, a drain electrode, and an active layer, wherein any one of the source electrode and the drain electrode may be electrically connected to any one of the first electrode and the second electrode of the light-emitting device.

The thin-film transistor may further include a gate electrode, a gate insulating film, or the like.

The active layer may include crystalline silicon, amorphous silicon, an organic semiconductor, an oxide semiconductor, or the like.

The electronic apparatus may further include a sealing portion for sealing the light-emitting device. The sealing portion may be arranged between the color filter and/or the color conversion layer and the light-emitting device. The sealing portion allows light from the light-emitting device to be extracted to the outside, and simultaneously prevents ambient air and moisture from penetrating into the light-emitting device. The sealing portion may be a sealing substrate including a transparent glass substrate or a plastic substrate. The sealing portion may be a thin-film encapsulation layer including at least one layer of an organic layer and/or an inorganic layer. When the sealing portion is a thin-film encapsulation layer, the electronic apparatus may be flexible.

Various functional layers may be additionally arranged on the sealing portion, in addition to the color filter and/or the color conversion layer, according to the use of the electronic apparatus. Examples of the functional layers may include a touch screen layer and a polarizing layer. The touch screen layer may be a pressure-sensitive touch screen layer, a capacitive touch screen layer, or an infrared touch screen layer.

In one or more embodiments, the electronic apparatus may include a light-emitting device and a sealing portion for sealing the light-emitting device.

In one or more embodiments, provided is a method of manufacturing an electronic apparatus including a light-emitting device and a sealing portion for sealing the light-emitting device, the method including:
manufacturing the light-emitting device; and
manufacturing the sealing portion for protecting the light-emitting device from ambient air and moisture.

In one or more embodiments, the electronic apparatus may be or may be applied to one of a flat panel display, a curved display, a computer monitor, a medical monitor, a television, a billboard, an indoor light, an outdoor light, a signal light, a head-up display, a fully or partially transparent display, a flexible display, a rollable display, a foldable display, a stretchable display, a laser printer, a telephone, a mobile phone, a tablet, a phablet, a personal digital assistant (PDA), a wearable device (e.g., a wristwatch), a laptop computer, a personal computer, a digital camera, a camcorder, a viewfinder, a micro display, a 3D display, a virtual reality display, an augmented reality display, a vehicle, a video wall including multiple displays tiled together, a theater screen, a stadium screen, a phototherapy device, a signboard, an electronic organizer, an electronic dictionary, an electronic game machine, or the like, but embodiments are not limited thereto.

The light-emitting device may have excellent driving voltage and external quantum efficiency characteristics, and thus, the electronic apparatus including the light-emitting device may have high-quality characteristics, such as a high luminance, a high resolution, and a low power consumption.

Another aspect provides a diagnostic composition including at least one organometallic compound represented by Formula 1.

The organometallic compound represented by Formula 1 may be able to provide a high luminescence efficiency, and thus, the diagnostic composition including at least one of the organometallic compounds represented by Formula 1 may have a high diagnostic efficiency.

The diagnostic composition may be used in various applications including a diagnosis kit, a diagnosis reagent, a biosensor, a biomarker, or the like, but embodiments are not limited thereto.

The term "C₁-C₆₀ alkyl group" as used herein refers to a linear or branched saturated aliphatic hydrocarbon monovalent group having 1 to 60 carbon atoms, and the term "C₁-C₆₀ alkylene group" as used here refers to a divalent group having the same structure as the C₁-C₆₀ alkyl group.

Herein, C₁-C₆₀ alkyl group may be C₁-C₂₀ alkyl group, for example, C₁-C₁₀ alkyl group or C₁-C₆ alkyl group. Each of these alkyl groups may be linear or branched. In the case of a branched alkyl group, the lower limit of the carbon number range of each of these alkyl groups changes to be 3. Non-limiting examples of the C₁-C₆₀ alkyl group, the C₁-C₂₀ alkyl group, and/or the C₁-C₁₀ alkyl group include a methyl group, an ethyl group, an n-propyl group, an isopropyl group, an n-butyl group, a sec-butyl group, an isobutyl group, a tert-butyl group, an n-pentyl group, a tert-pentyl group, a neopentyl group, an isopentyl group, a sec-pentyl group, a 3-pentyl group, a sec-isopentyl group, an n-hexyl group, an isohexyl group, a sec-hexyl group, a tert-hexyl group, an n-heptyl group, an isoheptyl group, a sec-heptyl group, a tert-heptyl group, an n-octyl group, an isooctyl group, a sec-octyl group, a tert-octyl group, an n-nonyl group, an isononyl group, a sec-nonyl group, a tert-nonyl group, an n-decyl group, an isodecyl group, a sec-decyl group, a tert-decyl group, or the like, each unsubstituted or substituted with a methyl group, an ethyl group, an n-propyl group, an isopropyl group, an n-butyl group, a sec-butyl group, an isobutyl group, a tert-butyl group, an n-pentyl group, a tert-pentyl group, a neopentyl group, an isopentyl group, a sec-pentyl group, a 3-pentyl group, a sec-isopentyl group, an n-hexyl group, an isohexyl group, a sec-hexyl group, a tert-hexyl group, an n-heptyl group, an isoheptyl group, a sec-heptyl group, a tert-heptyl group, an n-octyl group, an isooctyl group, a sec-octyl group, a tert-octyl group, an n-nonyl group, an isononyl group, a sec-nonyl group, a tert-nonyl group, an n-decyl group, an isodecyl group, a sec-decyl group, a tert-decyl group, or a combination thereof.

The term "C₁-C₆₀ alkoxy group" as used herein refers to monovalent group having a formula of -OA₁₀₁ (wherein A₁₀₁ is the C₁-C₆₀ alkyl group), and the term "C₁-C₆₆ alkylthio group" as used herein refers to a monovalent group having a formula of -SA₁₀₂ (wherein A₁₀₂ is the C₁-C₆₀ alkyl group).

Non-limiting examples of the C₁-C₆₀ alkoxy group, the C₁-C₂₀ alkoxy group, or the C₁-C₁₀ alkoxy group include a methoxy group, an ethoxy group, a propoxy group, a butoxy group, a pentoxy group, or the like.

The term "C₂-C₆₀ alkenyl group" as used herein refers to a hydrocarbon group formed by substituting at least one carbon-carbon double bond in the middle or at the terminus of the C₂-C₆₀ alkyl group, and non-limiting examples thereof include an ethenyl group, a propenyl group, a butenyl group, or the like. The term "C₂-C₆₀ alkenylene group" as used herein refers to a divalent group having the same structure as the C₂-C₆₀ alkenyl group.

The term "C₂-C₆₀ alkynyl group" as used herein refers to a hydrocarbon group formed by substituting at least one carbon-carbon triple bond in the middle or at the terminus of the C₂-C₆₀ alkyl group, and non-limiting examples thereof include an ethynyl group, a propynyl group, or the like. The term "C₂-C₆₀ alkynylene group" as used herein refers to a divalent group having the same structure as the C₂-C₆₀ alkynyl group.

The term "C₃-C₁₀ cycloalkyl group" as used herein refers to a monovalent saturated hydrocarbon ring group having 3 to 10 carbon atoms as ring-forming atoms, and the term "C₃-C₁₀ cycloalkylene group" as used herein refers to a divalent group having the same structure as the C₃-C₁₀ cycloalkyl group.

Non-limiting examples of the C₃-C₁₀ cycloalkyl group include a cyclopropyl group, a cyclobutyl group, a cyclopentyl group, a cyclohexyl group, a cycloheptyl group, a cyclooctyl group, an adamantanyl group, a bicyclo[1.1.1]pentyl group, a bicyclo[2.1.1]hexyl group, a bicyclo[2.2.1]heptyl(norbornanyl) group, a bicyclo[2.2.2]octyl group, or the like.

The term "C₁-C₁₀ heterocycloalkyl group" as used herein refers to a monovalent saturated ring group that includes at least one heteroatom selected from N, O, P, Si, S, Se, Ge, and B as a ring-forming atom and 1 to 10 carbon atoms as ring-forming atom(s), and the term "C₁-C₁₀ heterocycloalkylene group" as used herein refers to a divalent group having the same structure as the C₁-C₁₀ heterocycloalkyl group.

Non-limiting examples of the C₁-C₁₀ heterocycloalkyl group include a silolanyl group, a silinanyl group, tetrahydrofuranyl group, a tetrahydro-2H-pyranyl group, a tetrahydrothiophenyl group, or the like.

The term "C₃-C₁₀ cycloalkenyl group" as used herein refers to a monovalent hydrocarbon ring group that includes 3 to 10 carbon atoms as ring-forming atoms and at least one carbon-carbon double bond in the ring thereof and has no aromaticity, and non-limiting examples thereof include a cyclopentenyl group, a cyclohexenyl group, a cycloheptenyl group, or the like. The term "C₃-C₁₀ cycloalkenylene group" as used herein refers to a divalent group having the same structure as the C₃-C₁₀ cycloalkenyl group.

The term "C₁-C₁₀ heterocycloalkenyl group" as used herein refers to a monovalent ring group that includes at least one heteroatom selected from N, O, P, Si, S, Se, Ge, and B as a ring-forming atom, 1 to 10 carbon atoms as ring-forming atom(s), and at least one double bond in the ring thereof. Non-limiting examples of the C₁-C₁₀ heterocycloalkenyl group include a 2,3-dihydrofuranyl group, a 2,3-dihydrothiophenyl group, or the like. The term "C₁-C₁₀ heterocycloalkenylene group" as used herein refers to a divalent group having the same structure as the C₁-C₁₀ heterocycloalkenyl group.

The term "C₆-C₆₀ aryl group" as used herein refers to a monovalent group having a carbocyclic aromatic ring system having 6 to 60 carbon atoms as ring-forming, and the term "C₆-C₆₀ arylene group" as used herein refers to a divalent group having a carbocyclic aromatic ring system having 6 to 60 carbon atoms as ring-forming. Non-limiting examples of the C₆-C₆₀ aryl group include a phenyl group, a naphthyl group, an anthracenyl group, a phenanthrenyl group, a pyrenyl group, a chrysenyl group, or the like. When the C₆-C₆₀ aryl group and the C₆-C₆₀ arylene group each include two or more rings, the rings may be fused with each other.

The term "C₇-C₆₀ alkyl aryl group" as used herein refers to a C₆-C₆₀ aryl group substituted with at least one C₁-C₆₀ alkyl group. The term "C₇-C₆₀ aryl alkyl group" as used herein refers to a C₁-C₆₀ alkyl group substituted with at least one C₆-C₆₀ aryl group.

The term "C₁-C₆₀ heteroaryl group" as used herein refers to a monovalent heteroaromatic ring group that includes at least one heteroatom selected from N, O, P, Si, S, Se, Ge, and B as a ring-forming atom and a heteroaromatic ring system having 1 to 60 carbon atoms as ring-forming atom(s), and the term "C₁-C₆₀ heteroarylene group" as used herein refers to a divalent group that includes at least one heteroatom selected from N, O, P, Si, S, Se, Ge, and B as a ring-forming atom and a heteroaromatic ring system having 1 to 60 carbon atoms as ring-forming atom(s). Non-limiting examples of the C₁-C₆₀ heteroaryl group include a pyridinyl group, a pyrimidinyl group, a pyrazinyl group, a pyridazinyl group, a triazinyl group, a quinolinyl group, an isoquinolinyl group, or the like. When the C₁-C₆₀ heteroaryl group and the C₁-C₆₀ heteroarylene group each include two or more rings, the rings may be fused with each other.

The term "C₂-C₆₀ alkyl heteroaryl group" as used herein refers to a C₁-C₆₀ heteroaryl group substituted with at least one C₁-C₆₀ alkyl group. The term "C₂-C₆₀ heteroaryl alkyl group" as used herein refers to a C₁-C₆₀ alkyl group substituted with at least one C₁-C₆₀ heteroaryl group.

The term "C₆-C₆₀ aryloxy group" as used herein refers to -OA₁₀₃ (wherein A₁₀₃ is the C₆-C₆₀ aryl group), and the term "C₆-C₆₀ arylthio group" as used herein refers to -SA₁₀₄ (wherein A₁₀₄ is the C₆-C₆₀ aryl group).

The term "C₁-C₆₀ heteroaryloxy group" as used herein refers to -OA₁₀₅ (wherein A₁₀₅ is the C₁-C₆₀ heteroaryl group), and the term "C₁-C₆₀ heteroarylthio group" as used herein refers to -SA₁₀₆ (wherein A₁₀₆ is the C₁-C₆₀ heteroaryl group).

The term "monovalent non-aromatic condensed polycyclic group" as used herein refers to a monovalent group (e.g., having 8 to 60 carbon atoms) having two or more rings condensed with each other, only carbon atoms as ring-forming atoms, and no aromaticity in its entire molecular structure. Non-limiting examples of the monovalent non-aromatic condensed polycyclic group include a fluorenyl group or the like. The term "divalent non-aromatic condensed polycyclic group" as used herein refers to a divalent group having the same structure as the monovalent non-aromatic condensed polycyclic group.

The term "monovalent non-aromatic condensed heteropolycyclic group" as used herein refers to a monovalent group (e.g., having 1 to 60 carbon atoms) having two or more rings condensed with each other, a heteroatom selected from N, O, P, Si, S, Se, Ge, and B, other than carbon atoms, as a ring-forming atom, and no aromaticity in its entire molecular structure. Non-limiting examples of the monovalent non-aromatic condensed heteropolycyclic group include a carbazolyl group or the like. The term "divalent non-aromatic condensed heteropolycyclic group" as used herein refers to a divalent group having the same structure as the monovalent non-aromatic condensed heteropolycyclic group.

The term "C₅-C₃₀ carbocyclic group" as used herein refers to a saturated or unsaturated ring group including 5 to 30 carbon atoms only as ring-forming atoms. The C₅-C₃₀ carbocyclic group may be a monocyclic group or a polycyclic group. Non-limiting examples of the "C₅-C₃₀ carbocyclic group (unsubstituted or substituted with at least one R₁₀ₐ)" include an adamantane group, a norbornene group, a bicyclo[1.1.1]pentane group, a bicyclo[2.1.1]hexane group, a bicyclo[2.2.1]heptane(norbornane) group, a bicyclo[2.2.2]octane group, a cyclopentane group, a cyclohexane group, a cyclohexene group, a benzene group, a naphthalene group, an anthracene group, a phenanthrene group, a triphenylene group, a pyrene group, a chrysene group, a 1,2,3,4-tetrahydronaphthalene group, a cyclopentadiene group, a fluorene group, or the like (each unsubstituted or substituted with at least one R₁₀ₐ).

The term "C₁-C₃₀ heterocyclic group" as used herein refers to a saturated or unsaturated ring group having, as a ring-forming atom, at least one heteroatom selected from N, O, P, Si, S, Se, Ge, and B other than 1 to 30 carbon atoms as ring-forming atom(s). The C₁-C₃₀ heterocyclic group may be a monocyclic group or a polycyclic group. Non-limiting examples of the "C₁-C₃₀ heterocyclic group (unsubstituted or substituted with at least one R₁₀ₐ)" include a thiophene group, a furan group, a pyrrole group, a silole group, borole group, a phosphole group, a selenophene group, a germole group, a benzothiophene group, a benzofuran group, an indole group, a benzosilole group, a benzoborole group, a benzophosphole group, a benzoselenophene group, a benzogermole group, a dibenzothiophene group, a dibenzofuran group, a carbazole group, a dibenzosilole group, a dibenzoborole group, a dibenzophosphole group, a dibenzoselenophene group, a dibenzogermole group, a dibenzothiophene 5-oxide group, a 9H-fluoren-9-one group, a dibenzothiophene 5,5-dioxide group, an azabenzothiophene group, an azabenzofuran group, an azaindole group, an azaindene group, an azabenzosilole group, an azabenzoborole group, an azabenzophosphole group, an azabenzoselenophene group, an azabenzogermole group, an azadibenzothiophene group, an azadibenzofuran group, an azacarbazole group, an azafluorene group, an azadibenzosilole group, an azadibenzoborole group, an azadibenzophosphole group, an azadibenzoselenophene group, an azadibenzogermole group, an azadibenzothiophene 5-oxide group, an aza-9H-fluoren-9-one group, an azadibenzothiophene 5,5-dioxide group, a pyridine group, a pyrimidine group, a pyrazine group, a pyridazine group, a triazine group, a quinoline group, an isoquinoline group, a quinoxaline group, a quinazoline group, a phenanthroline group, a pyrazole group, an imidazole group, a triazole group, an oxazole group, an isooxazole group, a thiazole group, an isothiazole group, an oxadiazole group, a thiadiazole group, a benzopyrazole group, a benzimidazole group, a benzoxazole group, a benzothiazole group, a benzoxadiazole group, a benzothiadiazole group, a 5,6,7,8-tetrahydroisoquinoline group, a 5,6,7,8-tetrahydroquinoline group, or the like (each unsubstituted or substituted with at least one R₁₀ₐ).

The terms "fluorinated C₁-C₆₀ alkyl group (or fluorinated C₁-C₂₀ alkyl group, or the like)," "fluorinated C₃-C₁₀ cycloalkyl group," "fluorinated C₁-C₁₀ heterocycloalkyl group," and "fluorinated phenyl group" as used herein respectively refer to a C₁-C₆₀ alkyl group (or C₁-C₂₀ alkyl group, or the like), a C₃-C₁₀ cycloalkyl group, a C₁-C₁₀ heterocycloalkyl group, and a phenyl group, each substituted with at least one fluoro group (-F). For example, the term "fluorinated C₁ alkyl group (i.e., fluorinated methyl group)" includes -CF₃, -CF₂H, and -CFH₂. The "fluorinated C₁-C₆₀ alkyl group (or fluorinated C₁-C₂₀ alkyl group, or the like)," the "fluorinated C₃-C₁₀ cycloalkyl group," the "fluorinated C₁-C₁₀ heterocycloalkyl group," or the "fluorinated phenyl group" may be i) a fully fluorinated C₁-C₆₀ alkyl group (or fully fluorinated C₁-C₂₀ alkyl group, or the like), a fully fluorinated C₃-C₁₀ cycloalkyl group, a fully fluorinated C₁-C₁₀ heterocycloalkyl group, or a fully fluorinated phenyl group, wherein, in each group, all hydrogen atoms included therein are substituted with a fluoro group, or ii) a partially fluorinated C₁-C₆₀ alkyl group (or partially fluorinated C₁-C₂₀ alkyl group, or the like), a partially fluorinated C₃-C₁₀ cycloalkyl group, a partially fluorinated C₁-C₁₀ heterocycloalkyl group, or a partially fluorinated phenyl group, wherein, in each group, all hydrogen atoms included therein are not substituted with a fluoro group.

The terms "deuterated C₁-C₆₀ alkyl group (or deuterated C₁-C₂₀ alkyl group, or the like)," "deuterated C₃-C₁₀ cycloalkyl group," "deuterated C₁-C₁₀ heterocycloalkyl group," and "deuterated phenyl group" as used herein respectively refer to a C₁-C₆₀ alkyl group (or C₁-C₂₀ alkyl group, or the like), a C₃-C₁₀ cycloalkyl group, a C₁-C₁₀ heterocycloalkyl group, and a phenyl group, each substituted with at least one deuterium. For example, the term "deuterated C₁ alkyl group (i.e., deuterated methyl group)" includes -CD₃, -CD₂H, and -CDH₂. The "deuterated C₁-C₆₀ alkyl group (or deuterated C₁-C₂₀ alkyl group, or the like)", the "deuterated C₃-C₁₀ cycloalkyl group", the "deuterated C₁-C₁₀ heterocycloalkyl group", or the "deuterated phenyl group" may be i) a fully deuterated C₁-C₆₀ alkyl group (or fully deuterated C₁-C₂₀ alkyl group, or the like), a fully deuterated C₃-C₁₀ cycloalkyl group, a fully deuterated C₁-C₁₀ heterocycloalkyl group, or a fully deuterated phenyl group, in which, in each group, all hydrogen atoms included therein are substituted with deuterium, or ii) a partially deuterated C₁-C₆₀ alkyl group (or partially deuterated C₁-C₂₀ alkyl group, or the like), a partially deuterated C₃-C₁₀ cycloalkyl group, a partially deuterated C₁-C₁₀ heterocycloalkyl group, or a partially deuterated phenyl group, in which, in each group, all hydrogen atoms included therein are not substituted with deuterium.

The term "(C₁-C₂₀ alkyl) 'X' group" as used herein refers to an 'X' group that is substituted with at least one C₁-C₂₀ alkyl group. For example, the term "(C₁-C₂₀ alkyl)C₃-C₁₀ cycloalkyl group" as used herein refers to a C₃-C₁₀ cycloalkyl group substituted with at least one C₁-C₂₀ alkyl group, and the term "(C₁-C₂₀ alkyl)phenyl group" as used herein refers to a phenyl group substituted with at least one C₁-C₂₀ alkyl group. An example of a (C₁ alkyl)phenyl group is a tolyl group.

The terms "an azaindole group, an azabenzoborole group, an azabenzophosphole group, an azaindene group, an azabenzosilole group, an azabenzogermole group, an azabenzothiophene group, an azabenzoselenophene group, an azabenzofuran group, an azacarbazole group, an azadibenzoborole group, an azadibenzophosphole group, an azafluorene group, an azadibenzosilole group, an azadibenzogermole group, an azadibenzothiophene group, an azadibenzoselenophene group, an azadibenzofuran group, an azadibenzothiophene 5-oxide group, an aza-9H-fluoren-9-one group, and an azadibenzothiophene 5,5-dioxide group" as used herein respectively refer to heterocyclic groups having the same backbones as "an indole group, a benzoborole group, a benzophosphole group, an indene group, a benzosilole group, a benzogermole group, a benzothiophene group, a benzoselenophene group, a benzofuran group, a carbazole group, a dibenzoborole group, a dibenzophosphole group, a fluorene group, a dibenzosilole group, a dibenzogermole group, a dibenzothiophene group, a dibenzoselenophene group, a dibenzofuran group, a dibenzothiophene 5-oxide group, a 9H-fluoren-9-one group, and a dibenzothiophene 5,5-dioxide group," in which, in each group, at least one carbon atom selected from ring-forming carbon atoms is substituted with a nitrogen atom.

At least one substituent of the substituted C₅-C₃₀ carbocyclic group, the substituted C₁-C₃₀ heterocyclic group, the substituted C₁-C₆₀ alkyl group, the substituted C₂-C₆₀ alkenyl group, the substituted C₂-C₆₀ alkynyl group, the substituted C₁-C₆₀ alkoxy group, the substituted C₁-C₆₀ alkylthio group, the substituted C₃-C₁₀ cycloalkyl group, the substituted C₁-C₁₀ heterocycloalkyl group, the substituted C₃-C₁₀ cycloalkenyl group, the substituted C₁-C₁₀ heterocycloalkenyl group, the substituted C₆-C₆₀ aryl group, the substituted C₇-C₆₀ alkyl aryl group, the substituted C₇-C₆₀ aryl alkyl group, the substituted C₆-C₆₀ aryloxy group, the substituted C₆-C₆₀ arylthio group, the substituted C₁-C₆₀ heteroaryl group, the substituted C₂-C₆₀ alkyl heteroaryl group, the substituted C₂-C₆₀ heteroaryl alkyl group, the substituted C₁-C₆₀ heteroaryloxy group, the substituted C₁-C₆₀ heteroarylthio group, the substituted monovalent non-aromatic condensed polycyclic group, and the substituted monovalent non-aromatic condensed heteropolycyclic group may each independently be:
deuterium, -F, -Cl, -Br, -I, -SF₅, -CD₃, -CD₂H, -CDH₂, -CF₃, -CF₂H, - CFH₂, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, a C₁-C₆₀ alkyl group, a C₂-C₆₀ alkenyl group, a C₂-C₆₀ alkynyl group, a C₁-C₆₀ alkoxy group, or a C₁-C₆₀ alkylthio group;
a C₁-C₆₀ alkyl group, a C₂-C₆₀ alkenyl group, a C₂-C₆₀ alkynyl group, a C₁-C₆₀ alkoxy group, or a C₁-C₆₀ alkylthio group, each substituted with deuterium, -F, -Cl, -Br, -I, -SF₅, -CD₃, -CD₂H, -CDH₂, -CF₃, -CF₂H, -CFH₂, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, a C₃-C₁₀ cycloalkyl group, a C₁-C₁₀ heterocycloalkyl group, a C₃-C₁₀ cycloalkenyl group, a C₁-C₁₀ heterocycloalkenyl group, a C₆-C₆₀ aryl group, a C₇-C₆₀ alkyl aryl group, a C₆-C₆₀ aryloxy group, a C₆-C₆₀ arylthio group, a C₁-C₆₀ heteroaryl group, a C₂-C₆₀ alkyl heteroaryl group, a C₁-C₆₀ heteroaryloxy group, a C₁-C₆₀ heteroarylthio group, a monovalent non-aromatic condensed polycyclic group, a monovalent non-aromatic condensed heteropolycyclic group, -Si(Q₁₁)(Q₁₂)(Q₁₃), -Ge(Q₁₁)(Q₁₂)(Q₁₃), -N(Q₁₄)(Q₁₅), -B(Q₁₆)(Q₁₇), - P(Q₁₈)(Q₁₉), -P(=O)(Q₁₈)(Q₁₉), or a combination thereof;
a C₃-C₁₀ cycloalkyl group, a C₁-C₁₀ heterocycloalkyl group, a C₃-C₁₀ cycloalkenyl group, a C₁-C₁₀ heterocycloalkenyl group, a C₆-C₆₀ aryl group, a C₇-C₆₀ alkyl aryl group, a C₆-C₆₀ aryloxy group, a C₆-C₆₀ arylthio group, a C₁-C₆₀ heteroaryl group, a C₂-C₆₀ alkyl heteroaryl group, a C₁-C₆₀ heteroaryloxy group, a C₁-C₆₀ heteroarylthio group, a monovalent non-aromatic condensed polycyclic group, or a monovalent non-aromatic condensed heteropolycyclic group;
a C₃-C₁₀ cycloalkyl group, a C₁-C₁₀ heterocycloalkyl group, a C₃-C₁₀ cycloalkenyl group, a C₁-C₁₀ heterocycloalkenyl group, a C₆-C₆₀ aryl group, a C₇-C₆₀ alkyl aryl group, a C₆-C₆₀ aryloxy group, a C₆-C₆₀ arylthio group, a C₁-C₆₀ heteroaryl group, a C₂-C₆₀ alkyl heteroaryl group, a C₁-C₆₀ heteroaryloxy group, a C₁-C₆₀ heteroarylthio group, a monovalent non-aromatic condensed polycyclic group, or a monovalent non-aromatic condensed heteropolycyclic group, each substituted with deuterium, -F, -Cl, -Br, -I, -SF₅, -CD₃, -CD₂H, - CDH₂, -CF₃, -CF₂H, -CFH₂, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, a C₁-C₆₀ alkyl group, a C₂-C₆₀ alkenyl group, a C₂-C₆₀ alkynyl group, a C₁-C₆₀ alkoxy group, a C₁-C₆₀ alkylthio group, a C₃-C₁₀ cycloalkyl group, a C₁-C₁₀ heterocycloalkyl group, a C₃-C₁₀ cycloalkenyl group, a C₁-C₁₀ heterocycloalkenyl group, a C₆-C₆₀ aryl group, a C₇-C₆₀ alkyl aryl group, a C₇-C₆₀ aryl alkyl group, a C₆-C₆₀ aryloxy group, a C₆-C₆₀ arylthio group, a C₁-C₆₀ heteroaryl group, a C₂-C₆₀ alkyl heteroaryl group, a C₂-C₆₀ heteroaryl alkyl group, a C₁-C₆₀ heteroaryloxy group, a C₁-C₆₀ heteroarylthio group, a monovalent non-aromatic condensed polycyclic group, a monovalent non-aromatic condensed heteropolycyclic group, - Si(Q₂₁)(Q₂₂)(Q₂₃), -Ge(Q₂₁)(Q₂₂)(Q₂₃), -N(Q₂₄)(Q₂₅), -B(Q₂₆)(Q₂₇), -P(Q₂₈)(Q₂₉), -P(=O)(Q₂₈)(Q₂₉), or a combination thereof;
-Si(Q₃₁)(Q₃₂)(Q₃₃), -Ge(Q₃₁)(Q₃₂)(Q₃₃), -N(Q₃₄)(Q₃₅), -B(Q₃₆)(Q₃₇), - P(=O)(Q₃₈)(Q₃₉), or -P(Q₃₈)(Q₃₉); or
a combination thereof.

Q₁ to Q₉, Q₁₁ to Q₁₉, Q₂₁ to Q₂₉, and Q₃₁ to Q₃₉ described herein may each independently be:
hydrogen, deuterium, or -F; or
a C₁-C₆₀ alkyl group, a C₂-C₆₀ alkenyl group, a C₂-C₆₀ alkynyl group, a C₁-C₆₀ alkoxy group, a C₁-C₆₀ alkylthio group, a C₃-G₁₀ cycloalkyl group, a C₁-C₁₀ heterocycloalkyl group, a C₃-C₁₀ cycloalkenyl group, a C₁-C₁₀ heterocycloalkenyl group, a C₆-C₆₀ aryl group, a C₇-C₆₀ alkyl aryl group, a C₇-C₆₀ aryl alkyl group, a C₆-C₆₀ aryloxy group, a C₆-C₆₀ arylthio group, a C₁-C₆₀ heteroaryl group, a C₂-C₆₀ alkyl heteroaryl group, a C₂-C₆₀ heteroaryl alkyl group, a C₁-C₆₀ heteroaryloxy group, a C₁-C₆₀ heteroarylthio group, a monovalent non-aromatic condensed polycyclic group, or a monovalent non-aromatic condensed heteropolycyclic group, each unsubstituted or substituted with deuterium, -F, a cyano group, a C₁-C₆₀ alkyl group, a C₆-C₆₀ aryl group, or a combination thereof.

Hereinafter, organometallic compounds represented by Formula 1 and light-emitting devices according to exemplary embodiments will be described in further detail with reference to Synthesis Examples and Examples. However, embodiments are not limited thereto. The wording "B was used instead of A" used in describing Synthesis Examples means that an amount of A used was identical to an amount of B used, in terms of a molar equivalent.

### EXAMPLES

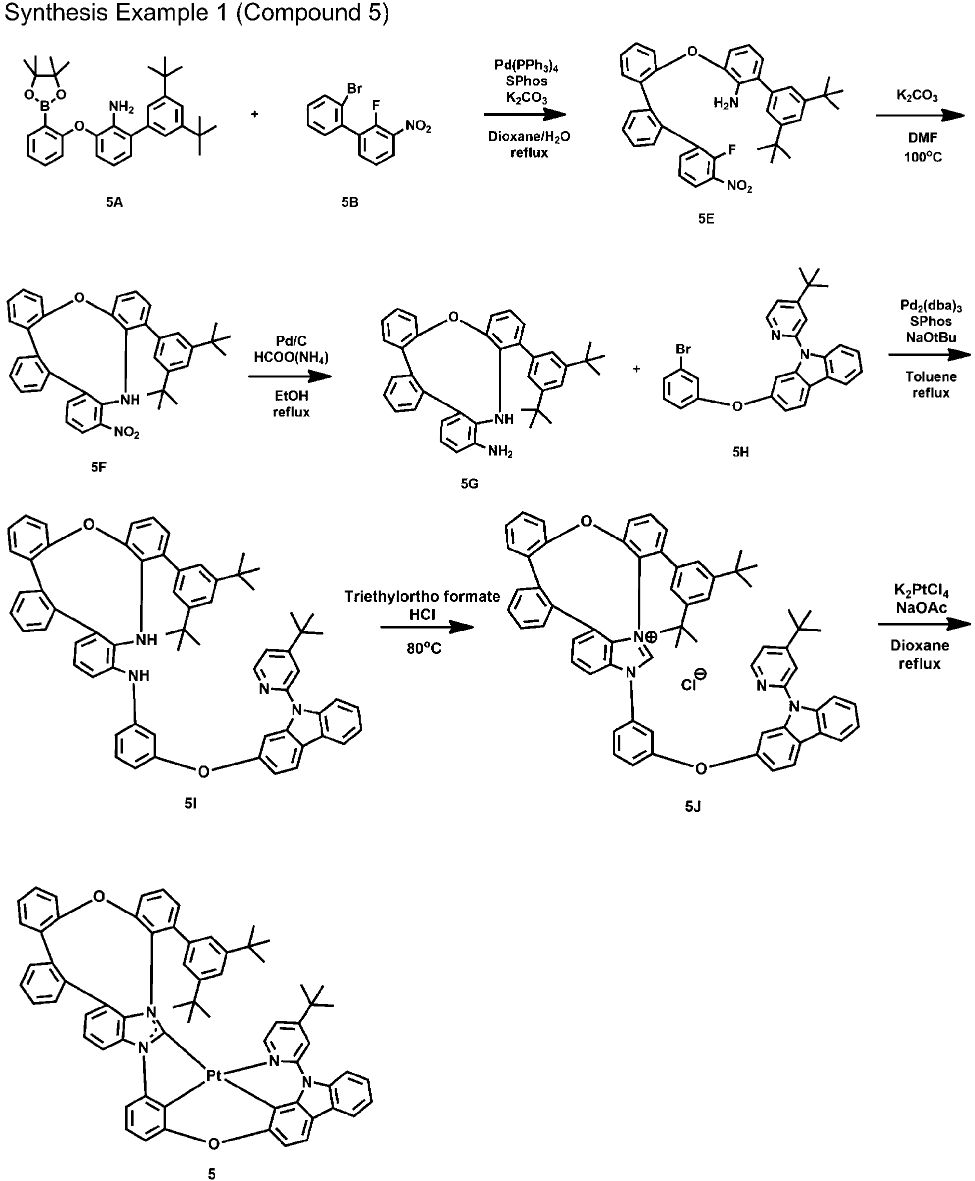

### Synthesis of Compound 5E

Compound 5A (8.00 grams (g), 27.0 millimoles (mmol)), Compound 5B (16.2 g, 32.4 mmol), tetrakis(triphenylphosphine)palladium(0) (Pd(PPh₃)₄) (3.12 g, 2.70 mmol), 2-dicyclohexylphosphino-2',6'-dimethoxybiphenyl (SPhos) (2.22 g, 5.40 mmol), and K₂CO₃ (7.47 g, 54.0 mmol) were added to a round-bottom flask, combined with 1,4-dioxane/H₂O (120 mL/30 mL), and then stirred under reflux at 110°C for 16 hours. After the reaction was completed, the temperature was lowered to room temperature, and ethyl acetate and a saturated ammonium chloride aqueous solution were added to the reaction mixture to obtain an organic layer. The organic layer was extracted using ethyl acetate, dried using anhydrous MgSO₄, and then filtered. A filtrate obtained therefrom was concentrated under reduced pressure and purified through silica gel column chromatography to obtain 9.0 g (yield of 57 %) of Compound 5E.

Liquid chromatography-mass spectrometry (LC-MS): 589.27 [M+H]⁺.

### Synthesis of Compound 5F

Compound 5E (9.0 g, 15.3 mmol) and K₂CO₃ (6.34 g, 45.9 mmol) were added to a round-bottom flask, combined with dimethylformamide (DMF) (160 mL), and then stirred at 100°C for 13 hours. After the reaction was completed, the temperature was lowered to room temperature, and ethyl acetate and a saturated ammonium chloride aqueous solution were added to the reaction mixture to obtain an organic layer. The organic layer was extracted using ethyl acetate, dried using anhydrous MgSO₄, and then filtered. A filtrate obtained therefrom was concentrated under reduced pressure and purified through silica gel column chromatography to obtain 4.2 g (yield of 48 %) of Compound 5F.

LC-MS: 568.27 [M+H]⁺.

### Synthesis of Compound 5G

Compound 5F (4.20 g, 7.39 mmol), palladium on carbon (Pd/C) (10 wt% Pd on carbon, 0.79 g, 0.74 mmol), and ammonium formate (9.31 g, 148 mmol) were added to a round-bottom flask, combined with ethanol (75 mL), and then stirred under reflux at 80°C for 13 hours. After the reaction was completed, the temperature was lowered to room temperature, and ethyl acetate and a saturated ammonium chloride aqueous solution were added to the reaction mixture to obtain an organic layer. The organic layer was extracted using ethyl acetate, dried using anhydrous MgSO₄, and then filtered. A filtrate obtained therefrom was concentrated under reduced pressure and purified through silica gel column chromatography to obtain 3.39 g (yield of 85 %) of Compound 5G.

LC-MS: 538.29 [M+H]⁺.

### Synthesis of Compound 5I

Compound 5G (3.39 g, 6.29 mmol), Compound 5H (3.11 g, 6.61 mmol), tris(dibenzylideneacetone)dipalladium(0) (Pd₂(dba)₃) (0.58 g, 0.63 mmol), SPhos (0.52 g, 1.26 mmol), and sodium tert-butoxide (NaOtBu) (0.91 g, 9.44 mmol) were added to a round-bottom flask, combined with toluene (65 mL), and then stirred under reflux at 110 °C for 13 hours. After the reaction was completed, the temperature was lowered to room temperature, and ethyl acetate and a saturated ammonium chloride aqueous solution were added to the reaction mixture to obtain an organic layer. The organic layer was extracted using ethyl acetate, dried using anhydrous MgSO₄, and then filtered. A filtrate obtained therefrom was concentrated under reduced pressure and purified through silica gel column chromatography to obtain 5.2 g (yield of 89 %) of Compound 5I.

LC-MS: 929.47 [M+H]⁺.

### Synthesis of Compound 5J

Compound 5I (5.2 g, 5.60 mmol) was added to a round-bottom flask and mixed with triethylorthoformate (50 mL), and 35 wt% hydrochloric acid (0.58 ml, 6.72 mmol) was added thereto, followed by stirring at 80°C for 3 hours. After completion of the reaction, the temperature was lowered to room temperature, and the reaction mixture was concentrated under reduced pressure and purified through silica gel column chromatography to obtain 5.19 g (yield of 95 %) of Compound 5J.

### Synthesis of Compound 5

Compound 5J (5.19 g, 5.32 mmol), K₂PtCl₄ (2.52 g, 5.85 mmol), and sodium acetate (NaOAc) (1.57 g, 16.0 mmol) were added to a round-bottom flask, combined with dioxane (100 mL), and then stirred under reflux at 100°C for 12 hours. After the reaction was completed, the temperature was lowered to room temperature, and ethyl acetate and a saturated ammonium chloride aqueous solution were added to the reaction mixture to obtain an organic layer. The organic layer was extracted using ethyl acetate, dried using anhydrous MgSO₄, and then filtered. A filtrate obtained therefrom was concentrated under reduced pressure and purified through silica gel column chromatography to obtain 3.4 g (yield of 56 %) of Compound 5.

LC-MS: 1132.28 [M+H]⁺.

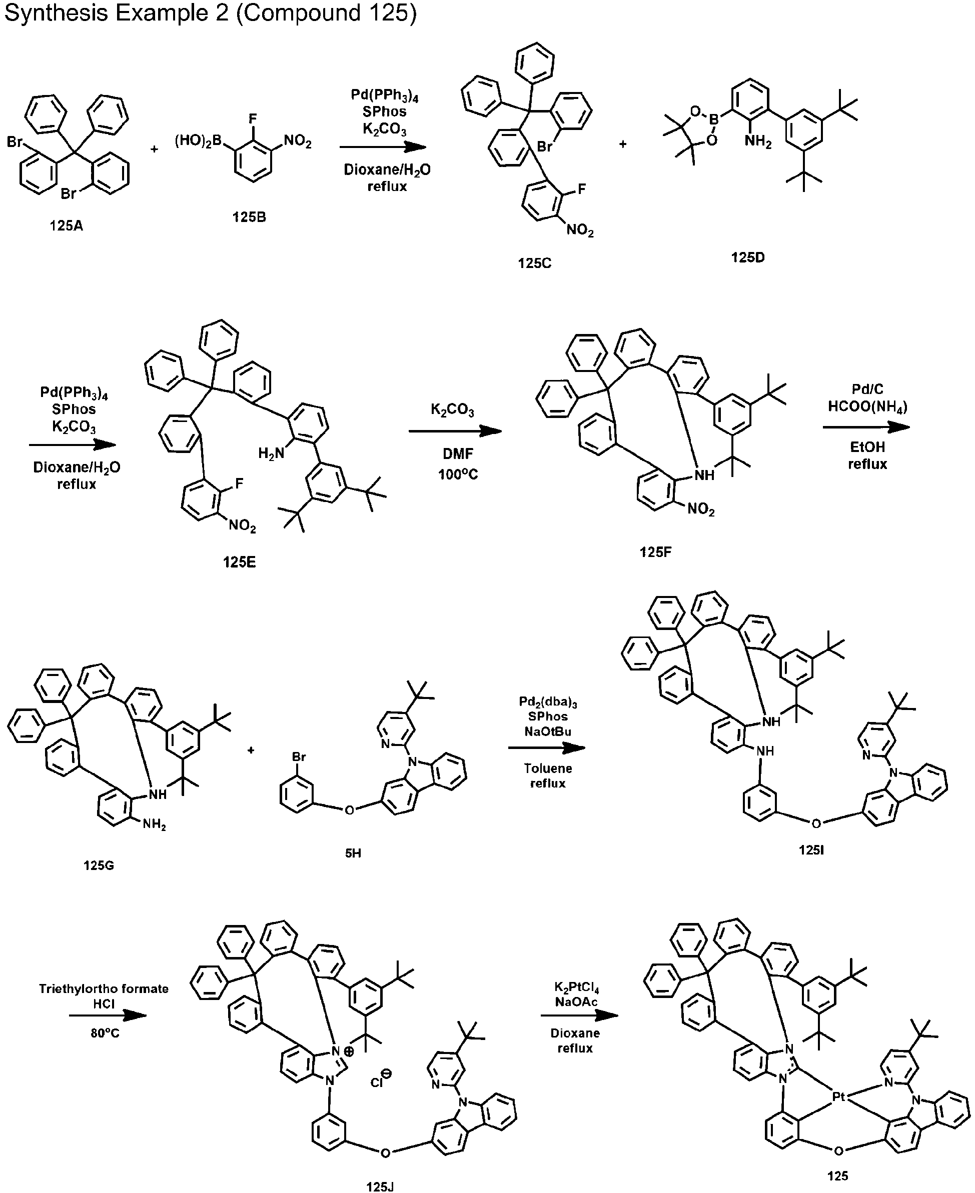

### Synthesis of Compound 125C

Compound 125A (10.0 g, 20.9 mmol), Compound 125B (5.8 g, 31.4 mmol), Pd(PPh₃)₄ (2.42 g, 2.09 mmol), SPhos (1.72 g, 4.18 mmol), and K₂CO₃ (5.78 g, 41.8 mmol) were added to a round-bottom flask, combined with 1,4-dioxane/H₂O (80 mL/20 mL), and then stirred under reflux at 110 °C for 16 hours. After the reaction was completed, the temperature was lowered to room temperature, and ethyl acetate and a saturated ammonium chloride aqueous solution were added to the reaction mixture to obtain an organic layer. The organic layer was extracted using ethyl acetate, dried using anhydrous MgSO₄, and then filtered. A filtrate obtained therefrom was concentrated under reduced pressure and purified through silica gel column chromatography to obtain 7.50 g (yield of 67 %) of Compound 125C.

LC-MS: 538.05 [M+H]⁺.

### Synthesis of Compound 125E

Compound 125C (7.50 g, 13.9 mmol), Compound 125D (8.51 g, 20.9 mmol), Pd(PPh₃)₄ (1.61 g, 1.39 mmol), SPhos (1.14 g, 2.79 mmol), and K₂CO₃ (3.85 g, 27.9 mmol) were added to a round-bottom flask, combined with 1,4-dioxane/H₂O (60 mL/15 mL), and then stirred under reflux at 110°C for 16 hours. After the reaction was completed, the temperature was lowered to room temperature, and ethyl acetate and a saturated ammonium chloride aqueous solution were added to the reaction mixture to obtain an organic layer. The organic layer was extracted using ethyl acetate, dried using anhydrous MgSO₄, and then filtered. A filtrate obtained therefrom was concentrated under reduced pressure and purified through silica gel column chromatography to obtain 8.50 g (yield of 83 %) of Compound 125E.

LC-MS: 739.35 [M+H]⁺.

### Synthesis of Compound 125F

Compound 125E (8.5 g, 11.5 mmol) and K₂CO₃ (4.77 g, 34.5 mmol) were added to a round-bottom flask, combined with DMF (120 mL), and then stirred at 100°C for 16 hours. After the reaction was completed, the temperature was lowered to room temperature, and ethyl acetate and a saturated ammonium chloride aqueous solution were added to the reaction mixture to obtain an organic layer. The organic layer was extracted using ethyl acetate, dried using anhydrous MgSO₄, and then filtered. A filtrate obtained therefrom was concentrated under reduced pressure and purified through silica gel column chromatography to obtain 5.30 g (yield of 64 %) of Compound 125F.

LC-MS: 719.36 [M+H]⁺.

### Synthesis of Compound 125G

Compound 125F (5.30 g, 7.37 mmol), Pd/C (10 wt% Pd on carbon, 0.78 g, 0.74 mmol), and ammonium formate (9.30 g, 147 mmol) were added to a round-bottom flask, combined with ethanol (75 mL), and then stirred under reflux at 80 °C for 4 hours. After the reaction was completed, the temperature was lowered to room temperature, and ethyl acetate and a saturated ammonium chloride aqueous solution were added to the reaction mixture to obtain an organic layer. The organic layer was extracted using ethyl acetate, dried using anhydrous MgSO₄, and then filtered. A filtrate obtained therefrom was concentrated under reduced pressure and purified through silica gel column chromatography to obtain 3.60 g (yield of 71 %) of Compound 125G.

LC-MS: 689.37 [M+H]⁺.

### Synthesis of Compound 125I

Compound 125G (3.60 g, 5.23 mmol), Compound 5H (2.59 g, 5.49 mmol), Pd₂(dba)₃ (0.48 g, 0.52 mmol), SPhos (0.43 g, 1.05 mmol), and NaOtBu (0.75 g, 7.84 mmol) were added to a round-bottom flask, combined with toluene (55 mL), and then stirred under reflux at 110°C for 15 hours. After the reaction was completed, the temperature was lowered to room temperature, and ethyl acetate and a saturated ammonium chloride aqueous solution were added to the reaction mixture to obtain an organic layer. The organic layer was extracted using ethyl acetate, dried using anhydrous MgSO₄, and then filtered. A filtrate obtained therefrom was concentrated under reduced pressure and purified through silica gel column chromatography to obtain 4.80 g (yield of 85 %) of Compound 125I.

LC-MS: 1079.55 [M+H]⁺.

### Synthesis of Compound 125J

Compound 125I (4.80 g, 4.45 mmol) was added to a round-bottom flask and mixed with triethylorthoformate (40 mL), and 35 wt% hydrochloric acid (0.46 ml, 5.34 mmol) was added thereto, followed by stirring at 80°C for 3 hours. After completion of the reaction, the temperature was lowered to room temperature, and the reaction mixture was concentrated under reduced pressure and purified through silica gel column chromatography to obtain 4.90 g (yield of 98 %) of Compound 125J.

### Synthesis of Compound 125

Compound 125J (4.90 g, 4.35 mmol), K₂PtCl₄ (2.07 g, 4.79 mmol), and NaOAc (1.28 g, 13.1 mmol) were added to a round-bottom flask, combined with dioxane (90 mL), and then stirred under reflux at 100°C for 15 hours. After the reaction was completed, the temperature was lowered to room temperature, and ethyl acetate and a saturated ammonium chloride aqueous solution were added to the reaction mixture to obtain an organic layer. The organic layer was extracted using ethyl acetate, dried using anhydrous MgSO₄, and then filtered. A filtrate obtained therefrom was concentrated and purified through silica gel column chromatography to obtain 3.08 g (yield of 55 %) of Compound 125.

LC-MS: 1282.48 [M+H]⁺.

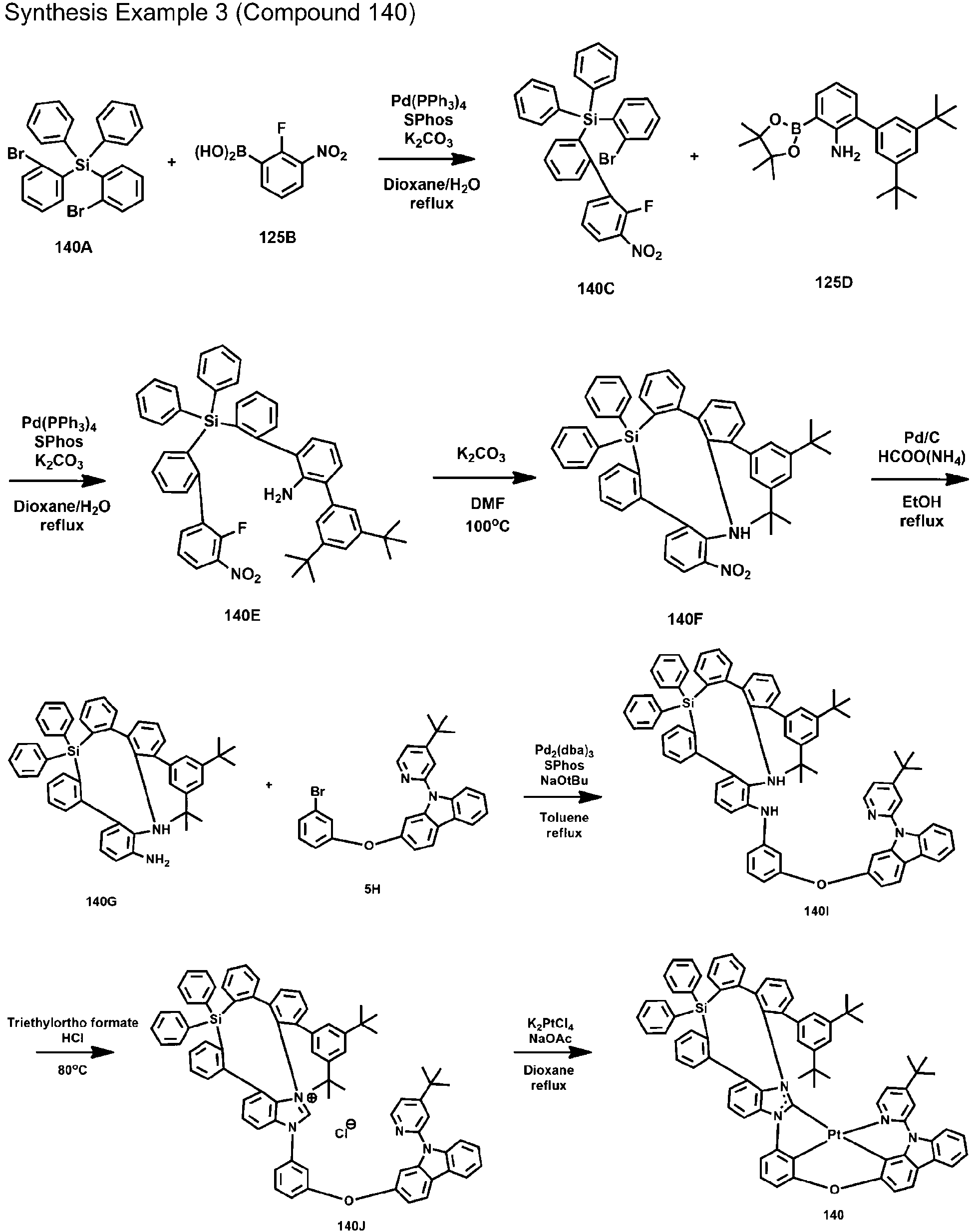

### Synthesis of Compound 140C

Compound 140A (12.0 g, 24.3 mmol), Compound 125B (6.73 g, 36.4 mmol), Pd(PPh₃)₄ (2.80 g, 2.43 mmol), SPhos (1.99 g, 4.86 mmol), and K₂CO₃ (6.71 g, 48.6 mmol) were added to a round-bottom flask, combined with 1,4-dioxane/H₂O (100 mL/25 mL), and then stirred under reflux at 110°C for 15 hours. After the reaction was completed, the temperature was lowered to room temperature, and ethyl acetate and a saturated ammonium chloride aqueous solution were added to the reaction mixture to obtain an organic layer. The organic layer was extracted using ethyl acetate, dried using anhydrous MgSO₄, and then filtered. A filtrate obtained therefrom was concentrated under reduced pressure and purified through silica gel column chromatography to obtain 8.60 g (yield of 64 %) of Compound 140C.

LC-MS: 554.05 [M+H]⁺.

### Synthesis of Compound 140E

Compound 140C (8.60 g, 15.5 mmol), Compound 125D (9.48 g, 23.3 mmol), Pd(PPh₃)₄ (1.79 g, 1.55 mmol), SPhos (1.27 g, 3.10 mmol), and K₂CO₃ (4.29 g, 31.0 mmol) were added to a round-bottom flask, combined with 1,4-dioxane/H₂O (65 mL/15 mL), and then stirred under reflux at 110°C for 15 hours. After the reaction was completed, the temperature was lowered to room temperature, and ethyl acetate and a saturated ammonium chloride aqueous solution were added to the reaction mixture to obtain an organic layer. The organic layer was extracted using ethyl acetate, dried using anhydrous MgSO₄, and then filtered. A filtrate obtained therefrom was concentrated under reduced pressure and purified through silica gel column chromatography to obtain 8.35 g (yield of 71 %) of Compound 140E.

LC-MS: 755.33 [M+H]⁺.

### Synthesis of Compound 140F

Compound 140E (8.35 g, 11.1 mmol) and K₂CO₃ (4.59 g, 33.2 mmol) were added to a round-bottom flask, combined with DMF (110 mL), and then stirred at 100°C for 16 hours. After the reaction was completed, the temperature was lowered to room temperature, and ethyl acetate and a saturated ammonium chloride aqueous solution were added to the reaction mixture to obtain an organic layer. The organic layer was extracted using ethyl acetate, dried using anhydrous MgSO₄, and then filtered. A filtrate obtained therefrom was concentrated under reduced pressure and purified through silica gel column chromatography to obtain 4.70 g (yield of 58 %) of Compound 140F.

LC-MS: 735.32 [M+H]⁺.

### Synthesis of Compound 140G

Compound 140F (4.70 g, 6.39 mmol), Pd/C (10 wt% Pd on carbon, 0.68 g, 0.64 mmol), and ammonium formate (8.06 g, 128 mmol) were added to a round-bottom flask, combined with ethanol (65 mL), and then stirred under reflux at 80°C for 4 hours. After the reaction was completed, the temperature was lowered to room temperature, and ethyl acetate and a saturated ammonium chloride aqueous solution were added to the reaction mixture to obtain an organic layer. The organic layer was extracted using ethyl acetate, dried using anhydrous MgSO₄, and then filtered. A filtrate obtained therefrom was concentrated under reduced pressure and purified through silica gel column chromatography to obtain 3.82 g (yield of 85 %) of Compound 140G.

LC-MS: 705.36 [M+H]⁺.

### Synthesis of Compound 140I

Compound 140G (3.82 g, 5.42 mmol), Compound 5H (2.68 g, 5.69 mmol), Pd₂(dba)₃ (0.50 g, 0.54 mmol), SPhos (0.44 g, 1.08 mmol), and NaOtBu (0.78 g, 8.13 mmol) were added to a round-bottom flask, combined with toluene (55 mL), and then stirred under reflux at 110°C for 17 hours. After the reaction was completed, the temperature was lowered to room temperature, and ethyl acetate and a saturated ammonium chloride aqueous solution were added to the reaction mixture to obtain an organic layer. The organic layer was extracted using ethyl acetate, dried using anhydrous MgSO₄, and then filtered. A filtrate obtained therefrom was concentrated under reduced pressure and purified through silica gel column chromatography to obtain 4.50 g (yield of 76 %) of Compound 140I.

LC-MS: 1095.52 [M+H]⁺.

### Synthesis of Compound 140J

Compound 140I (4.50 g, 4.11 mmol) was added to a round-bottom flask and mixed with triethylorthoformate (35 mL), and 35 wt% hydrochloric acid (0.42 ml, 4.93 mmol) was added thereto, followed by stirring at 80°C for 3 hours. After completion of the reaction, the temperature was lowered to room temperature, and the reaction mixture was concentrated under reduced pressure and purified through silica gel column chromatography to obtain 4.53 g (yield of 97 %) of Compound 140J.

### Synthesis of Compound 140

Compound 140J (4.53 g, 3.97 mmol), K₂PtCl₄ (1.88 g, 4.36 mmol), and NaOAc (1.17 g, 11.9 mmol) were added to a round-bottom flask, combined with dioxane (80 mL), and then stirred under reflux at 100°C for 17 hours. After the reaction was completed, the temperature was lowered to room temperature, and ethyl acetate and a saturated ammonium chloride aqueous solution were added to the reaction mixture to obtain an organic layer. The organic layer was extracted using ethyl acetate, dried using anhydrous MgSO₄, and then filtered. A filtrate obtained therefrom was concentrated under reduced pressure and purified through silica gel column chromatography to obtain 2.66 g (yield of 52 %) of Compound 140.

LC-MS: 1298.47 [M+H]⁺.

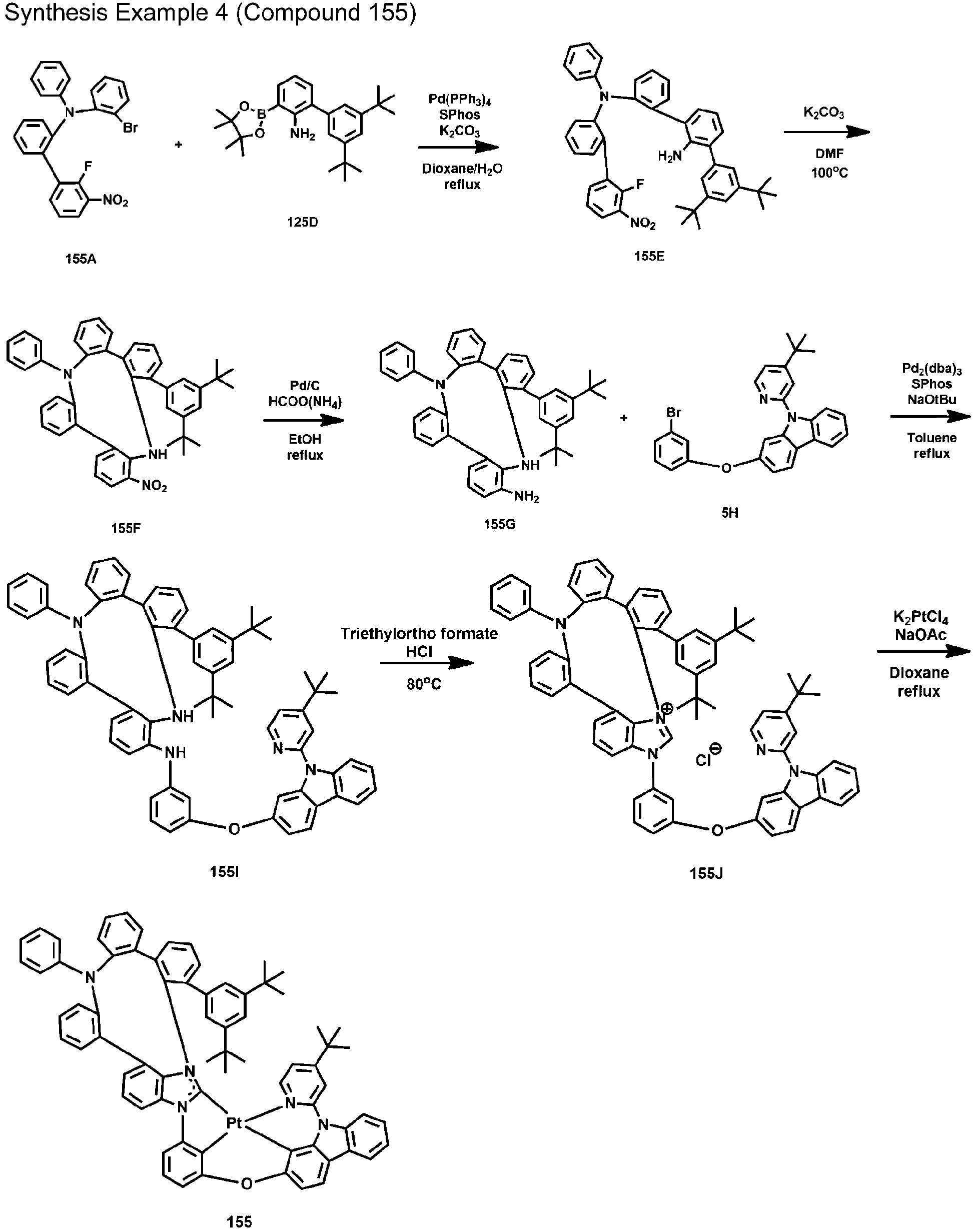

### Synthesis of Compound 155E

Compound 155A (4.20 g, 9.07 mmol), Compound 125D (5.54 g, 13.6 mmol), Pd(PPh₃)₄ (1.05 g, 0.91 mmol), SPhos (0.74 g, 1.81 mmol), and K₂CO₃ (2.51 g, 18.1 mmol) were added to a round-bottom flask, combined with 1,4-dioxane/H₂O (40 mL/10 mL), and then stirred under reflux at 110°C for 19 hours. After the reaction was completed, the temperature was lowered to room temperature, and ethyl acetate and a saturated ammonium chloride aqueous solution were added to the reaction mixture to obtain an organic layer. The organic layer was extracted using ethyl acetate, dried using anhydrous MgSO₄, and then filtered. A filtrate obtained therefrom was concentrated under reduced pressure and purified through silica gel column chromatography to obtain 5.00 g (yield of 83 %) of Compound 155E.

LC-MS: 664.32 [M+H]⁺.

### Synthesis of Compound 155F

Compound 155E (5.00 g, 7.53 mmol) and K₂CO₃ (3.12 g, 22.6 mmol) were added to a round-bottom flask, combined with DMF (75 mL), and then stirred at 100°C for 16 hours. After the reaction was completed, the temperature was lowered to room temperature, and ethyl acetate and a saturated ammonium chloride aqueous solution were added to the reaction mixture to obtain an organic layer. The organic layer was extracted using ethyl acetate, dried using anhydrous MgSO₄, and then filtered. A filtrate obtained therefrom was concentrated under reduced pressure and purified through silica gel column chromatography to obtain 2.05 g (yield of 42 %) of Compound 155F.

LC-MS: 644.32 [M+H]⁺.

### Synthesis of Compound 155G

Compound 155F (2.05 g, 3.18 mmol), Pd/C (10 wt% Pd on carbon, 0.34 g, 0.32 mmol), and ammonium formate (4.02 g, 63.7 mmol) were added to a round-bottom flask, combined with ethanol (32 mL), and then stirred under reflux at 80°C for 3 hours. After the reaction was completed, the temperature was lowered to room temperature, and ethyl acetate and a saturated ammonium chloride aqueous solution were added to the reaction mixture to obtain an organic layer. The organic layer was extracted using ethyl acetate, dried using anhydrous MgSO₄, and then filtered. A filtrate obtained therefrom was concentrated under reduced pressure and purified through silica gel column chromatography to obtain 1.66 g (yield of 85 %) of Compound 155G.

LC-MS: 614.33 [M+H]⁺.

### Synthesis of Compound 155I

Compound 155G (1.66 g, 2.70 mmol), Compound 5H (1.34 g, 2.84 mmol), Pd₂(dba)₃ (0.25 g, 0.27 mmol), SPhos (0.22 g, 0.54 mmol), and NaOtBu (0.39 g, 4.06 mmol) were added to a round-bottom flask, combined with toluene (30 mL), and then stirred under reflux at 110°C for 15 hours. After the reaction was completed, the temperature was lowered to room temperature, and ethyl acetate and a saturated ammonium chloride aqueous solution were added to the reaction mixture to obtain an organic layer. The organic layer was extracted using ethyl acetate, dried using anhydrous MgSO₄, and then filtered. A filtrate obtained therefrom was concentrated under reduced pressure and purified through silica gel column chromatography to obtain 1.80 g (yield of 66 %) of Compound 155I.

LC-MS: 1004.51 [M+H]⁺.

### Synthesis of Compound 155J

Compound 155I (1.80 g, 1.79 mmol) was added to a round-bottom flask and mixed with triethylorthoformate (15 mL), and 35 wt% hydrochloric acid (0.18 ml, 2.15 mmol) was added thereto, followed by stirring at 80°C for 3 hours. After completion of the reaction, the temperature was lowered to room temperature, and the reaction mixture was concentrated under reduced pressure and purified through silica gel column chromatography to obtain 1.65 g (yield of 88 %) of Compound 155J.

### Synthesis of Compound 155

Compound 155J (1.65 g, 1.57 mmol), K₂PtCl₄ (0.75 g, 1.73 mmol), and NaOAc (0.46 g, 4.71 mmol) were added to a round-bottom flask, combined with dioxane (30 mL), and then stirred under reflux at 100°C for 18 hours. After the reaction was completed, the temperature was lowered to room temperature, and ethyl acetate and a saturated ammonium chloride aqueous solution were added to the reaction mixture to obtain an organic layer. The organic layer was extracted using ethyl acetate, dried using anhydrous MgSO₄, and then filtered. A filtrate obtained therefrom was concentrated under reduced pressure and purified through silica gel column chromatography to obtain 1.10 g (yield of 58 %) of Compound 155.

LC-MS: 1207.45 [M+H]⁺.

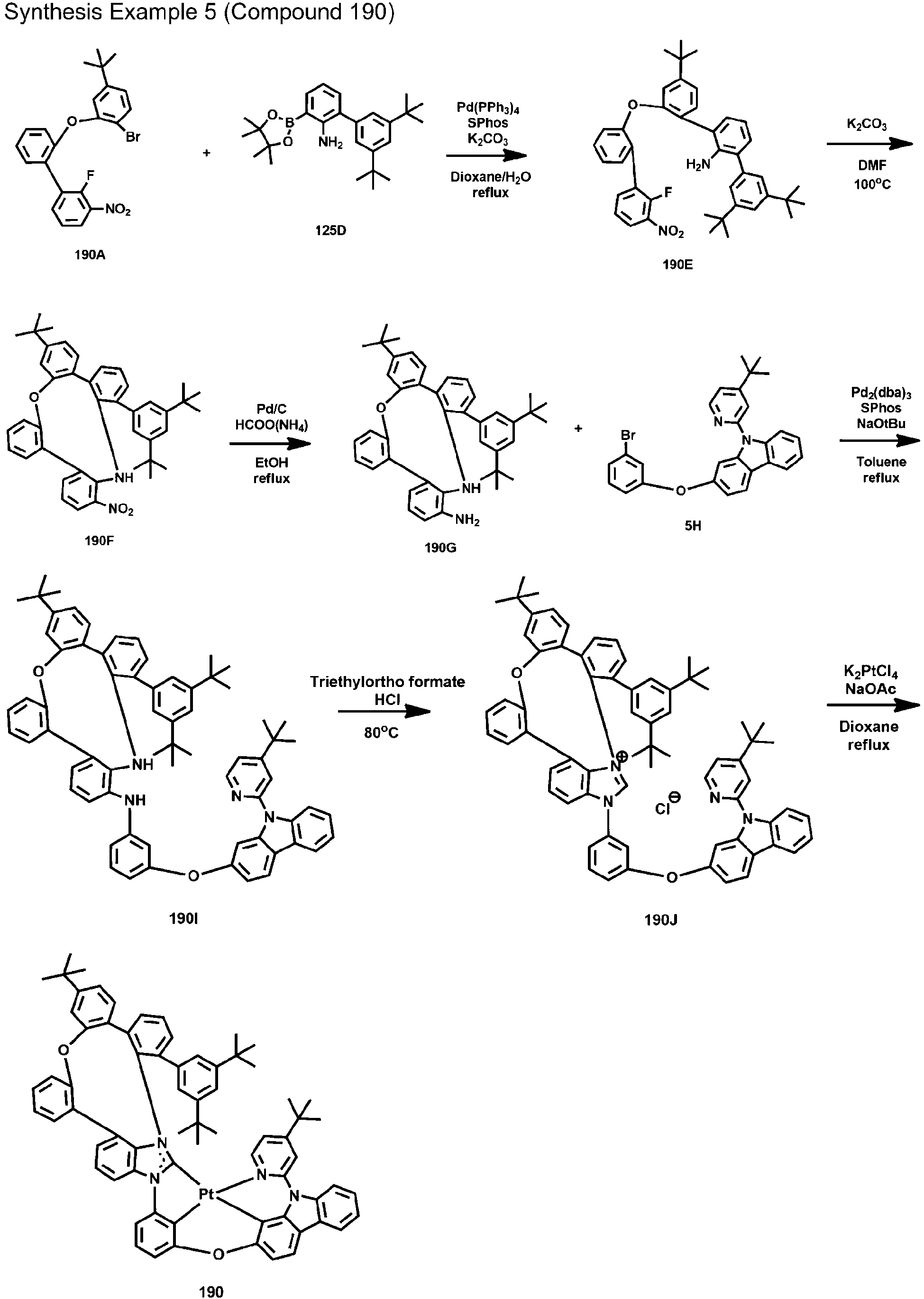

### Synthesis of Compound 190E

Compound 190A (5.00 g, 11.3 mmol), Compound 125D (6.88 g, 16.9 mmol), Pd(PPh₃)₄ (1.30 g, 1.13 mmol), SPhos (0.92 g, 2.25 mmol), and K₂CO₃ (3.11 g, 22.5 mmol) were added to a round-bottom flask, combined with 1,4-dioxane/H₂O (40 mL/10 mL), and then stirred under reflux at 110°C for 5 hours. After the reaction was completed, the temperature was lowered to room temperature, and ethyl acetate and a saturated ammonium chloride aqueous solution were added to the reaction mixture to obtain an organic layer. The organic layer was extracted using ethyl acetate, dried using anhydrous MgSO₄, and then filtered. A filtrate obtained therefrom was concentrated under reduced pressure and purified through silica gel column chromatography to obtain 7.15 g (yield of 99 %) of Compound 190E.

LC-MS: 645.32 [M+H]⁺.

### Synthesis of Compound 190F

Compound 190E (1.63 g, 2.53 mmol) and K₂CO₃ (1.05 g, 7.58 mmol) were added to a round-bottom flask, combined with DMF (25 mL), and then stirred at 100°C for 16 hours. After the reaction was completed, the temperature was lowered to room temperature, and ethyl acetate and a saturated ammonium chloride aqueous solution were added to the reaction mixture to obtain an organic layer. The organic layer was extracted using ethyl acetate, dried using anhydrous MgSO₄, and then filtered. A filtrate obtained therefrom was concentrated and purified through silica gel column chromatography to obtain 1.03 g (yield of 65 %) of Compound 190F.

LC-MS: 625.32 [M+H]⁺.

### Synthesis of Compound 190G

Compound 190F (1.03 g, 1.65 mmol), Pd/C (10 wt% Pd on carbon, 0.18 g, 0.16 mmol), and ammonium formate (2.08 g, 33.0 mmol) were added to a round-bottom flask, combined with ethanol (20 mL), and then stirred under reflux at 80°C for 3 hours. After the reaction was completed, the temperature was lowered to room temperature, and ethyl acetate and a saturated ammonium chloride aqueous solution were added to the reaction mixture to obtain an organic layer. The organic layer was extracted using ethyl acetate, dried using anhydrous MgSO₄, and then filtered. A filtrate obtained therefrom was concentrated under reduced pressure and purified through silica gel column chromatography to obtain 0.93 g (yield of 95 %) of Compound 190G.

LC-MS: 595.35 [M+H]⁺.

### Synthesis of Compound 190I

Compound 190G (0.93 g, 1.56 mmol), Compound 5H (0.77 g, 1.64 mmol), Pd₂(dba)₃ (0.14 g, 0.16 mmol), SPhos (0.13 g, 0.31 mmol), and NaOtBu (0.23 g, 2.35 mmol) were added to a round-bottom flask, combined with toluene (20 mL), and then stirred under reflux at 110°C for 5 hours. After the reaction was completed, the temperature was lowered to room temperature, and ethyl acetate and a saturated ammonium chloride aqueous solution were added to the reaction mixture to obtain an organic layer. The organic layer was extracted using ethyl acetate, dried using anhydrous MgSO₄, and then filtered. A filtrate obtained therefrom was concentrated under reduced pressure and purified through silica gel column chromatography to obtain 1.42 g (yield of 92 %) of Compound 190I.

LC-MS: 985.53 [M+H]⁺.

### Synthesis of Compound 190J

Compound 190I (1.42 g, 1.44 mmol) was added to a round-bottom flask and mixed with triethylorthoformate (12 mL), and 35 wt% hydrochloric acid (0.15 ml, 1.73 mmol) was added thereto, followed by stirring at 80°C for 2 hours. After completion of the reaction, the temperature was lowered to room temperature, and the reaction mixture was concentrated under reduced pressure and purified through silica gel column chromatography to obtain 1.45 g (yield of 98 %) of Compound 190J.

### Synthesis of Compound 190

Compound 190J (1.45 g, 1.41 mmol), K₂PtCl₄ (0.67 g, 1.55 mmol), and NaOAc (0.41 g, 4.22 mmol) were added to a round-bottom flask, combined with dioxane (30 mL), and then stirred under reflux at 100°C for 13 hours. After the reaction was completed, the temperature was lowered to room temperature, and ethyl acetate and a saturated ammonium chloride aqueous solution were added to the reaction mixture to obtain an organic layer. The organic layer was extracted using ethyl acetate, dried using anhydrous MgSO₄, and then filtered. A filtrate obtained therefrom was concentrated under reduced pressure and purified through silica gel column chromatography to obtain 1.05 g (yield of 63 %) of Compound 190.

LC-MS: 1188.47 [M+H]⁺.

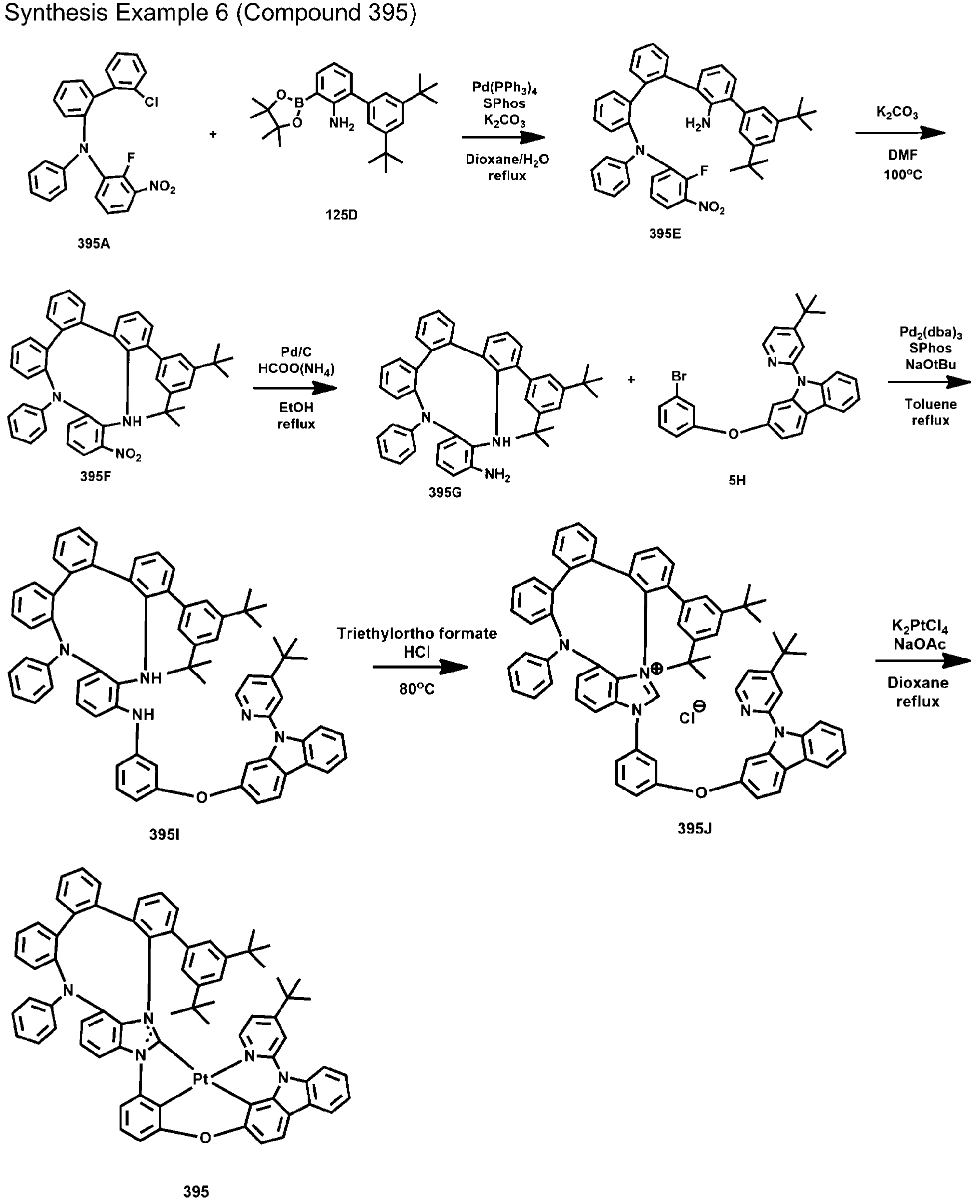

### Synthesis of Compound 395E

Compound 395A (7.00 g, 16.7 mmol), Compound 125D (10.2 g, 25.1 mmol), Pd(PPh₃)₄ (1.93 g, 1.67 mmol), SPhos (1.37 g, 3.34 mmol), and K₂CO₃ (4.62 g, 33.4 mmol) were added to a round-bottom flask, combined with 1,4-dioxane/H₂O (75 mL/20 mL), and then stirred under reflux at 110°C for 18 hours. After the reaction was completed, the temperature was lowered to room temperature, and ethyl acetate and a saturated ammonium chloride aqueous solution were added to the reaction mixture to obtain an organic layer. The organic layer was extracted using ethyl acetate, dried using anhydrous MgSO₄, and then filtered. A filtrate obtained therefrom was concentrated under reduced pressure and purified through silica gel column chromatography to obtain 6.20 g (yield of 56 %) of Compound 395E.

LC-MS: 664.32 [M+H]⁺.

### Synthesis of Compound 395F

Compound 395E (6.20 g, 9.34 mmol) and K₂CO₃ (3.87 g, 28.0 mmol) were added to a round-bottom flask, combined with DMF (95 mL), and then stirred at 100°C for 16 hours. After the reaction was completed, the temperature was lowered to room temperature, and ethyl acetate and a saturated ammonium chloride aqueous solution were added to the reaction mixture to obtain an organic layer. The organic layer was extracted using ethyl acetate, dried using anhydrous MgSO₄, and then filtered. A filtrate obtained therefrom was concentrated under reduced pressure and purified through silica gel column chromatography to obtain 2.35 g (yield of 39 %) of Compound 395F.

LC-MS: 644.32 [M+H]⁺.

### Synthesis of Compound 395G

Compound 395F (2.35 g, 3.65 mmol), Pd/C (10 wt% Pd on carbon, 0.39 g, 0.37 mmol), and ammonium formate (4.60 g, 73.0 mmol) were added to a round-bottom flask, combined with ethanol (40 mL), and then stirred under reflux at 80°C for 3 hours. After the reaction was completed, the temperature was lowered to room temperature, and ethyl acetate and a saturated ammonium chloride aqueous solution were added to the reaction mixture to obtain an organic layer. The organic layer was extracted using ethyl acetate, dried using anhydrous MgSO₄, and then filtered. A filtrate obtained therefrom was concentrated under reduced pressure and purified through silica gel column chromatography to obtain 1.83 g (yield of 82 %) of Compound 395G.

LC-MS: 614.33 [M+H]⁺.

### Synthesis of Compound 395I

Compound 395G (1.83 g, 2.98 mmol), Compound 5H (1.48 g, 3.13 mmol), Pd₂(dba)₃ (0.27 g, 0.30 mmol), SPhos (0.24 g, 0.60 mmol), and NaOtBu (0.43 g, 4.47 mmol) were added to a round-bottom flask, combined with toluene (30 mL), and then stirred under reflux at 110°C for 15 hours. After the reaction was completed, the temperature was lowered to room temperature, and ethyl acetate and a saturated ammonium chloride aqueous solution were added to the reaction mixture to obtain an organic layer. The organic layer was extracted using ethyl acetate, dried using anhydrous MgSO₄, and then filtered. A filtrate obtained therefrom was concentrated under reduced pressure and purified through silica gel column chromatography to obtain 1.92 g (yield of 64 %) of Compound 395I.

LC-MS: 1004.51 [M+H]⁺.

### Synthesis of Compound 395J

Compound 395I (1.92 g, 1.91 mmol) was added to a round-bottom flask and mixed with triethylorthoformate (20 mL), and 35 wt% hydrochloric acid (0.20 ml, 2.29 mmol) was added thereto, followed by stirring at 80°C for 3 hours. After completion of the reaction, the temperature was lowered to room temperature, and the reaction mixture was concentrated under reduced pressure and purified through silica gel column chromatography to obtain 1.73 g (yield of 86 %) of Compound 395J.

### Synthesis of Compound 395

Compound 395J (1.73 g, 1.65 mmol), K₂PtCl₄ (0.78 g, 1.81 mmol), and NaOAc (0.48 g, 4.94 mmol) were added to a round-bottom flask, combined with dioxane (35 mL), and then stirred under reflux at 100°C for 18 hours. After the reaction was completed, the temperature was lowered to room temperature, and ethyl acetate and a saturated ammonium chloride aqueous solution were added to the reaction mixture to obtain an organic layer. The organic layer was extracted using ethyl acetate, dried using anhydrous MgSO₄, and then filtered. A filtrate obtained therefrom was concentrated under reduced pressure and purified through silica gel column chromatography to obtain 1.15 g (yield of 58 %) of Compound 395.

LC-MS: 1207.45 [M+H]⁺.

### Evaluation Example 1

0.5 wt% of Compound 5 was mixed with a PMMA in a CH₂Cl₂ solution, and the resulting product was coated on a quartz substrate by using a spin coater, heat-treated in an oven at 80°C, and then cooled to room temperature to obtain a film.

A photoluminescence quantum yield (PLQY) of Compound 5 in film was evaluated by using a Hamamatsu Photonics absolute PL quantum yield measurement system equipped with a xenon light source, a monochromator, a photonic multichannel analyzer, and an integrating sphere, and using PLQY measurement software (Hamamatsu Photonics, Ltd., Shizuoka, Japan), and the same process was repeatedly performed on each of the remaining compounds shown in Table 2. The results thereof are shown in Table 2. In Table 2, the PLQY of each of Compounds 5, 125, 140, 155, 190, 395, C2, C3, and C4 is expressed as a relative value (%) with respect to the PLQY of Compound C1.

**Table 2**

| Compound No. | PLQY (relative value, %) |
|---|---|
| 5 | 111 |
| 125 | 120 |
| 140 | 129 |
| 155 | 121 |
| 190 | 111 |
| 395 | 118 |
| C1 | 100 |
| C2 | 104 |
| C3 | 107 |
| C4 | 107 |

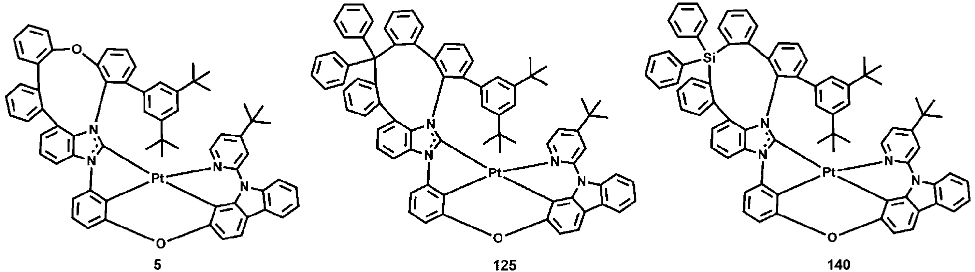

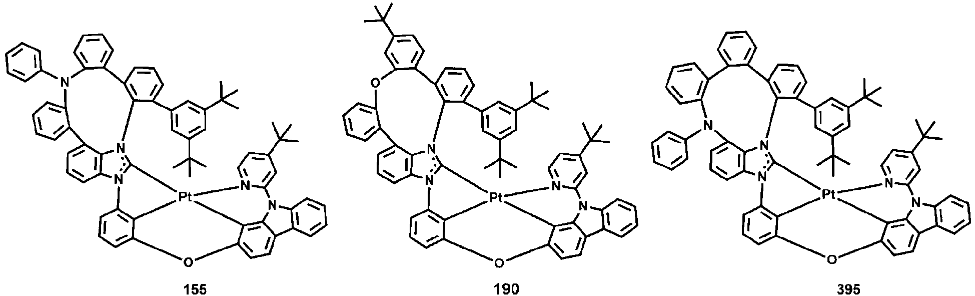

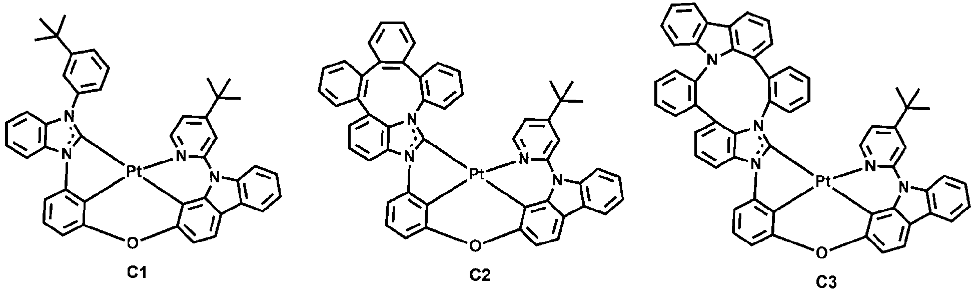

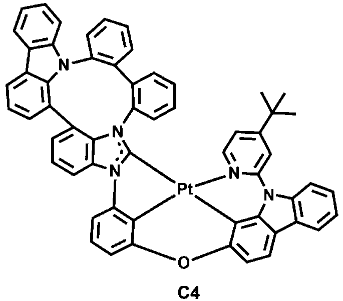

From Table 2, it was confirmed that Compounds 5, 125, 140, 155, 190, and 395 had excellent PLQY characteristics compared to Compounds C1, C2, C3, and C4.

### Example 1

A glass substrate with a 1,500 Å-thick ITO electrode formed thereon was cut to a size of 50 millimeters (mm) x 50 mm x 0.5 mm, sonicated in acetone, isopropyl alcohol, and deionized (DI) water, each for 15 minutes, and then cleaned by exposure to UV and ozone for 30 minutes.

Next, m-MTDATA was deposited on the ITO electrode (anode) on the glass substrate to form a hole injection layer having a thickness of 600 Å, and α-NPD was deposited on the hole injection layer to form a hole transport layer having a thickness of 250 Å.

Compound 5 (emitter) and CBP (host) were co-deposited at a weight ratio of 10:90 on the hole transport layer to form an emission layer having a thickness of 400 Å.

BAlq was deposited on the emission layer to form a hole-blocking layer having a thickness of 50 Å, Alq₃ was deposited on the hole-blocking layer to form an electron transport layer having a thickness of 300 Å, LiF was deposited on the electron transport layer to form an electron injection layer having a thickness of 10 Å, and then, Al was vacuum-deposited on the electron injection layer to form a second electrode (cathode) having a thickness of 1,200 Å, thereby completing the manufacture of a light-emitting device having a structure of ITO / m-MTDATA (600 Å) / α-NPD (250 Å) / CBP + Compound 5 (10 wt%) (400 Å) / BAlq (50 Å) / Alq₃ (300 Å) / LiF (10 Å) / Al (1,200 Å).

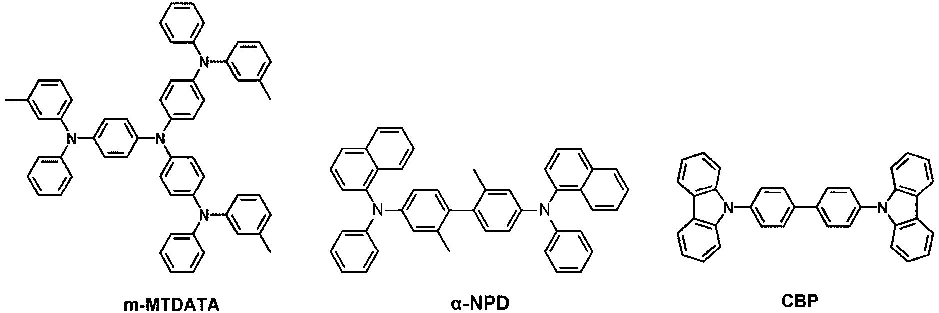

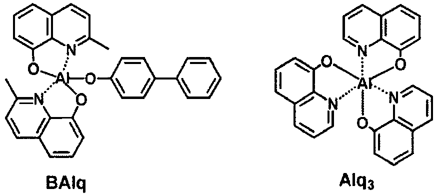

### Examples 2 to 5 and Comparative Examples C1 and C2

Light-emitting devices were manufactured in the same manner as in Example 1, except that, in forming an emission layer, the compounds shown in Table 3 were each used instead of Compound 5 as an emitter.

### Evaluation Example 2

For each of the light-emitting devices manufactured in Examples 1 to 5 and Comparative Examples C1 and C2, a driving voltage (relative %), external quantum efficiency (EQE, relative %), CIE color coordinates (x, y), and a FWHM (nm) of an emission peak of an EL spectrum were evaluated, and the results thereof are shown in Table 3.

The driving voltage and the EQE were evaluated using a current-voltmeter (Keithley 2400) and a luminance meter (Minolta Cs-1000A). The CIE color coordinates (x,y) and the FWHM (nm) of the emission peak of the EL spectrum were evaluated from an EL spectrum (at 1,000 cd/m²) measured using a luminance meter (Minolta Cs-1000A) for each of the light-emitting devices. In Table 3, the driving voltage (relative %) and the EQE (relative %) of each of the light-emitting devices of Examples 1 to 5 and Comparative Example C2 are expressed as relative values (%) with respect to the driving voltage and the EQE of the light-emitting device of Comparative Example C1, respectively.

**Table 3**

| | Emitter Compound No. | Driving voltage (relative %) | External quantum efficiency at 1,000 cd/m² (relative %) | CIE color coordinates (x,y) | FWHM (nm) |
|---|---|---|---|---|---|
| Example 1 | 5 | 98.6 | 120 | (0.143, 0.158) | 20.2 |
| Example 2 | 125 | 99.3 | 127 | (0.143, 0.145) | 19.6 |
| Example 3 | 140 | 99.5 | 132 | (0.139, 0.143) | 20.1 |
| Example 4 | 190 | 97.7 | 115 | (0.134, 0.156) | 22.4 |
| Example 5 | 395 | 99.7 | 122 | (0.139, 0.144) | 20.7 |
| Comparative Example C1 | C1 | 100 | 100 | (0.148, 0.183) | 35.4 |
| Comparative Example C2 | C2 | 103 | 112 | (0.145, 0.156) | 23.6 |

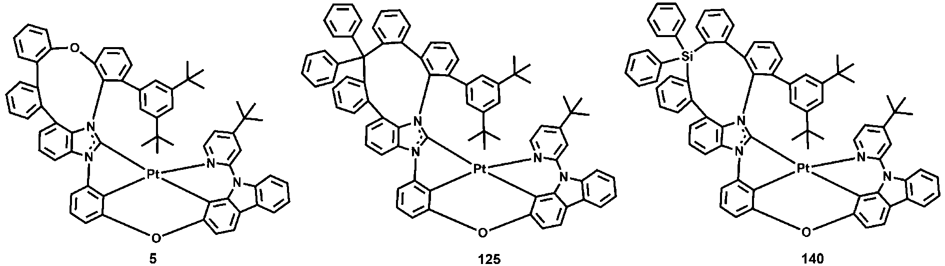

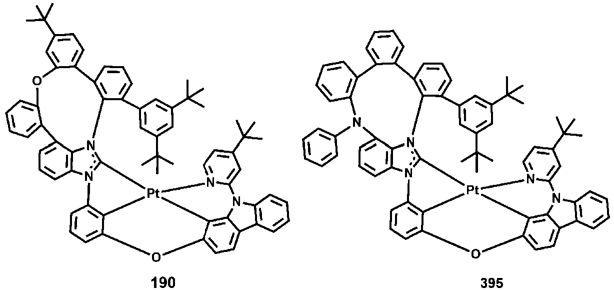

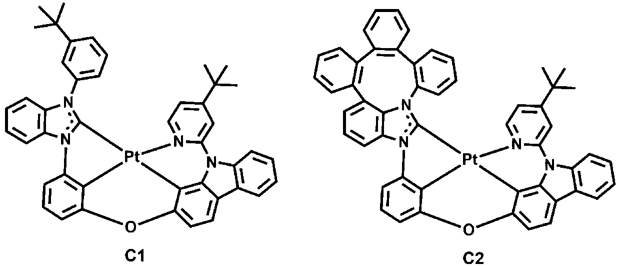

From Table 3, it was confirmed that the light-emitting devices of Examples 1 to 5 emitted a blue light with excellent color purity and a relatively narrow FWHM, and had an excellent driving voltage and an excellent EQE as compared to the light-emitting devices of Comparative Examples C1 and C2.

### Example 6 and Comparative Examples C3 and C4

Light-emitting devices were manufactured in the same manner as in Example 1, except that, in forming an emission layer, the compounds shown in Table 4 were each used instead of Compound 5 as an emitter.

### Evaluation Example 3

For each of the light-emitting devices manufactured in Example 6 and Comparative Examples C3 and C4, a driving voltage, EQE, and CIE color coordinates were evaluated in the same manner as in Evaluation Example 2, and results thereof are shown in Table 4. Data for Comparative Examples C1 and C2 has also been added to Table 4, and the driving voltage and the EQE of each of the light-emitting devices of Example 6 and Comparative Examples C2 to C4 in Table 4 are expressed as relative values (%) with respect to the driving voltage and the EQE of the light-emitting device of Comparative Example C1, respectively.

**Table 4**

| | Emitter Compound No. | Driving voltage (relative %) | External quantum efficiency at 1,000 cd/m² (relative %) | CIE color coordinates (x,y) |
|---|---|---|---|---|
| Example 6 | 155 | 99.7 | 119 | (0.134, 0.153) |
| Comparative Example C1 | C1 | 100 | 100 | (0.148, 0.183) |
| Comparative Example C2 | C2 | 103 | 112 | (0.145, 0.156) |
| Comparative Example C3 | C3 | 101 | 113 | (0.141, 0.153) |
| Comparative Example C4 | C4 | 101 | 115 | (0.139, 0.148) |

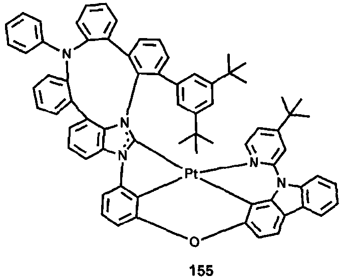

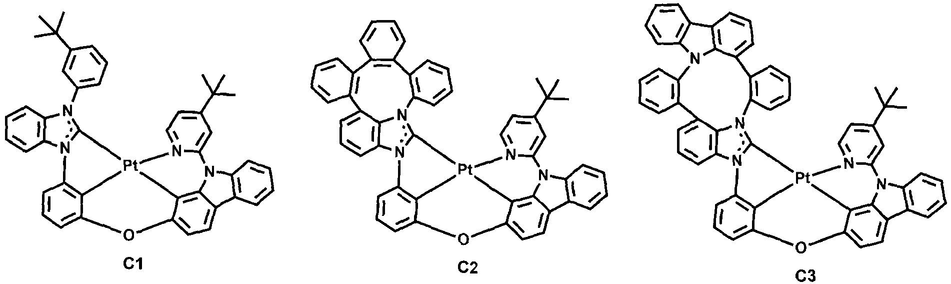

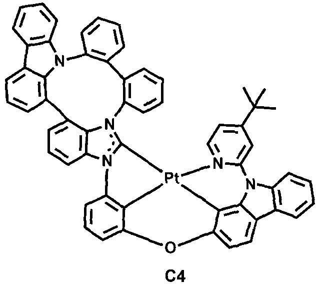

From Table 4, it was confirmed that the light-emitting device of Example 6 emitted a blue light with excellent color purity, and had an excellent driving voltage and an excellent EQE as compared to the light-emitting devices of Comparative Examples C1 to C4.

### Example 7

A light-emitting device was manufactured in the same manner as in Example 1, except that, in forming an emission layer, Compound 155 (sensitizer), Compound FD14 (emitter), and CBP(host) were co-deposited at a weight ratio of 10:1.5:88.5 to a thickness of 400 Å.

### Comparative Example X

A light-emitting device was manufactured in the same manner as in Example 1, except that, in forming an emission layer, Compound FD14 (emitter) and CBP (host) were co-deposited at a weight ratio of 10:90 to a thickness of 400 Å.

### Evaluation Example 4

For each of the light-emitting devices manufactured in Example 7 and Comparative Example X, a maximum emission wavelength (λₘₐₓ) of an EL spectrum, a y value (CIEy) of color coordinates, EQE (relative %), and a driving voltage (relative %) were evaluated in the same manner as in Evaluation Example 2, and results thereof are shown in Table 5. In Table 5, each of the EQE and the driving voltage of the light-emitting devices of Example 7 are expressed as relative values (%) compared with Comparative Example X.

**Table 5**

| | Sensitizer compound No. | Emitter compound No. | λₘₐₓ (nm) | CIEy | External quantum efficiency at 1,000 cd/m² (relative %) | Driving voltage (relative %) |
|---|---|---|---|---|---|---|
| Example 7 | 155 | FD14 | 463 | 0.132 | 137 | 97 |
| Comparative Example X | - | FD14 | 462 | 0.138 | 100 | 100 |

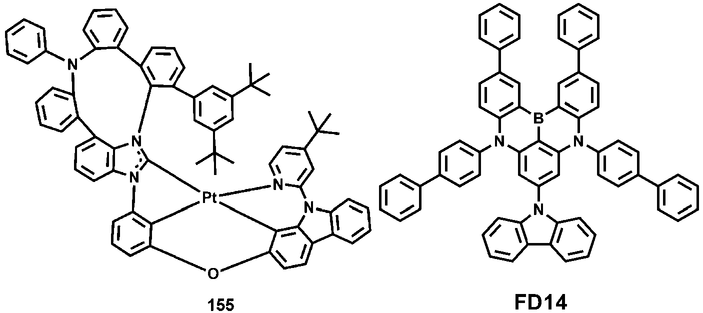

From Table 5, it was confirmed that the light-emitting device of Example 7 including Compound 155 as a sensitizer had an excellent EQE and excellent driving voltage characteristics, and emitted a blue light with excellent color purity, as compared to the light-emitting device of Comparative Example X.

According to one or more embodiments, an organometallic compound represented by Formula 1 may have excellent thermal stability and excellent electrical characteristics, and may emit a blue light with a high color purity and/or a relatively narrow FWHM. Thus, an electronic device, for example, a light-emitting device, including at least one of the organometallic compounds represented by Formula 1 may emit a blue light with a high color purity, and may have an improved driving voltage and an improved EQE. By using the light-emitting device, a high-quality electronic apparatus may be manufactured.

It should be understood that exemplary embodiments described herein should be considered in a descriptive sense only and not for purposes of limitation. Descriptions of features or aspects within each exemplary embodiment should typically be considered as available for other similar features or aspects in other exemplary embodiments. While one or more exemplary embodiments have been described with reference to the figure, it will be understood by those of ordinary skill in the art that various changes in form and details may be made therein without departing from the scope as defined by the following claims.

## Claims

1. An organometallic compound represented by Formula 1: 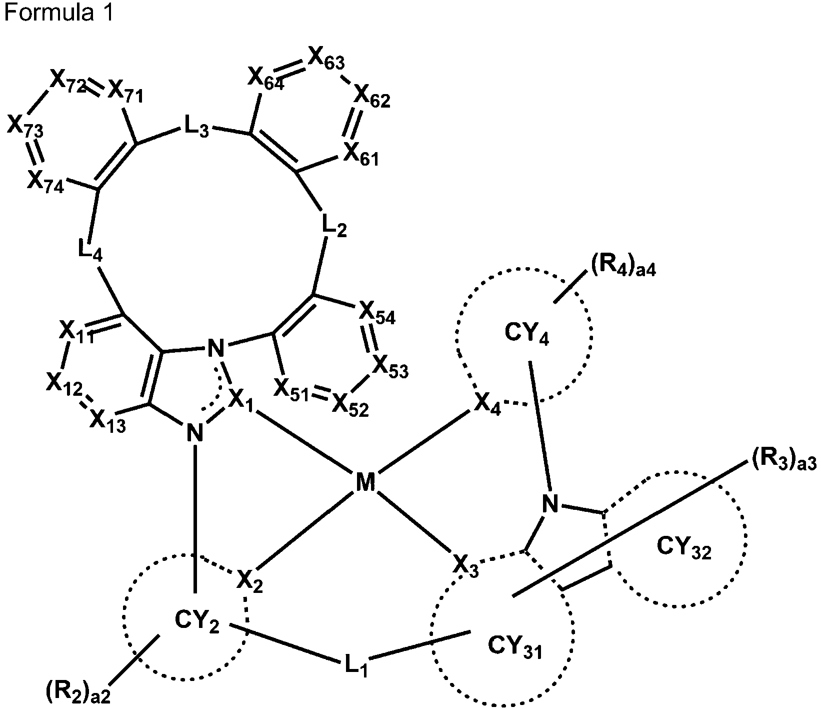 wherein, in Formula 1,
M is Pt or Pd,
X₁ is C,
X₂ to X₄ are each independently C or N,
ring CY₂, ring CY₃₁, ring CY₃₂, and ring CY₄ are each independently a C₅-C₃₀ carbocyclic group or a C₁-C₃₀ heterocyclic group,
X₁₁ is N or C(R₁₁), X₁₂ is N or C(R₁₂), and X₁₃ is N or C(R₁₃),
X₅₁ is N or C(R₅₁), X₅₂ is N or C(R₅₂), X₅₃ is N or C(R₅₃), and X₅₄ is N or C(R₅₄),
X₆₁ is N or C(R₆₁), X₆₂ is N or C(R₆₂), X₆₃ is N or C(R₆₃), and X₆₄ is N or C(R₆₄),
X₇₁ is N or C(R₇₁), X₇₂ is N or C(R₇₂), X₇₃ is N or C(R₇₃), and X₇₄ is N or C(R₇₄),
L₁ is O, S, Se, N(R₁₀₁), C(R₁₀₁)(R₁₀₂), or Si(R₁₀₁)(R₁₀₂),
L₂, L₃, and L₄ are each independently a single bond, O, S, Se, N(R'), C(R')(R"), or Si(R')(R"),
at least one of L₂, L₃, and L₄ is O, S, Se, N(R'), C(R')(R"), or Si(R')(R"),
i) when L₂ is N(R'), R' is not linked to either of X₅₄ and X₆₁, ii) when L₃ is N(R'), R' is not linked to either of X₆₄ and X₇₁, and iii) when L₄ is N(R'), R' is not linked to either of X₇₄ and X₁₁,
R₂, R₃, R₄, R₁₁ to R₁₃, R₅₁ to R₅₄, R₆₁ to R₆₄, R₇₁ to R₇₄, R₁₀₁, R₁₀₂, R', and R" are each independently hydrogen, deuterium, -F, -Cl, -Br, -I, -SF₅, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, a substituted or unsubstituted C₁-C₆₀ alkyl group, a substituted or unsubstituted C₂-C₆₀ alkenyl group, a substituted or unsubstituted C₂-C₆₀ alkynyl group, a substituted or unsubstituted C₁-C₆₀ alkoxy group, a substituted or unsubstituted C₁-C₆₀ alkylthio group, a substituted or unsubstituted C₃-C₁₀ cycloalkyl group, a substituted or unsubstituted C₁-C₁₀ heterocycloalkyl group, a substituted or unsubstituted C₃-C₁₀ cycloalkenyl group, a substituted or unsubstituted C₁-C₁₀ heterocycloalkenyl group, a substituted or unsubstituted C₆-C₆₀ aryl group, a substituted or unsubstituted C₇-C₆₀ alkyl aryl group, a substituted or unsubstituted C₇-C₆₀ aryl alkyl group, a substituted or unsubstituted C₆-C₆₀ aryloxy group, a substituted or unsubstituted C₆-C₆₀ arylthio group, a substituted or unsubstituted C₁-C₆₀ heteroaryl group, a substituted or unsubstituted C₂-C₆₀ alkyl heteroaryl group, a substituted or unsubstituted C₂-C₆₀ heteroaryl alkyl group, a substituted or unsubstituted C₁-C₆₀ heteroaryloxy group, a substituted or unsubstituted C₁-C₆₀ heteroarylthio group, a substituted or unsubstituted monovalent non-aromatic condensed polycyclic group, a substituted or unsubstituted monovalent non-aromatic condensed heteropolycyclic group, -Si(Q₁)(Q₂)(Q₃), -Ge(Q₁)(Q₂)(Q₃), - N(Q₄)(Q₅), -B(Q₆)(Q₇), -P(Q₈)(Q₉), or -P(=O)(Q₈)(Q₉),
a2 to a4 are each independently an integer from 0 to 20,
two or more of R₁₁ to R₁₃ are optionally linked to each other to form a C₅-C₃₀ carbocyclic group unsubstituted or substituted with at least one R₁₀ₐ or a C₁-C₃₀ heterocyclic group unsubstituted or substituted with at least one R₁₀ₐ,
two or more of a plurality of R₂ are optionally linked to each other to form a C₅-C₃₀ carbocyclic group unsubstituted or substituted with at least one R₁₀ₐ or a C₁-C₃₀ heterocyclic group unsubstituted or substituted with at least one R₁₀ₐ,
two or more of a plurality of R₃ are optionally linked to each other to form a C₅-C₃₀ carbocyclic group unsubstituted or substituted with at least one R₁₀ₐ or a C₁-C₃₀ heterocyclic group unsubstituted or substituted with at least one R₁₀ₐ,
two or more of a plurality of R₄ are optionally linked to each other to form a C₅-C₃₀ carbocyclic group unsubstituted or substituted with at least one R₁₀ₐ or a C₁-C₃₀ heterocyclic group unsubstituted or substituted with at least one R₁₀ₐ,
two or more of R₅₁ to R₅₄ are optionally linked to each other to form a C₅-C₃₀ carbocyclic group unsubstituted or substituted with at least one R₁₆ₐ or a C₁-C₃₀ heterocyclic group unsubstituted or substituted with at least one R₁₀ₐ,
two or more of R₆₁ to R₆₄ are optionally linked to each other to form a C₅-C₃₀ carbocyclic group unsubstituted or substituted with at least one R₁₀ₐ or a C₁-C₃₀ heterocyclic group unsubstituted or substituted with at least one R₁₀ₐ,
two or more of R₇₁ to R₇₄ are optionally linked to each other to form a C₅-C₃₀ carbocyclic group unsubstituted or substituted with at least one R₁₀ₐ or a C₁-C₃₀ heterocyclic group unsubstituted or substituted with at least one R₁₀ₐ,
R₁₀₁ and R₁₀₂ are optionally linked to each other to form a C₅-C₃₀ carbocyclic group unsubstituted or substituted with at least one R₁₀ₐ or a C₁-C₃₀ heterocyclic group unsubstituted or substituted with at least one R₁₀ₐ,
R' and R" are optionally linked to each other to form a C₅-C₃₀ carbocyclic group unsubstituted or substituted with at least one R₁₀ₐ or a C₁-C₃₀ heterocyclic group unsubstituted or substituted with at least one R₁₀ₐ,
R₁₀ₐ is as described in connection with R₁₁,
at least one substituent of the substituted C₁-C₆₀ alkyl group, the substituted C₂-C₆₀ alkenyl group, the substituted C₂-C₆₀ alkynyl group, the substituted C₁-C₆₀ alkoxy group, the substituted C₁-C₆₀ alkylthio group, the substituted C₃-C₁₀ cycloalkyl group, the substituted C₁-C₁₀ heterocycloalkyl group, the substituted C₃-C₁₀ cycloalkenyl group, the substituted C₁-C₁₀ heterocycloalkenyl group, the substituted C₆-C₆₀ aryl group, the substituted C₇-C₆₀ alkyl aryl group, the substituted C₇-C₆₀ aryl alkyl group, the substituted C₆-C₆₀ aryloxy group, the substituted C₆-C₆₀ arylthio group, the substituted C₁-C₆₀ heteroaryl group, the substituted C₂-C₆₀ alkyl heteroaryl group, the substituted C₂-C₆₀ heteroaryl alkyl group, the substituted C₁-C₆₀ heteroaryloxy group, the substituted C₁-C₆₀ heteroarylthio group, the substituted monovalent non-aromatic condensed polycyclic group, and the substituted monovalent non-aromatic condensed heteropolycyclic group is:
deuterium, -F, -Cl, -Br, -I, -SF₅, -CD₃, -CD₂H, -CDH₂, -CF₃, -CF₂H, -CFH₂, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, a C₁-C₆₆ alkyl group, a C₂-C₆₀ alkenyl group, a C₂-C₆₀ alkynyl group, a C₁-C₆₀ alkoxy group, or a C₁-C₆₀ alkylthio group;
a C₁-C₆₀ alkyl group, a C₂-C₆₀ alkenyl group, a C₂-C₆₀ alkynyl group, a C₁-C₆₀ alkoxy group, or a C₁-C₆₀ alkylthio group, each substituted with deuterium, -F, -Cl, -Br, -I, -SF₅, -CD₃, -CD₂H, -CDH₂, -CF₃, -CF₂H, -CFH₂, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, a C₃-C₁₀ cycloalkyl group, a C₁-C₁₀ heterocycloalkyl group, a C₃-C₁₀ cycloalkenyl group, a C₁-C₁₀ heterocycloalkenyl group, a C₆-C₆₀ aryl group, a C₇-C₆₀ alkyl aryl group, a C₆-C₆₀ aryloxy group, a C₆-C₆₀ arylthio group, a C₁-C₆₀ heteroaryl group, a C₂-C₆₆ alkyl heteroaryl group, a C₁-C₆₀ heteroaryloxy group, a C₁-C₆₀ heteroarylthio group, a monovalent non-aromatic condensed polycyclic group, a monovalent non-aromatic condensed heteropolycyclic group, -Si(Q₁₁)(Q₁₂)(Q₁₃), -Ge(Q₁₁)(Q₁₂)(Q₁₃), -N(Q₁₄)(Q₁₅), -B(Q₁₆)(Q₁₇), -P(Q₁₈)(Q₁₉), -P(=O)(Q₁₈)(Q₁₉), or a combination thereof;
a C₃-C₁₀ cycloalkyl group, a C₁-C₁₀ heterocycloalkyl group, a C₃-C₁₀ cycloalkenyl group, a C₁-C₁₀ heterocycloalkenyl group, a C₆-C₆₀ aryl group, a C₇-C₆₀ alkyl aryl group, a C₆-C₆₀ aryloxy group, a C₆-C₆₀ arylthio group, a C₁-C₆₀ heteroaryl group, a C₂-C₆₀ alkyl heteroaryl group, a C₁-C₆₀ heteroaryloxy group, a C₁-C₆₀ heteroarylthio group, a monovalent non-aromatic condensed polycyclic group, or a monovalent non-aromatic condensed heteropolycyclic group, each unsubstituted or substituted with deuterium, -F, -Cl, -Br, -I, -SF₅, -CD₃, -CD₂H, -CDH₂, -CF₃, -CF₂H, - CFH₂, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, a C₁-C₆₆ alkyl group, a C₂-C₆₀ alkenyl group, a C₂-C₆₀ alkynyl group, a C₁-C₆₀ alkoxy group, a C₁-C₆₀ alkylthio group, a C₃-C₁₀ cycloalkyl group, a C₁-C₁₀ heterocycloalkyl group, a C₃-C₁₀ cycloalkenyl group, a C₁-C₁₀ heterocycloalkenyl group, a C₆-C₆₀ aryl group, a C₇-C₆₀ alkyl aryl group, a C₇-C₆₀ aryl alkyl group, a C₆-C₆₀ aryloxy group, a C₆-C₆₀ arylthio group, a C₁-C₆₀ heteroaryl group, a C₂-C₆₆ alkyl heteroaryl group, a C₂-C₆₀ heteroaryl alkyl group, a C₁-C₆₀ heteroaryloxy group, a C₁-C₆₀ heteroarylthio group, a monovalent non-aromatic condensed polycyclic group, a monovalent non-aromatic condensed heteropolycyclic group, -Si(Q₂₁)(Q₂₂)(Q₂₃), -Ge(Q₂₁)(Q₂₂)(Q₂₃), - N(Q₂₄)(Q₂₅), -B(Q₂₆)(Q₂₇), -P(Q₂₈)(Q₂₉), -P(=O)(Q₂₈)(Q₂₉), or a combination thereof;
-Si(Q₃₁)(Q₃₂)(Q₃₃), -Ge(Q₃₁)(Q₃₂)(Q₃₃), -N(Q₃₄)(Q₃₅), -B(Q₃₆)(Q₃₇), -P(Q₃₈)(Q₃₉), or -P(=O)(Q₃₈)(Q₃₉); or
a combination thereof, and
Q₁ to Q₉, Q₁₁ to Q₁₉, Q₂₁ to Q₂₉, and Q₃₁ to Q₃₉ are each independently:
hydrogen, deuterium, or -F; or
a C₁-C₆₀ alkyl group, a C₂-C₆₀ alkenyl group, a C₂-C₆₀ alkynyl group, a C₁-C₆₀ alkoxy group, a C₁-C₆₀ alkylthio group, a C₃-C₁₀ cycloalkyl group, a C₁-C₁₀ heterocycloalkyl group, a C₃-C₁₀ cycloalkenyl group, a C₁-C₁₀ heterocycloalkenyl group, a C₆-C₆₀ aryl group, a C₇-C₆₀ alkyl aryl group, a C₇-C₆₀ aryl alkyl group, a C₆-C₆₀ aryloxy group, a C₆-C₆₀ arylthio group, a C₁-C₆₀ heteroaryl group, a C₂-C₆₆ alkyl heteroaryl group, a C₂-C₆₀ heteroaryl alkyl group, a C₁-C₆₀ heteroaryloxy group, a C₁-C₆₀ heteroarylthio group, a monovalent non-aromatic condensed polycyclic group, or a monovalent non-aromatic condensed heteropolycyclic group, each unsubstituted or substituted with deuterium, -F, a cyano group, a C₁-C₆₀ alkyl group, a C₆-C₆₀ aryl group, or a combination thereof.

2. The organometallic compound of claim 1, wherein
X₂ and X₃ are each C, and
X₄ is N.

3. The organometallic compound of claims 1 or 2, wherein
ring CY₂, ring CY₃₁, and ring CY₃₂ are each independently a benzene group, a naphthalene group, a phenanthrene group, a pyridine group, a pyrimidine group, a pyridazine group, a pyrazine group, a triazine group, a quinoline group, an isoquinoline group, a benzoquinoline group, or a benzoisoquinoline group, and
ring CY₄ is a pyridine group, a pyrimidine group, a pyridazine group, a pyrazine group, a triazine group, a quinoline group, an isoquinoline group, a benzoquinoline group, or a benzoisoquinoline group.

4. The organometallic compound of any of claims 1-3, wherein L₂, L₃, L₄, or any combination thereof is N(R'); and/or
wherein L₂, L₃, L₄, or any combination thereof is O, S, or Se; and/or
wherein at least one of L₂, L₃, L₄, or any combination thereof is C(R')(R") or Si(R')(R").

5. The organometallic compound of any of claims 1-4, wherein
i) L₂ and L₃ are each a single bond; and L₄ is O, S, Se, N(R'), C(R')(R"), or Si(R')(R"),
ii) L₂ and L₄ are each a single bond; and L₃ is O, S, Se, N(R'), C(R')(R"), or Si(R')(R"), or
iii) L₃ and L₄ are each a single bond; and L₂ is O, S, Se, N(R'), C(R')(R"), or Si(R')(R").

6. The organometallic compound of any of claims 1-5, wherein R₂, R₃, R₄, R₁₁ to R₁₃, R₅₁ to R₅₄, R₆₁ to R₆₄, R₇₁ to R₇₄, R₁₀₁, R₁₀₂, R', and R" are each independently:
hydrogen, deuterium, -F, or a cyano group;
a C₁-C₂₀ alkyl group, or a C₁-C₂₀ alkoxy group, each unsubstituted or substituted with deuterium, -F, a cyano group, or a combination thereof;
a C₃-C₁₀ cycloalkyl group, a phenyl group, a naphthyl group, a pyridinyl group, a furanyl group, a thiophenyl group, a benzofuranyl group, a benzothiophenyl group, a carbazolyl group, a dibenzofuranyl group, or a dibenzothiophenyl group, each unsubstituted or substituted with deuterium, -F, a cyano group, a C₁-C₂₀ alkyl group, a C₁-C₂₀ alkoxy group, a deuterated C₁-C₂₀ alkyl group, a fluorinated C₁-C₂₀ alkyl group, a C₃-C₁₀ cycloalkyl group, a deuterated C₃-C₁₀ cycloalkyl group, a fluorinated C₃-C₁₀ cycloalkyl group, a (C₁-C₂₀ alkyl)C₃-C₁₀ cycloalkyl group, a phenyl group, a deuterated phenyl group, a fluorinated phenyl group, a (C₁-C₂₀ alkyl)phenyl group, a naphthyl group, a pyridinyl group, a furanyl group, a thiophenyl group, a benzofuranyl group, a benzothiophenyl group, a carbazolyl group, a dibenzofuranyl group, a dibenzothiophenyl group, -Si(Q₃₁)(Q₃₂)(Q₃₃), -Ge(Q₃₁)(Q₃₂)(Q₃₃), or a combination thereof; or
-Si(Q₁)(Q₂)(Q₃) or -Ge(Q₁)(Q₂)(Q₃).

7. The organometallic compound of any of claims 1-6, wherein the organometallic compound comprises deuterium, a tert-butyl group unsubstituted or substituted with at least one deuterium, or a combination thereof.

8. The organometallic compound of any of claims 1-7, wherein the organometallic compound is represented by Formula 1-1: 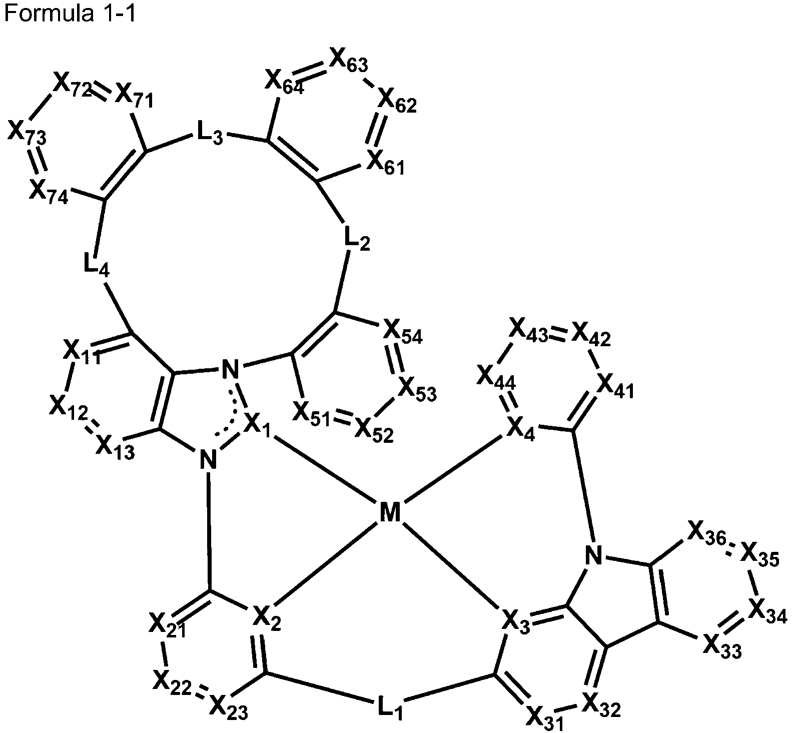 wherein, in Formula 1-1,
M, X₁ to X₄, X₁₁ to X₁₃, X₅₁ to X₅₄, X₆₁ to X₆₄, X₇₁ to X₇₄, and L₁ to L₄ are each as described in claim 1,
X₂₁ is N or C(R₂₁), X₂₂ is N or C(R₂₂), and X₂₃ is N or C(R₂₃),
R₂₁ to R₂₃ are each as described in connection with R₂ in claim 1,
X₃₁ is N or C(R₃₁), X₃₂ is N or C(R₃₂), X₃₃ is N or C(R₃₃), X₃₄ is N or C(R₃₄), X₃₅ is N or C(R₃₅), and X₃₆ is N or C(R₃₆),
R₃₁ to R₃₆ are each as described in connection with R₃ in claim 1,
X₄₁ is N or C(R₄₁), X₄₂ is N or C(R₄₂), X₄₃ is N or C(R₄₃), and X₄₄ is N or C(R₄₄),
R₄₁ to R₄₄ are each as described in connection with R₄ in claim 1,
two or more of R₁₁ to R₁₃ are optionally linked to each other to form a C₅-C₃₀ carbocyclic group unsubstituted or substituted with at least one R₁₆ₐ or a C₁-C₃₀ heterocyclic group unsubstituted or substituted with at least one R₁₀ₐ,
two or more of R₂₁ to R₂₃ are optionally linked to each other to form a C₅-C₃₀ carbocyclic group unsubstituted or substituted with at least one R₁₀ₐ or a C₁-C₃₀ heterocyclic group unsubstituted or substituted with at least one R₁₀ₐ,
two or more of R₃₁ to R₃₆ are optionally linked to each other to form a C₅-C₃₀ carbocyclic group unsubstituted or substituted with at least one R₁₀ₐ or a C₁-C₃₀ heterocyclic group unsubstituted or substituted with at least one R₁₀ₐ,
two or more of R₄₁ to R₄₄ are optionally linked to each other to form a C₅-C₃₀ carbocyclic group unsubstituted or substituted with at least one R₁₀ₐ or a C₁-C₃₀ heterocyclic group unsubstituted or substituted with at least one R₁₀ₐ, and
R₁₀ₐ is as described in connection with R₁₁ in claim 1.

9. A light-emitting device, comprising:
a first electrode;
a second electrode; and
an interlayer arranged between the first electrode and the second electrode,
wherein the interlayer comprises an emission layer,
wherein the interlayer further comprises at least one organometallic compound of any of claims 1-8.

10. The light-emitting device of claim 9, wherein the emission layer comprises the at least one organometallic compound.

11. The light-emitting device of claim 10, wherein light emitted from the emission layer is a blue light; and/or
wherein a CIEy value of light emitted from the emission layer is 0.040 to 0.170.

12. The light-emitting device of claims 10 or 11, wherein a maximum emission wavelength of light emitted from the emission layer is 440 nanometers to 470 nanometers; and/or
wherein the at least one organometallic compound is an emitter.

13. The light-emitting device of any of claims 10-12, wherein
the at least one organometallic compound is a sensitizer,
the emission layer further comprises an emitter, and
the emitter is different from the at least one organometallic compound.

14. The light-emitting device of claim 13, wherein the emitter is a prompt fluorescence compound or a delayed fluorescence compound; or
wherein the emitter is a multi-resonance thermally activated delayed fluorescence compound.

15. An electronic apparatus, comprising the light-emitting device of any of claims 9-14.
